# EUROPEAN PATENT APPLICATION

(11) **EP 4 672 339 A1**
(43) Date of publication of application: **31.12.2025**
(21) Application number: 24759949.1
(22) Date of filing: 11.01.2024
(51) Int. Cl.: H01L 27/146, H04N 25/532, H04N 25/70, H04N 25/772, H04N 25/79

(54) **SOLID-STATE IMAGING DEVICE AND ELECTRONIC APPARATUS**

(30) Priority: 24.02.2023 JP 2023027743
(71) Applicant: Sony Semiconductor Solutions Corporation, Atsugi-shi, Kanagawa 243-0014 (JP)
(72) Inventor: MACHIDA, Takashi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/000469
(87) International publication number: WO 2024/176641

(57) **Abstract**

[Problem] To control the ground potential of an imaging device composed of stacked semiconductors.

[Solution] A solid-state imaging device includes a first substrate and a second substrate. The first substrate includes at least a light receiving element that outputs a signal based on the intensity of received light, and the ground potential is a first ground potential. The second substrate includes at least a transistor that outputs a signal based on a signal output from the light receiving element, and the ground potential is a second ground potential different from the first ground potential.

## Description

### [Technical Field]

The present disclosure relates to a solid-state imaging device and an electronic device.

### [Background Art]

Solid-state imaging devices using photodiodes have been widely used. In order to increase the saturation capacitance of the photodiode, when the ground potential of a pixel is reduced to increase a potential difference in the pixel, the potential difference is applied to the transistor of a pixel circuit on the same substrate. Although it is necessary to increase the size of the transistor in order to withstand the applied potential difference, unfortunately, the transistor may occupy a large area in the layout. Furthermore, as the potential difference applied to the pixel transistor increases, the reliability may decrease or hot carrier emission may occur.

### [Citation List]

### [Patent Literatures]

[PTL 1]
JP 2015-159501A

### [Summary]

### [Technical Problem]

Therefore, one of non-limiting problems to be solved by the embodiment of the present disclosure is to provide different ground potentials in an imaging device composed of stacked semiconductors. Problems to be solved by the embodiment of the present disclosure can also be problems corresponding to the effects described in the embodiment as some additional non-limiting examples. In other words, a problem corresponding to at least one of the effects in the description of the embodiment of the present disclosure can be a problem to be solved in the present disclosure.

### [Solution to Problem]

According to one embodiment, a solid-state imaging device includes a first substrate and a second substrate.

The first substrate includes:
at least a light receiving element that outputs a signal based on the intensity of received light, and
the ground potential is a first ground potential.

The second substrate includes
at least a transistor that outputs a signal based on the signal output from the light receiving element, and
the ground potential is a second ground potential different from the first ground potential.

The second ground potential may be a potential on the positive side of the first ground potential.

The first ground potential may be a negative bias potential.

The second ground potential may be 0 [V].

The second substrate may include an amplification transistor that amplifies a signal output from the light receiving element.

The thickness of the gate oxide film of the transistor provided on the second substrate may be smaller than the thickness of the gate oxide film provided on the first substrate.

The first substrate and the second substrate may be electrically connected to each other via a metal.

The metal may be copper.

A distance between the wirings of the second substrate may be shorter than a distance between the wirings of the first substrate.

The first substrate and the second substrate may be formed in a stacked state.

The imaging device may further include a third substrate, and the third substrate may form a pixel unit with the first substrate and the second substrate.

The signal acquired by the light receiving element may be converted into an image signal by a charge-domain global shutter system.

The signal acquired by the light receiving element may be converted into an image signal by a voltage-domain global shutter system.

The signal acquired by the light receiving element may be converted into a digital signal by an analogue-to-digital conversion circuit provided for the light receiving element.

The amplification transistor may have a well potential and a source potential that are equal to each other and different from the second ground potential.

According to the embodiment, the solid-state imaging device includes any one of the foregoing solid-state imaging devices.

### [Brief Description of Drawings]

[Fig. 1]

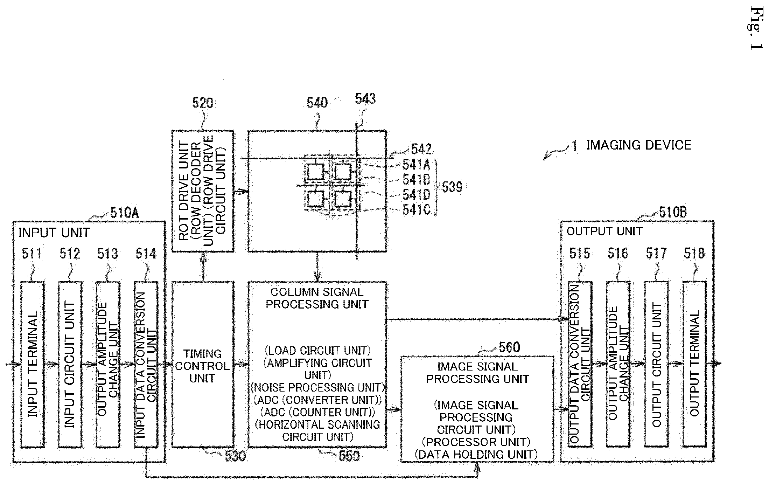

   Fig. 1 is a block diagram illustrating an example of the functional configuration of an imaging device according to an embodiment of the present disclosure.
[Fig. 2]

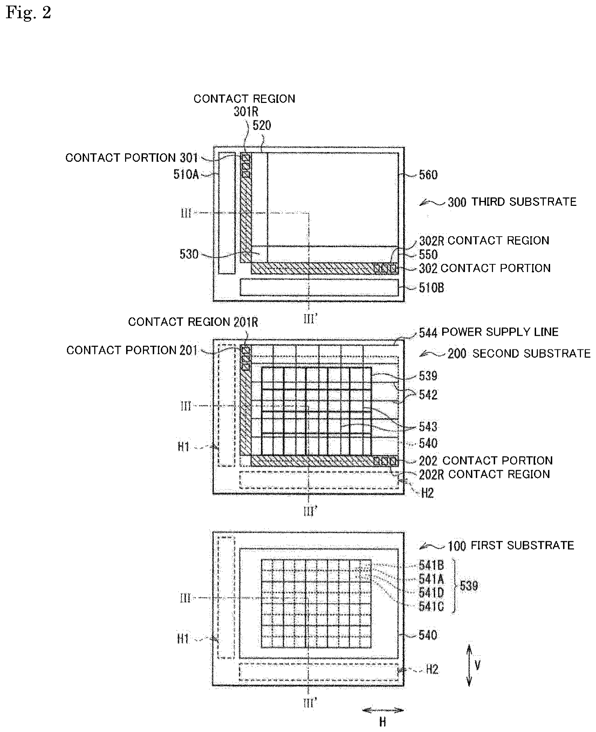

   Fig. 2 is a schematic plan view of the schematic configuration of the imaging device shown in Fig. 1.
[Fig. 3]

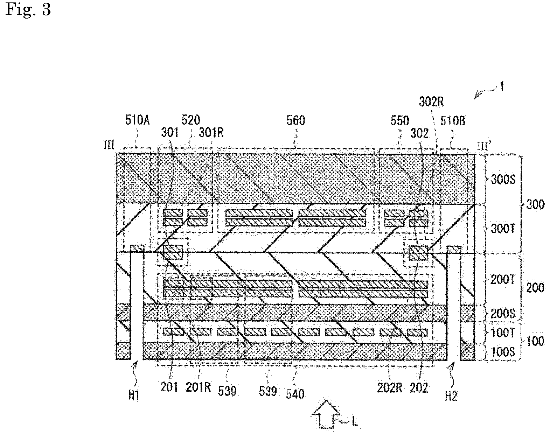

   Fig. 3 is a schematic diagram of a cross-sectional configuration taken along line III-III' shown in Fig. 2.
[Fig. 4]

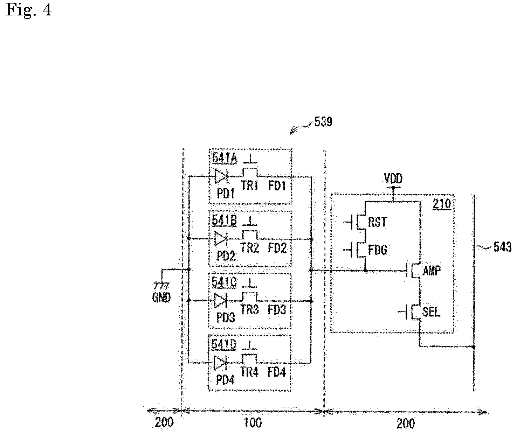

   Fig. 4 is an equivalent circuit diagram of a pixel sharing unit shown in Fig. 1.
[Fig. 5]

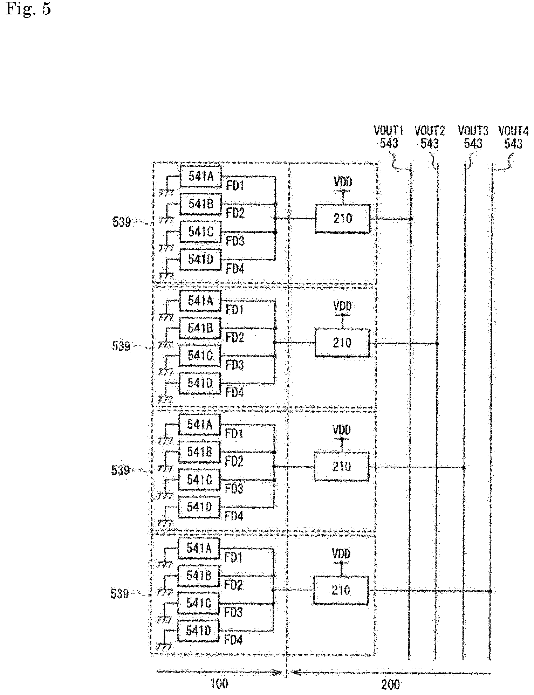

   Fig. 5 shows an example of a connection mode between the plurality of pixel sharing units and a plurality of vertical signal lines.
[Fig. 6]

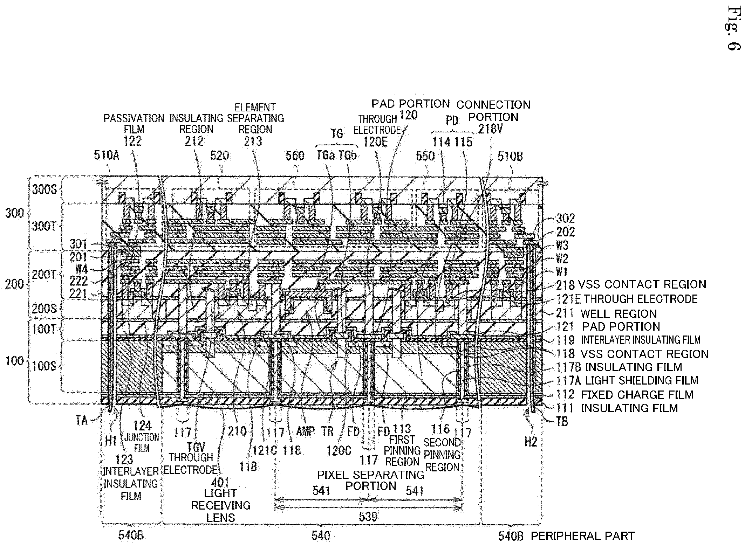

   Fig. 6 is a schematic cross-sectional view of an example of a specific configuration of the imaging device shown in Fig. 3.
[Fig. 7A]

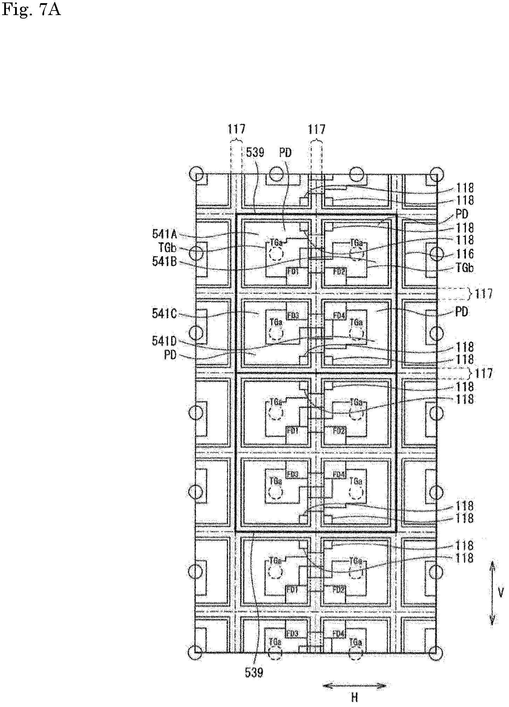

   Fig. 7A is a schematic diagram showing an example of the planar configuration of the main part of a first substrate shown in Fig. 6.
[Fig. 7B]

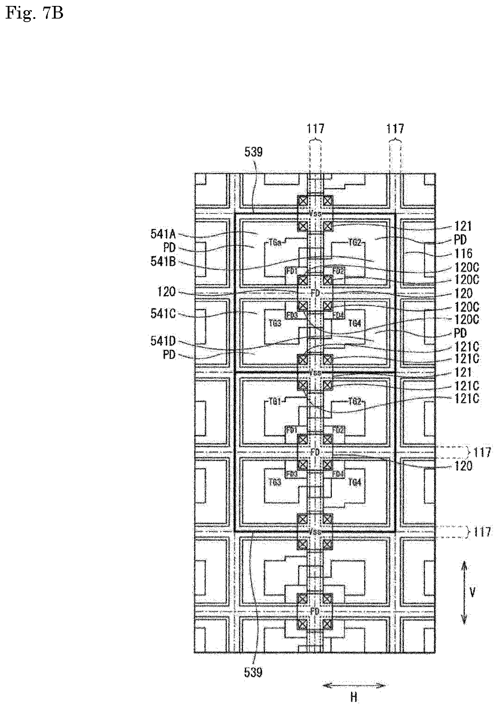

   Fig. 7B a schematic diagram showing the planar configuration of pad portions along with the main portion of the first substrate shown in Fig. 7A.
[Fig. 8]

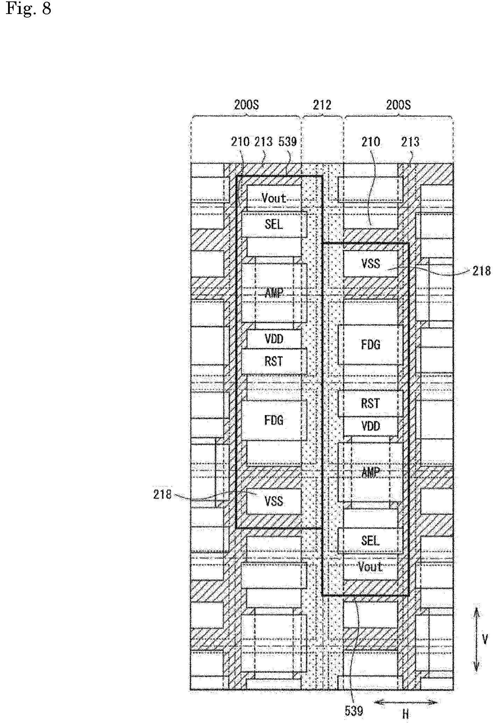

   Fig. 8 is a schematic diagram illustrating an example of the planar configuration of a second substrate (semiconductor layer) shown in Fig. 6.
[Fig. 9]

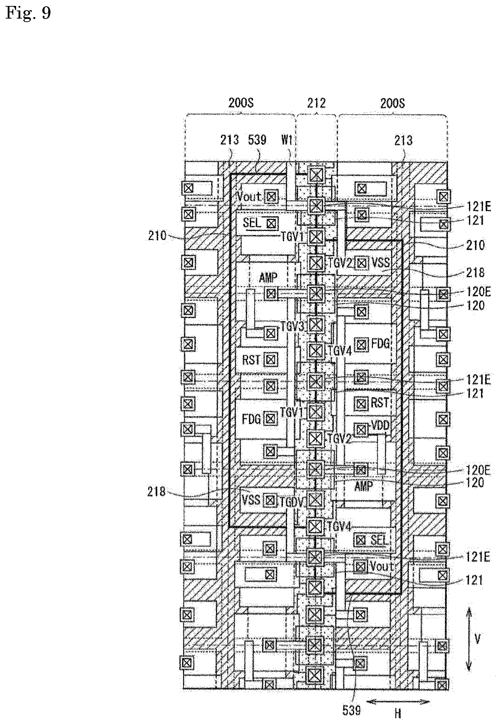

   Fig. 9 is a schematic diagram illustrating an example of the planar configuration of pixel circuits and the main part of the first substrate along with a first wiring layer shown in Fig. 6.
[Fig. 10]

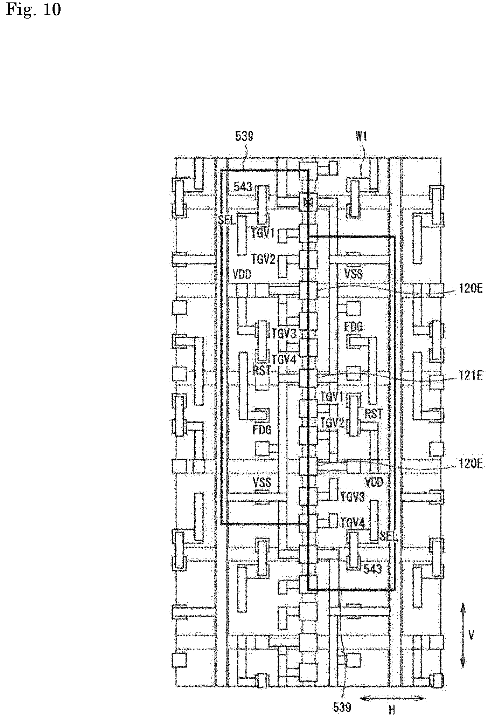

   Fig. 10 is a schematic diagram showing an example of the planar configuration of the first wiring layer and a second wiring layer in Fig. 6.
[Fig. 11]

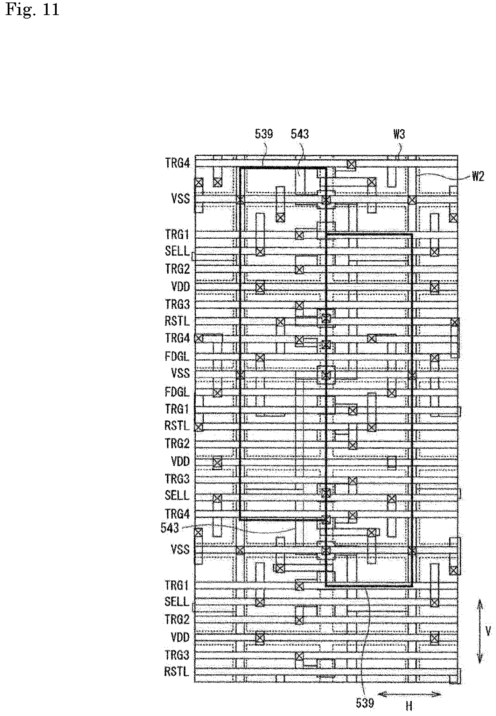

   Fig. 11 is a schematic diagram showing an example of the planar configuration of the second wiring layer and a third wiring layer in Fig. 6.
[Fig. 12]

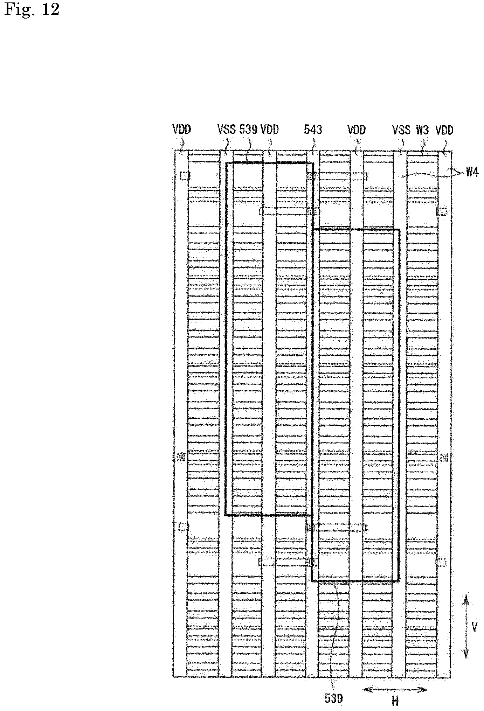

   Fig. 12 is a schematic diagram showing an example of the planar configuration of the third wiring layer and the fourth wiring layer in Fig. 6.
[Fig. 13]

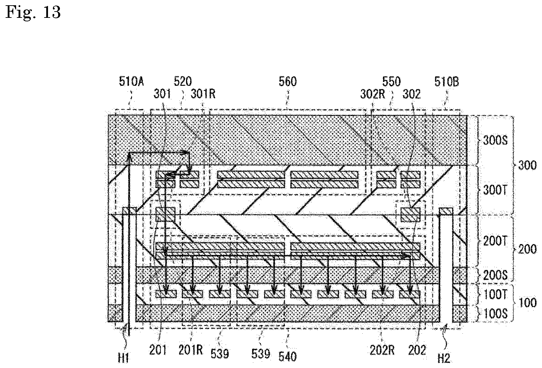

   Fig. 13 is a schematic diagram for describing the path of an input signal to the imaging device shown in Fig. 3.
[Fig. 14]

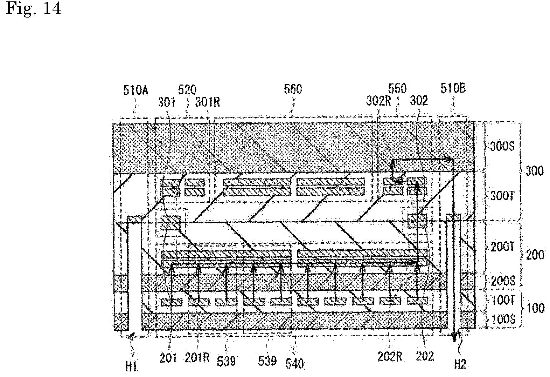

   Fig. 14 is a schematic diagram for describing the signal path of the pixel signal of the imaging device shown in Fig. 3.
[Fig. 15]

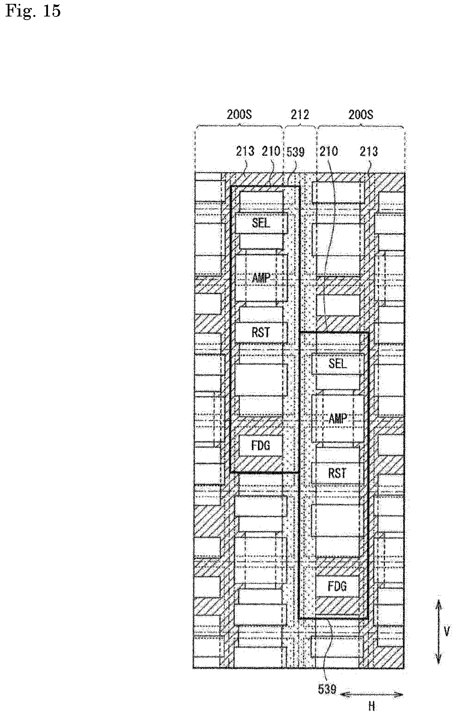

   Fig. 15 is a schematic diagram showing a modification example of the planar configuration of the second substrate (semiconductor layer) shown in Fig. 8.
[Fig. 16]

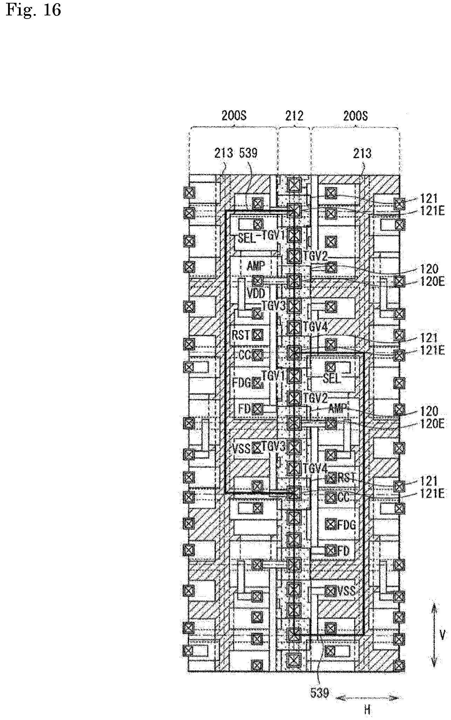

   Fig. 16 is a schematic diagram illustrating the planar configuration of the first wiring layer and the main part of the first substrate along with the pixel circuit shown in Fig. 15.
[Fig. 17]

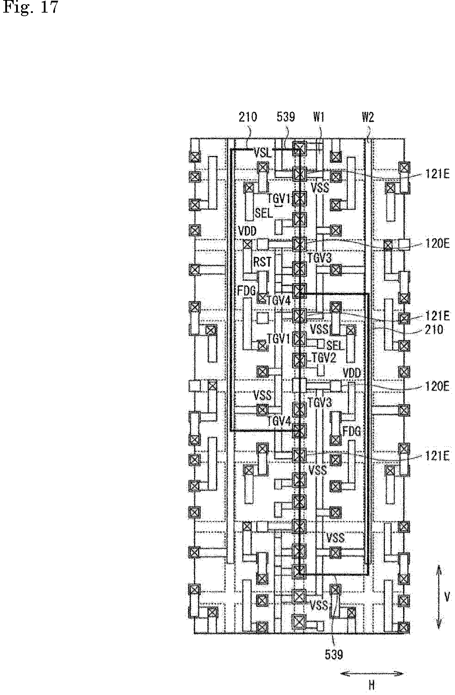

   Fig. 17 is a schematic diagram illustrating an example of the planar configuration of the second wiring layer along with the first wiring layer shown in Fig. 16.
[Fig. 18]

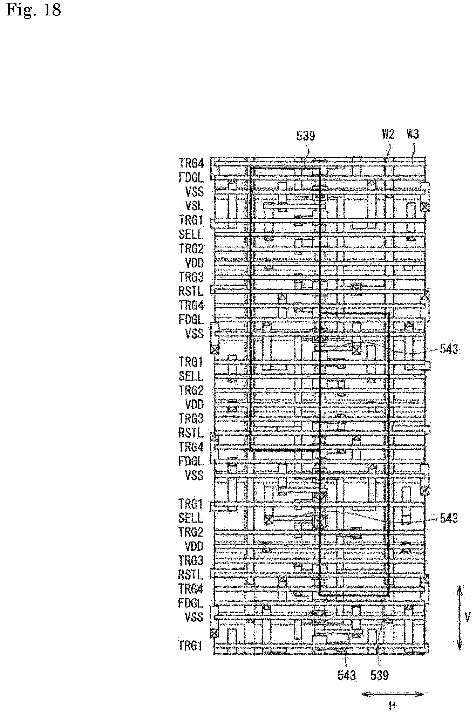

   Fig. 18 is a schematic diagram illustrating an example of the planar configuration of the third wiring layer along with the second wiring layer shown in Fig. 17.
[Fig. 19]

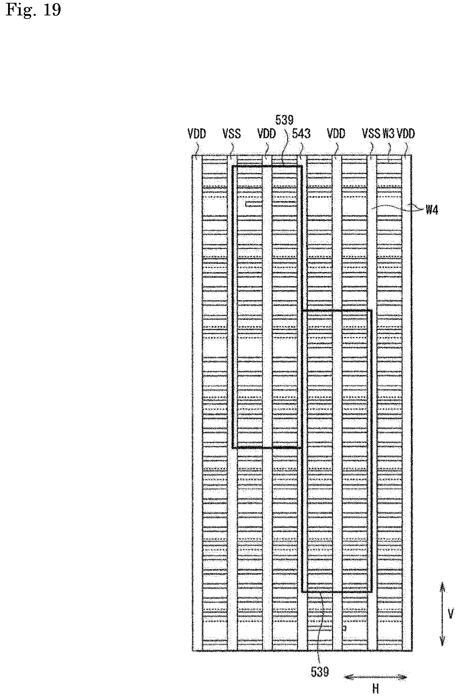

   Fig. 19 is a schematic diagram showing an example of the planar configuration of the fourth wiring layer along with the third wiring layer shown in Fig. 18.
[Fig. 20]

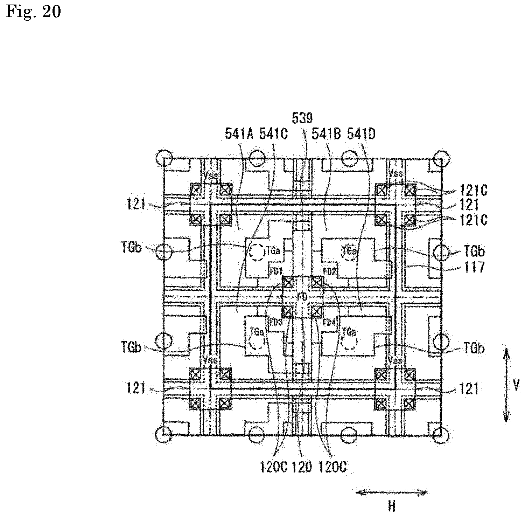

   Fig. 20 is a schematic diagram illustrating a modification example of the planar configuration of the first substrate shown in Fig. 7A.
[Fig. 21]

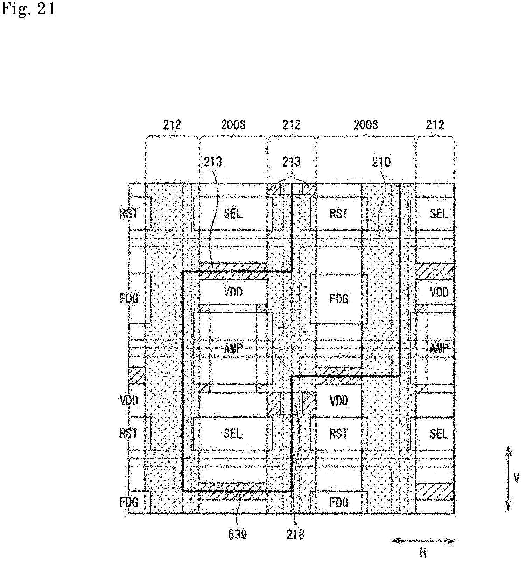

   Fig. 21 is a schematic diagram illustrating an example of the planar configuration of the second substrate (semiconductor layer) stacked on the first substrate shown in Fig. 20.
[Fig. 22]

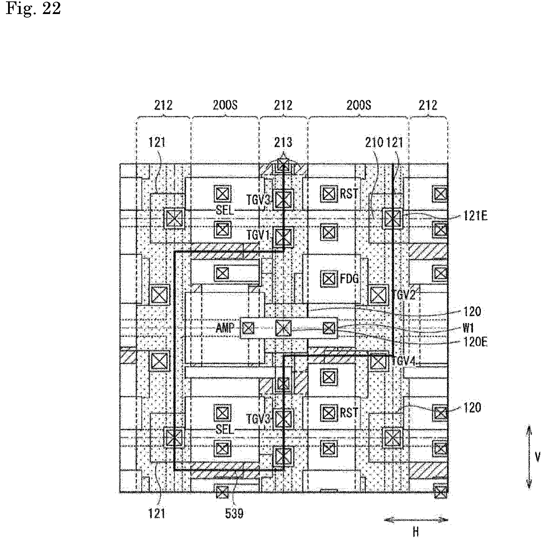

   Fig. 22 is a schematic diagram showing an example of the planar configuration of the first wiring layer along with the pixel circuit shown in Fig. 21.
[Fig. 23]

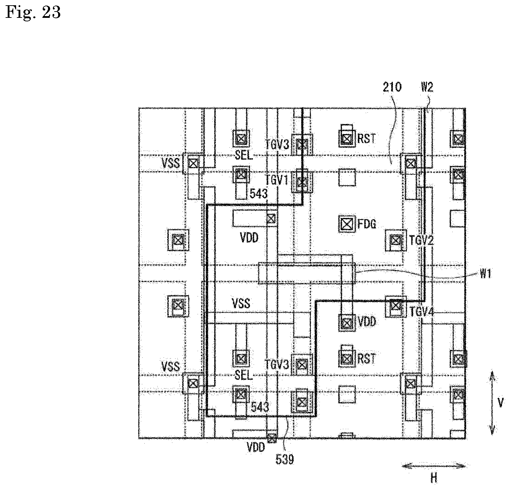

   Fig. 23 is a schematic diagram showing an example of the planar configuration of the second wiring layer along with the first wiring layer shown in Fig. 22.
[Fig. 24]

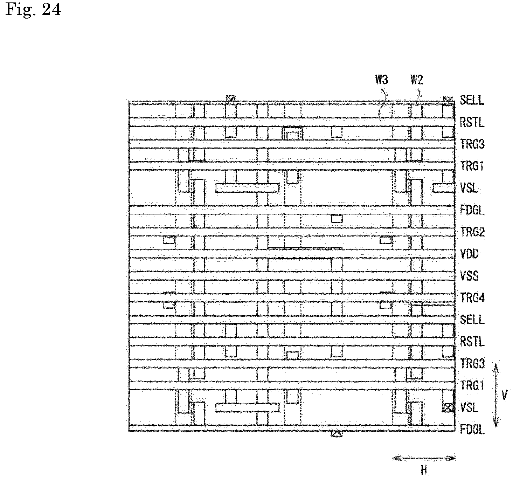

   Fig. 24 is a schematic diagram illustrating an example of the planar configuration of the third wiring layer along with the second wiring layer shown in Fig. 23.
[Fig. 25]

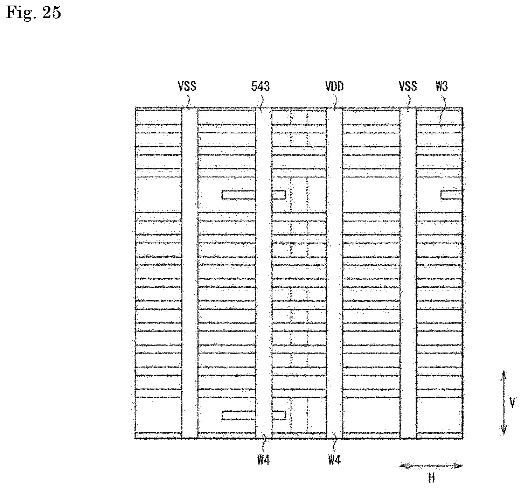

   Fig. 25 is a schematic diagram illustrating an example of the planar configuration of the fourth wiring layer along with the third wiring layer shown in Fig. 24.
[Fig. 26]

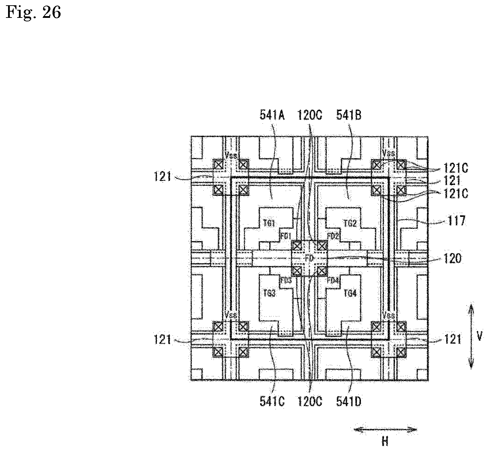

   Fig. 26 is a schematic diagram illustrating another example of the planar configuration of the first substrate shown in Fig. 20.
[Fig. 27]

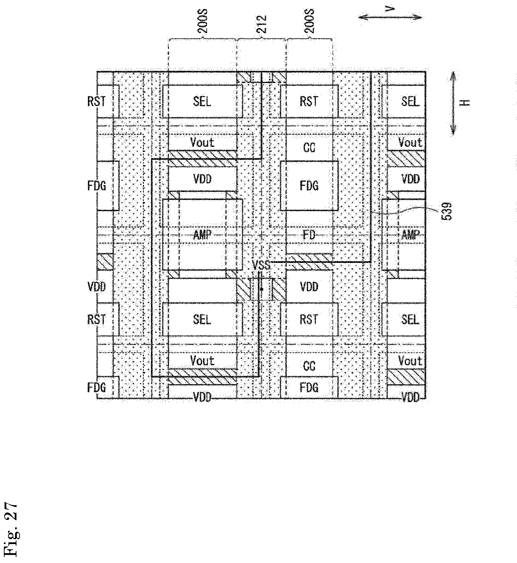

   Fig. 27 is a schematic diagram illustrating an example of the planar configuration of the second substrate (semiconductor layer) stacked on the first substrate shown in Fig. 26.
[Fig. 28]

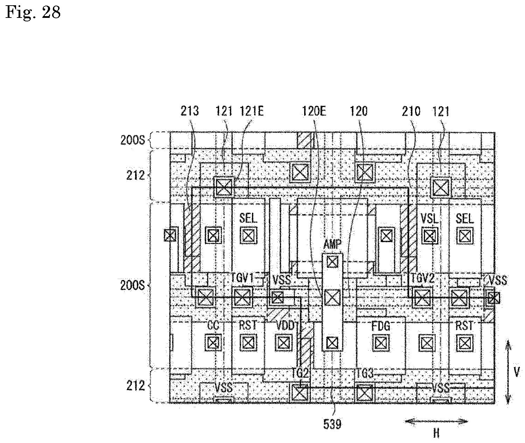

   Fig. 28 is a schematic diagram showing an example of the planar configuration of the first wiring layer along with the pixel circuit shown in Fig. 27.
[Fig. 29]

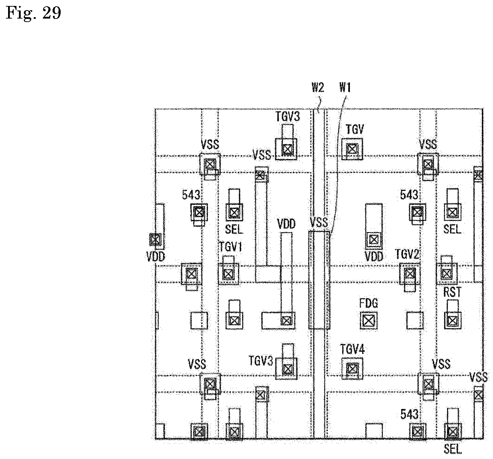

   Fig. 29 is a schematic diagram illustrating an example of the planar configuration of the second wiring layer along with the first wiring layer shown in Fig. 28.
[Fig. 30]

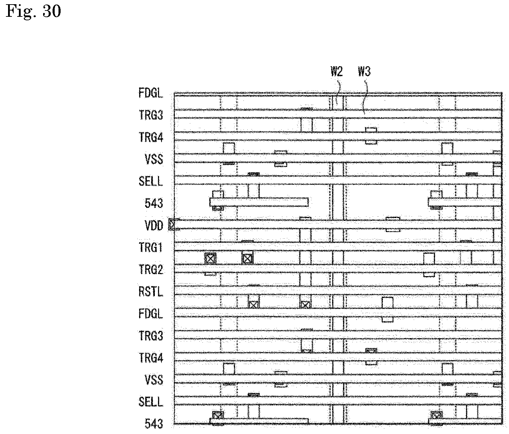

   Fig. 30 is a schematic diagram illustrating an example of the planar configuration of the third wiring layer along with the second wiring layer shown in Fig. 29.
[Fig. 31]

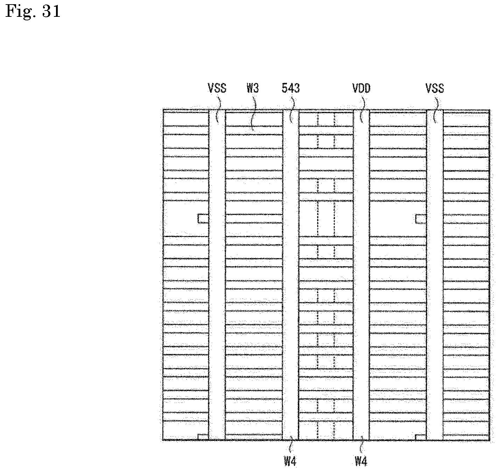

   Fig. 31 is a schematic diagram illustrating an example of the planar configuration of the fourth wiring layer along with the third wiring layer shown in Fig. 30.
[Fig. 32]

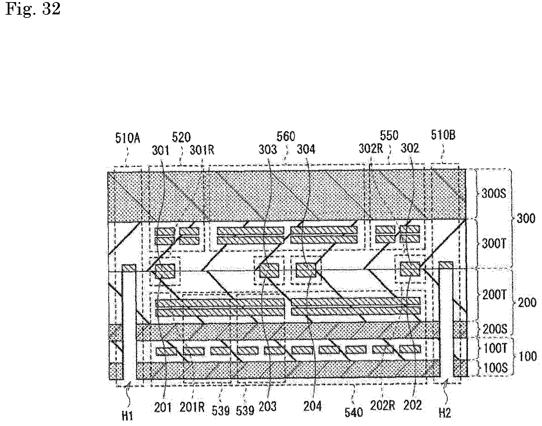

   Fig. 32 is a schematic cross-sectional view illustrating another example of the imaging device shown in Fig. 3.
[Fig. 33]

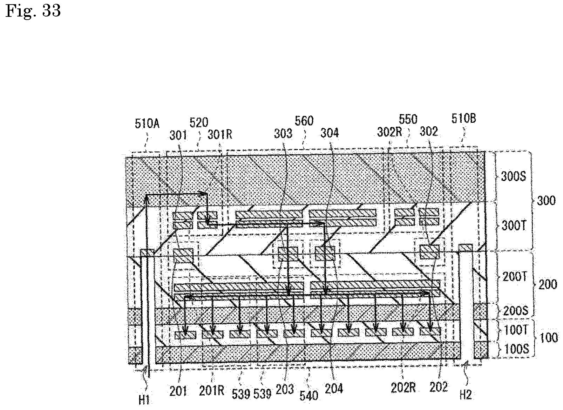

   Fig. 33 is a schematic diagram for describing the path of the input signal to the imaging device shown in Fig. 32.
[Fig. 34]

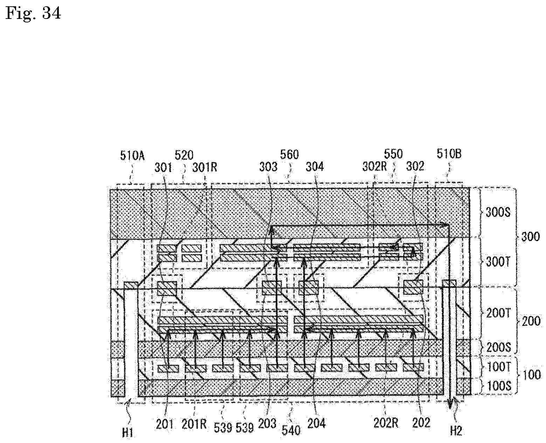

   Fig. 34 is a schematic diagram for describing the signal path of the pixel signal of the imaging device shown in Fig. 32.
[Fig. 35]

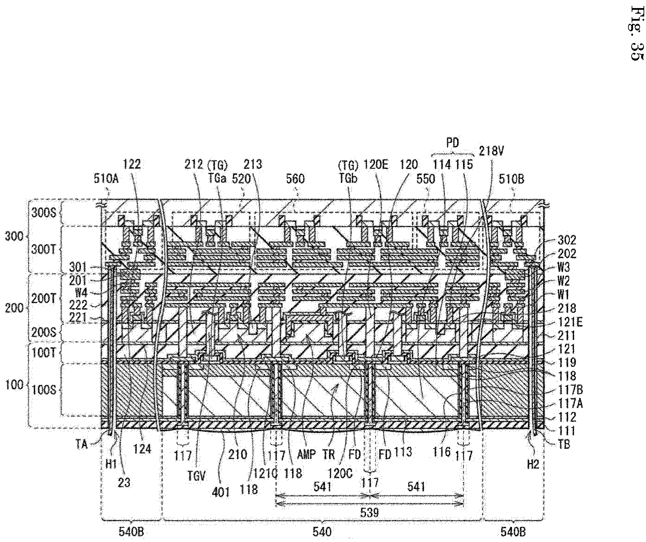

   Fig. 35 is a schematic cross-sectional view illustrating another example of the imaging device shown in Fig. 6.
[Fig. 36]

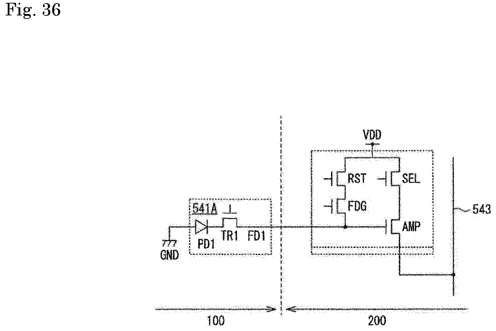

   Fig. 36 illustrates another example of an equivalent circuit shown in Fig. 4.
[Fig. 37]

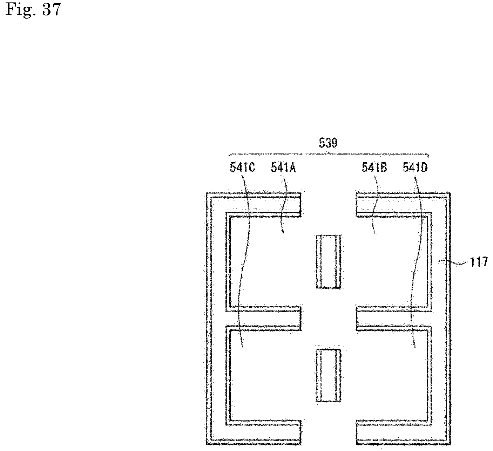

   Fig. 37 is a schematic plan view illustrating another example of a pixel separating portion shown in Fig. 7A and other drawings.
[Fig. 38]

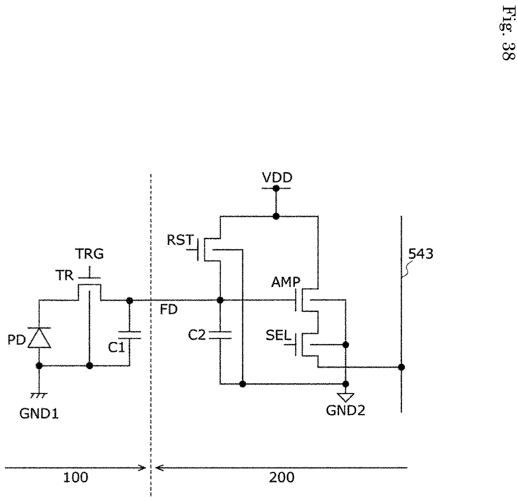

   Fig. 38 illustrates an example of the equivalent circuit according to the embodiment.
[Fig. 39]

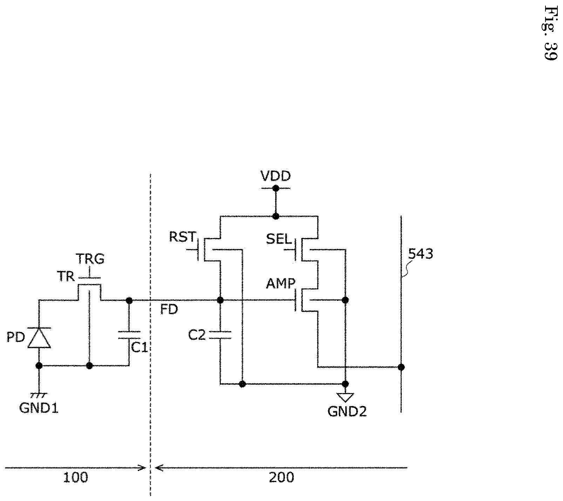

   Fig. 39 illustrates an example of the equivalent circuit according to the embodiment.
[Fig. 40]

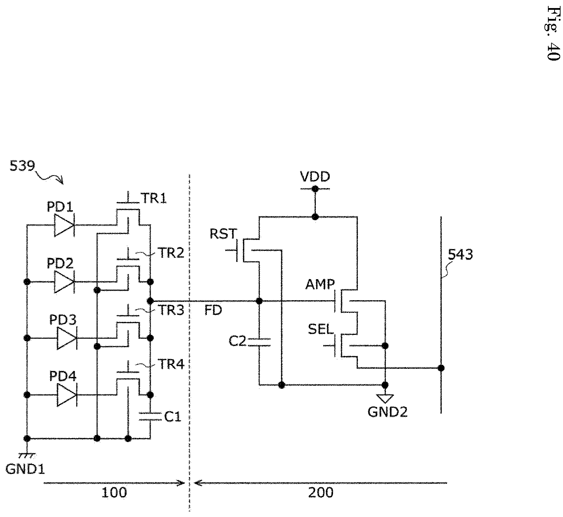

   Fig. 40 illustrates an example of the equivalent circuit according to the embodiment.
[Fig. 41]

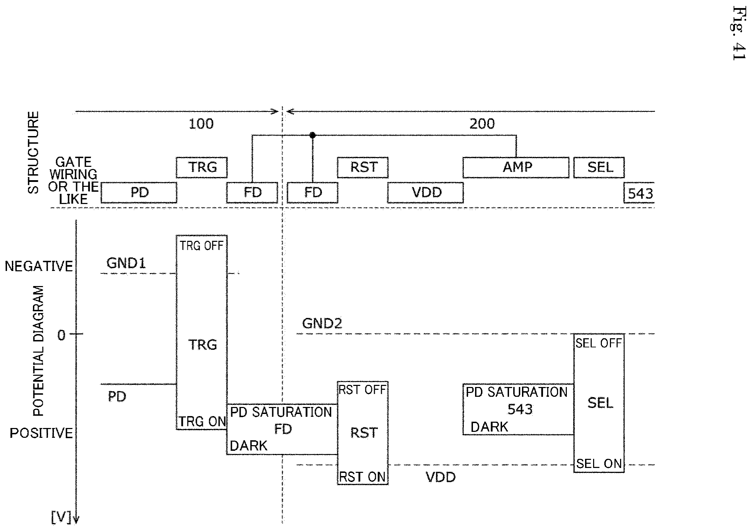

   Fig. 41 shows a potential diagram of the equivalent circuit according to the embodiment.
[Fig. 42]

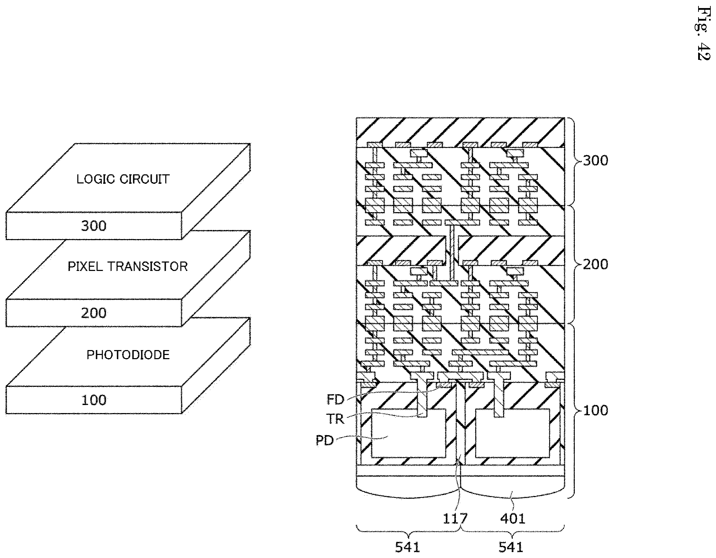

   Fig. 42 illustrates an example of the configuration of the substrate when a ground potential is changed according to the embodiment.
[Fig. 43]

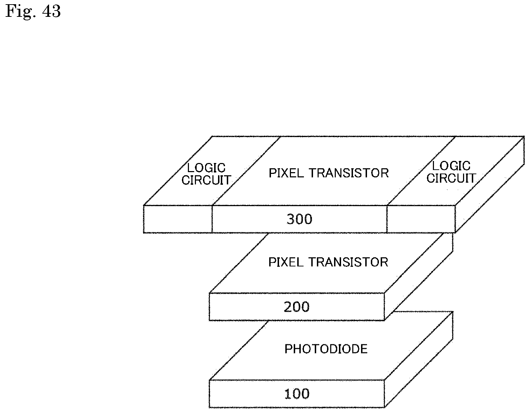

   Fig. 43 illustrates an example of the configuration of the substrate when the ground potential is changed according to the embodiment.
[Fig. 44]

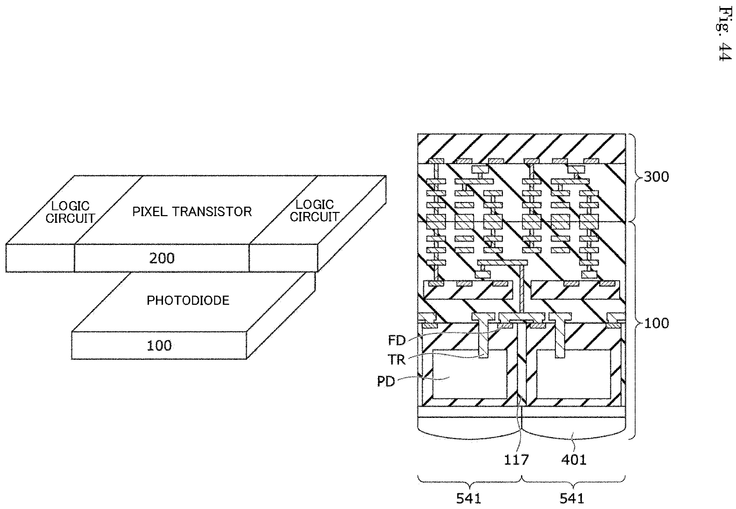

   Fig. 44 illustrates an example of the configuration of the substrate when the ground potential is changed according to the embodiment.
[Fig. 45]

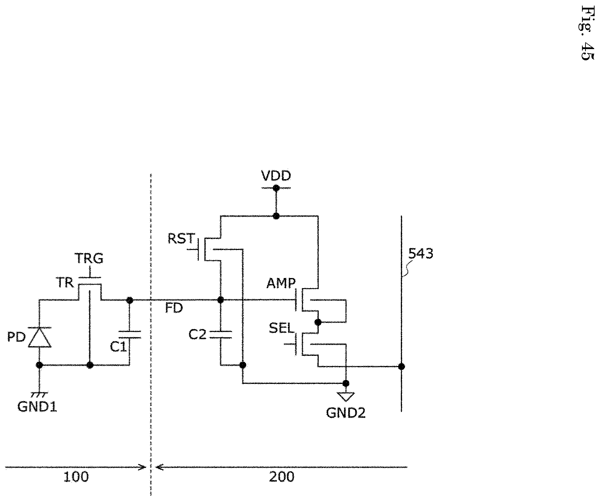

   Fig. 45 illustrates an example of the configuration of the equivalent circuit according to the embodiment.
[Fig. 46]

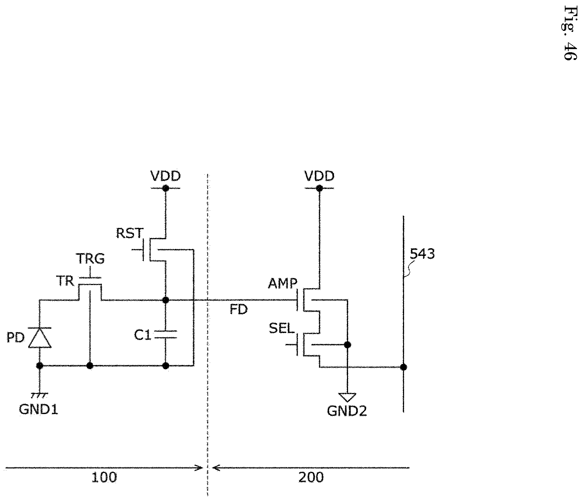

   Fig. 46 illustrates an example of the configuration of the equivalent circuit according to the embodiment.
[Fig. 47]

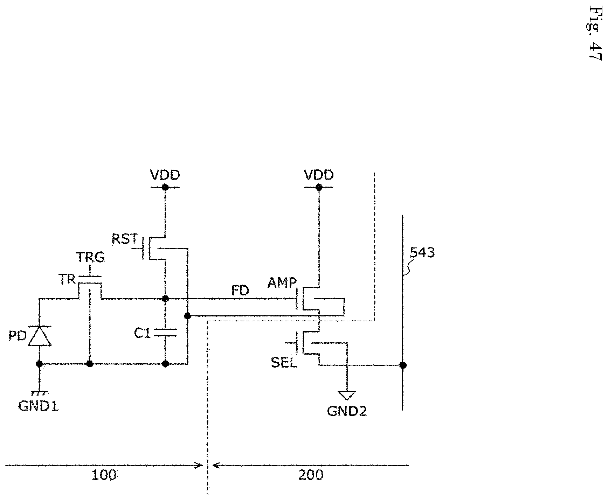

   Fig. 47 illustrates an example of the configuration of the equivalent circuit according to the embodiment.
[Fig. 48]

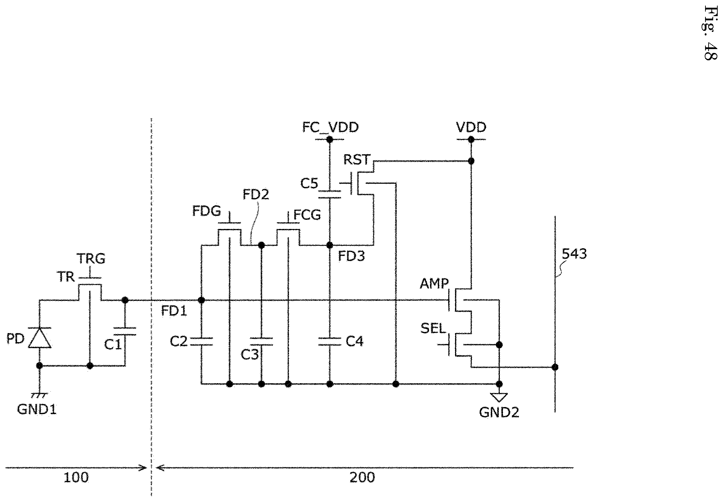

   Fig. 48 illustrates an example of the configuration of the equivalent circuit according to the embodiment.
[Fig. 49]

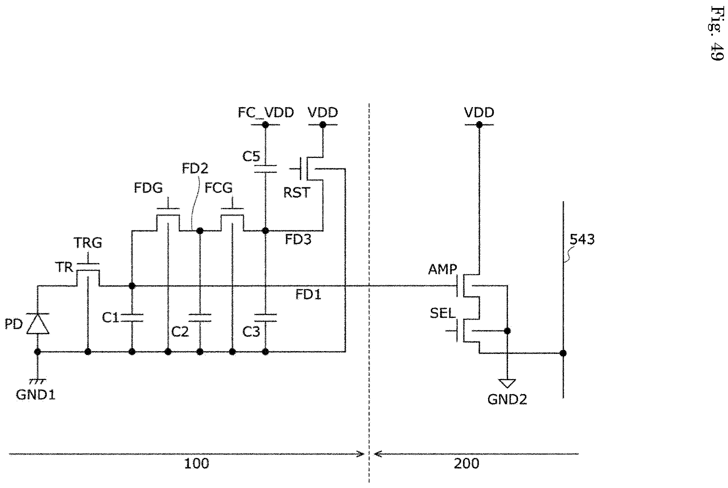

   Fig. 49 illustrates an example of the configuration of the equivalent circuit according to the embodiment.
[Fig. 50]

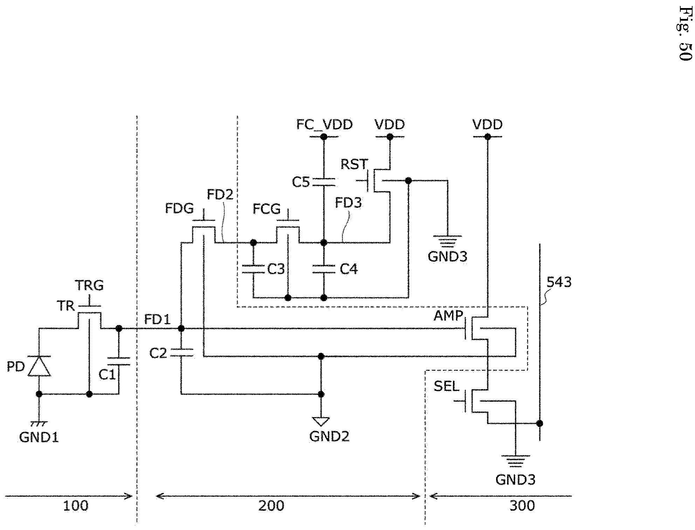

   Fig. 50 illustrates an example of the configuration of the equivalent circuit according to the embodiment.
[Fig. 51]

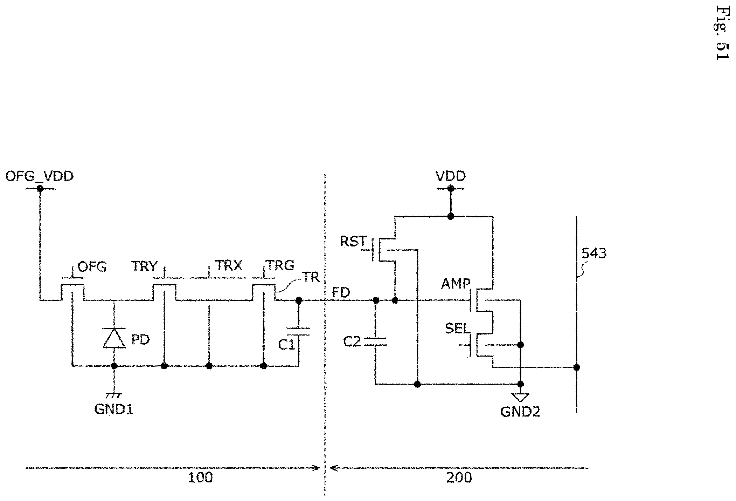

   Fig. 51 illustrates an example of the configuration of the equivalent circuit according to the embodiment.
[Fig. 52]

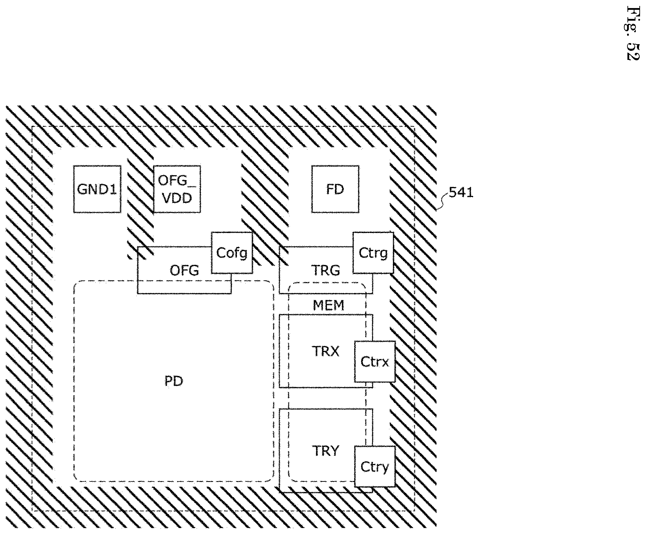

   Fig. 52 illustrates an example of the configuration of the equivalent circuit according to the embodiment.
[Fig. 53]

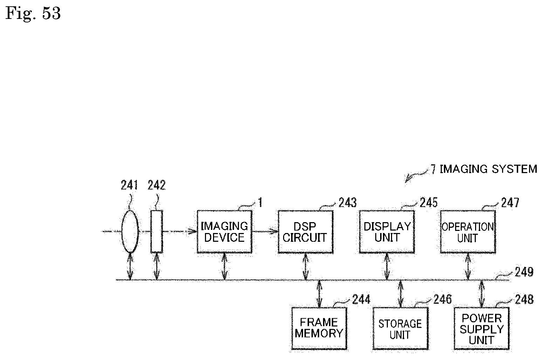

   Fig. 53 illustrates an example of a schematic configuration of an imaging system including the imaging device according to the embodiment and modification examples.
[Fig. 54]

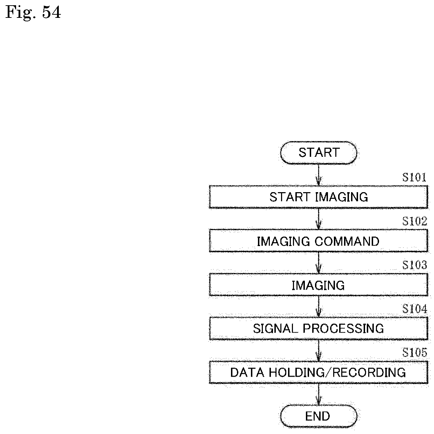

   Fig. 54 shows an example of the imaging procedure of the imaging system in Fig. 53.
[Fig. 55]

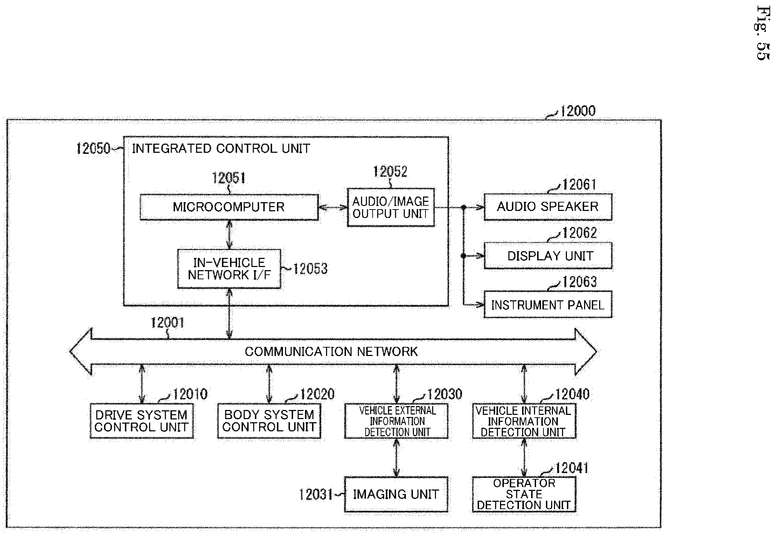

   Fig. 55 is a block diagram illustrating an example of a schematic configuration of a vehicle control system.
[Fig. 56]

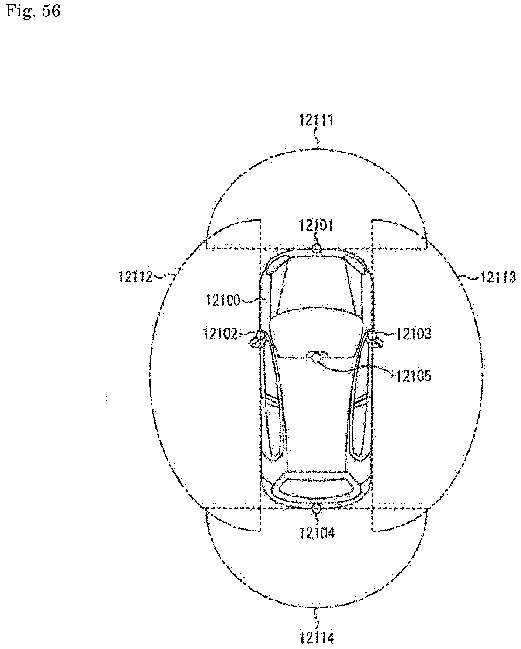

   Fig. 56 is an explanatory drawing illustrating an example of the installation positions of a vehicle external information detection unit and an imaging unit.
[Fig. 57]

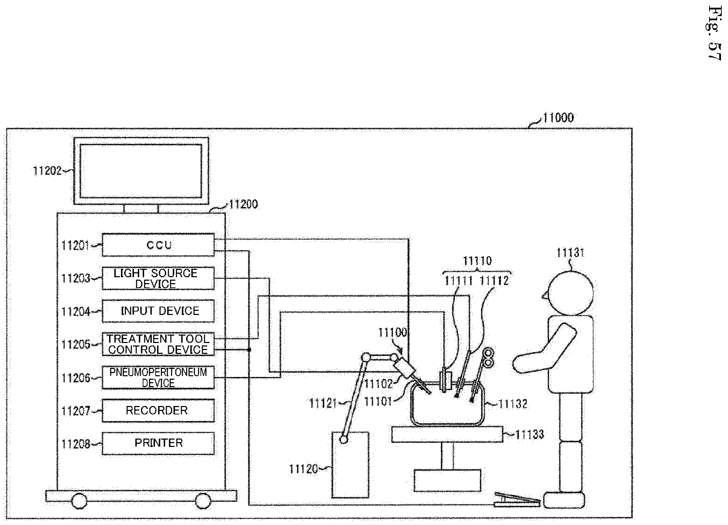

   Fig. 57 illustrates an example of a schematic configuration of an endoscopic system.
[Fig. 58]

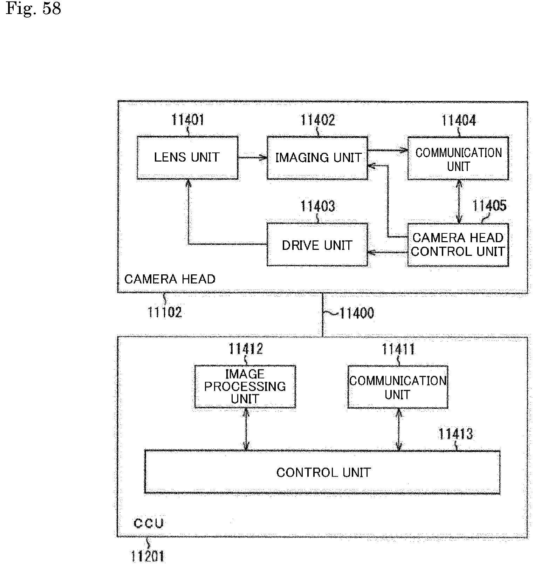

   Fig. 58 is a block diagram showing an example of the functional configuration of a camera head and a CCU.

### [Description of Embodiments]

An embodiment of the present disclosure will be described below with reference to the accompanying drawings. The drawings are used for illustrative purposes, and do not always agree with the shapes and sizes of the configurations of units in an actual device or size ratios or the like relative to other configurations in the actual device. Since the drawings are simplified, configurations that are not illustrated but are necessary for implementation are assumed to be provided as appropriate.

Although an imaging device will be described below, the wording of the imaging device can be replaced with, for example, that of a solid-state imaging device.

The description will be made in the following order.
1. Embodiment (an imaging device having a laminated structure of three substrates)
2. Modification example 1 (example 1 of a planar configuration)
3. Modification example 2 (example 2 of a planar configuration)
4. Modification example 3 (example 3 of a planar configuration)
5. Modification example 4 (example in which a contact portion is provided at the central portion of a pixel array part)
6. Modification example 5 (example in which a planar transfer transistor is provided)
7. Modification example 6 (example in which one pixel is connected to one pixel circuit)
8. Modification example 7 (configuration example of a pixel separating portion)
9. Modification example 8 (configuration example 1 of the ground potential of a substrate)
10. Modification example 9 (configuration example in a cross section of the substrate)
11. Modification example 10 (configuration example 2 of the ground potential of the substrate)
12. Availability example (imaging system)
13. Application examples

### <1. Embodiment>

### [Functional configuration of imaging device 1]

Fig. 1 is a block diagram illustrating an example of the functional configuration of an imaging device (imaging device 1) according to an embodiment of the present disclosure.

The imaging device 1 in Fig. 1 includes, for example, an input unit 510A, a row drive unit 520, a timing control unit 530, a pixel array part 540, a column signal processing unit 550, an image signal processing unit 560, and an output unit 510B.

In the pixel array part 540, pixels 541 are arranged repeatedly in an array. More specifically, pixel sharing units 539, each of which includes a plurality of pixels, serve as units of repetition and are arranged repeatedly in an array of row and column directions. In the present specification, for convenience, the row direction may be referred to as H direction, whereas the column direction orthogonal to the row direction may be referred to as V direction. In the example of Fig. 1, one of the pixel sharing units 539 includes four pixels (pixels 541A, 541B, 541C, and 541D). Each of the pixels 541A, 541B, 541C, and 541D includes a photodiode PD (shown in Fig. 6 and other drawings, which will be described later). The pixel sharing unit 539 is a unit of sharing of one pixel circuit (a pixel circuit 210 of Fig. 3, which will be described later). In other words, one pixel circuit (the pixel circuit 210 described later) is provided for each of the four pixels (pixels 541A, 541B, 541C, and 541D). By operating the pixel circuit in a time-sharing manner, the pixel signals of the pixels 541A, 541B, 541C, and 541D are sequentially read. The pixels 541A, 541B, 541C, and 541D are arranged in, for example, two rows by two columns. In the pixel array part 540, a plurality of row drive signal lines 542 and a plurality of vertical signal lines (column reading lines) 543 are provided along with the pixels 541A, 541B, 541C, and 541D. The row drive signal lines 542 drive the pixels 541 that are included in the plurality of pixel sharing units 539 and are arranged in the row direction in the pixel array part 540. Among the pixel sharing units 539, the pixels arranged in the row direction are driven. The pixel sharing unit 539 includes a plurality of transistors, which will be described in detail later with reference to Fig. 4. In order to drive each of the transistors, the plurality of row drive signal lines 542 are connected to each of the pixel sharing units 539. The pixel sharing units 539 are connected to vertical signal lines (column reading lines) 543. From the pixels 541A, 541B, 541C, and 541D included in the pixel sharing unit 539, pixel signals are read through the vertical signal lines (column reading lines) 543.

The row drive unit 520 includes, for example, a row address control unit that determines a row position for driving pixels, in other words, a row decoder unit, and a row drive circuit unit that generates signals for driving the pixels 541A, 541B, 541C, and 541D.

The column signal processing unit 550 includes, for example, a load circuit unit that is connected to the vertical signal line 543 and forms a source follower circuit with the pixels 541A, 541B, 541C, and 541D (pixel sharing unit 539). The column signal processing unit 550 may include an amplifying circuit unit that amplifies signals read from the pixel sharing units 539 through the vertical signal line 543. The column signal processing unit 550 may include a noise processing unit. In the noise processing unit, for example, the noise level of the system is removed from the signals read from the pixel sharing units 539 as a result of photoelectric conversion.

The column signal processing unit 550 includes, for example, an analog-to-digital converter (ADC). The analog-to-digital converter converts a signal read from the pixel sharing units 539 or the noise-processed analog signal into a digital signal. The ADC includes, for example, a comparator unit and a counter unit. The comparator unit compares an analog signal to be converted and a reference signal as a target of comparison with the analog signal. The counter unit measures the time until the comparison result in the comparator unit is inverted. The column signal processing unit 550 may include a horizontal scanning circuit unit that controls scanning of a column to be read.

The timing control unit 530 provides timing control signals to the row drive unit 520 and the column signal processing unit 550 on the basis of reference clock signals and timing control signals input to the device.

The image signal processing unit 560 is a circuit that performs various kinds of signal processing on data obtained as a result of photoelectric conversion, in other words, data obtained as a result of imaging operation by the imaging device 1. The image signal processing unit 560 includes, for example, an image signal processing circuit unit and a data holding unit. The image signal processing unit 560 may include a processor unit.

An example of signal processing performed in the image signal processing unit 560 is tone curve correction processing, in which when AD-converted imaging data is data on a dark subject, the tonal range is increased, whereas when the imaging data is data on a bright subject, the tonal range is reduced. In this case, it is desirable to store in advance, in the data holding unit of the image signal processing unit 560, tone curve characteristic data for determining a reference tone curve for correcting the tones of the imaging data.

The input unit 510A is used to input, for example, the reference clock signal, the timing control signals, and the characteristic data from the outside of the device to the imaging device 1. The timing control signals are, for example, a vertical synchronizing signal and a horizontal synchronizing signal. The characteristic data is, for example, data to be stored in the data holding unit of the image signal processing unit 560. The input unit 510A includes, for example, an input terminal 511, an input circuit unit 512, an input amplitude change unit 513, an input data conversion circuit unit 514, and a power supply unit (not shown).

The input terminal 511 is an external terminal for inputting data. The input circuit unit 512 is configured to capture signals input to the input terminal 511 into the imaging device 1. The input amplitude change unit 513 changes the amplitude of a signal captured by the input circuit unit 512, into an amplitude that is easy to use in the imaging device 1. The input data conversion circuit unit 514 changes the order of the data sequence of the input data. The input data conversion circuit unit 514 includes, for example, a serial-to-parallel conversion circuit. In the serial-to-parallel conversion circuit, serial signals received as input data are converted to parallel signals. In the input unit 510A, the input amplitude change unit 513 and the input data conversion circuit unit 514 may be omitted. The power supply unit supplies power set at various voltage levels required in the imaging device 1, on the basis of power supplied to the imaging device 1 from the outside.

When the imaging device 1 is connected to an external memory device, the input unit 510A may be provided with memory interface circuitry to receive data from the external memory device. Examples of the external memory device include a flash memory, an SRAM, and a DRAM.

The output unit 510B outputs image data to the outside of the device. The image data is, for example, image data captured by the imaging device 1 and image data subjected to signal processing by the image signal processing unit 560. The output unit 510B includes, for example, an output data conversion circuit unit 515, an output amplitude change unit 516, an output circuit unit 517, and an output terminal 518.

The output data conversion circuit unit 515 includes, for example, a parallel-serial conversion circuit, and in the output data conversion circuit unit 515, parallel signals used in the imaging device 1 are converted into serial signals. The output amplitude change unit 516 changes the amplitude of a signal used in the imaging device 1. The amplitude-changed signal is easy to use in an external device connected to the imaging device 1. The output circuit unit 517 is a circuit that outputs data from inside of the imaging device 1 to the outside of the device, and an external wiring that is located outside the imaging device 1 and is connected to the output terminal 518 is driven by the output circuit unit 517. At the output terminal 518, data is output from the imaging device 1 to the outside of the device. In the output unit 510B, the output data conversion circuit unit 515 and the output amplitude change unit 516 may be omitted.

When the imaging device 1 is connected to an external memory device, the output unit 510B may be provided with a memory interface circuit that outputs data to the external memory device. Examples of the external memory device include a flash memory, an SRAM, and a DRAM.

### [Schematic configuration of imaging device 1]

Figs. 2 and 3 show an example of the schematic configuration of the imaging device 1. The imaging device 1 includes three substrates (a first substrate 100, a second substrate 200, and a third substrate 300). Fig. 2 schematically shows the planar configurations of the first substrate 100, the second substrate 200, and the third substrate 300. Fig. 3 schematically shows the cross-sectional configurations of the first substrate 100, the second substrate 200, and the third substrate 300 that are stacked on top of each other. Fig. 3 corresponds to the cross-sectional configuration taken along line **III-III'** shown in Fig. 2. The imaging device 1 is an imaging device having a three-dimensional structure configured by bonding the three substrates (the first substrate 100, the second substrate 200, and the third substrate 300). The first substrate 100 includes a semiconductor layer 100S and a wiring layer 100T. The second substrate 200 includes a semiconductor layer 200S and a wiring layer 200T. The third substrate 300 includes a semiconductor layer 300S and a wiring layer 300T. In this configuration, for convenience, the wiring included in each of the first substrate 100, the second substrate 200, and the third substrate 300 and an interlayer insulating film surrounding the wiring are combined and referred to as a wiring layer (100T, 200T, or 300T) provided in each of the substrates (the first substrate 100, the second substrate 200, and the third substrate 300). The first substrate 100, the second substrate 200, and the third substrate 300 are stacked in this order, and the semiconductor layer 100S, the wiring layer 100T, the semiconductor layer 200S, the wiring layer 200T, the wiring layer 300T, and the semiconductor layer 300S are arranged in this order along the stacking direction. The specific configurations of the first substrate 100, the second substrate 200, and the third substrate 300 will be described later. The arrow illustrated in Fig. 3 represents a direction of incidence of light L into the imaging device 1. As used herein, in the following cross-sectional views, the light incidence side of the imaging device 1 may be referred to as "lower", "lower side", or "below", and the side opposite to the light incidence side may be referred to as "upper", "upper side", or "above" for convenience. Also herein, with respect to the substrate including the semiconductor layer and the wiring layer, the side near the wiring layer may be referred to as a front side and the side near the semiconductor layer may be referred to as a back side for convenience. The description in the specification is not limited to the above-described terminology. The imaging device 1 is, for example, a back-illuminated imaging device in which light enters from the back side of the first substrate 100 including photodiodes.

The pixel array part 540 and the pixel sharing unit 539 included in the pixel array part 540 are both configured using both of the first substrate 100 and the second substrate 200.

The first substrate 100 is provided with the plurality of pixels 541A, 541B, 541C, and 541D included in the pixel sharing unit 539. Each of the pixels 541 has a photodiode (photodiode PD described later) and a transfer transistor (transfer transistor TR described later). The second substrate 200 is provided with the pixel circuit (pixel circuit 210 described later) included in the pixel sharing unit 539. The pixel circuit reads the pixel signals transferred from the respective photodiodes of the pixels 541A, 541B, 541C, and 541D via the transfer transistors, or resets the photodiodes. In addition to such a pixel circuit, the second substrate 200 includes the plurality of row drive signal lines 542 extending in the row direction and the plurality of vertical signal lines 543 extending in the column direction. The second substrate 200 further includes a power supply line 544 extending in the row direction. The third substrate 300 includes, for example, the input unit 510A, the row drive unit 520, the timing control unit 530, the column signal processing unit 550, the image signal processing unit 560, and the output unit 510B. For example, the row drive unit 520 is provided in a region where the row drive unit 520 partially overlaps the pixel array part 540 in the direction in which the first substrate 100, the second substrate 200, and the third substrate 300 are stacked (hereinafter simply referred to as the stacking direction). More specifically, the row drive unit 520 is provided in a region that overlaps the vicinity of the H direction end of the pixel array part 540 in the stacking direction (Fig. 2). For example, the column signal processing unit 550 is provided in a region where a part of the column signal processing unit 550 overlaps the pixel array part 540 in the stacking direction. More specifically, the column signal processing unit 550 is provided in a region that overlaps the vicinity of the V direction end of the pixel array part 540 in the stacking direction (Fig. 2). Although not illustrated, the input unit 510A and the output unit 510B may be disposed in parts other than the third substrate 300, for example, in the second substrate 200. Alternatively, the input unit 510A and the output unit 510B may be provided on the back side (light incident side) of the first substrate 100. The pixel circuit provided in the second substrate 200 may be referred to as a pixel transistor circuit, a pixel transistor group, a pixel transistor, a pixel readout circuit, or a readout circuit as another name. The term "pixel circuit" is used herein.

The first substrate 100 and the second substrate 200 are electrically connected to each other via, for example, through electrodes (through electrodes 120E and 121E in Fig. 6, which will be described later). The second substrate 200 and the third substrate 300 are electrically connected to each other via, for example, contact portions 201, 202, 301, and 302. The contact portions 201 and 202 are provided on the second substrate 200, and the contact portions 301 and 302 are provided on the third substrate 300. The contact portions 201 of the second substrate 200 are in contact with the contact portions 301 of the third substrate 300, and the contact portions 202 of the second substrate 200 are in contact with the contact portions 302 of the third substrate 300. The second substrate 200 has a contact region 201R including the plurality of contact portions 201 and a contact region 202R including the plurality of contact portions 202. The third substrate 300 has a contact region 301R including the plurality of contact portions 301 and a contact region 302R including the plurality of contact portions 302. The contact regions 201R and 301R are provided between the pixel array part 540 and the row drive unit 520 in the stacking direction (Fig. 3). In other words, the contact regions 201R and 301R are provided in, for example, a region where the row drive unit 520 (third substrate 300) and the pixel array part 540 (second substrate 200) overlap each other in the stacking direction or in an adjacent region. The contact regions 201R and 301R are disposed on, for example, the H direction ends of these regions (Fig. 2). On the third substrate 300, for example, the contact region 301R is provided at a position overlapping a part of the row drive unit 520, specifically, the H direction end of the row drive unit 520 (Figs. 2 and 3). The contact portions 201 and 301 connect, for example, the row drive unit 520 provided on the third substrate 300 and a row drive line 542 provided on the second substrate 200. The contact portions 201 and 301 may connect, for example, the input unit 510A provided on the third substrate 300 to the power supply line 544 and a reference potential line (reference potential line VSS described later). The contact regions 202R and 302 R are provided between the pixel array part 540 and the column signal processing unit 550 in the stacking direction (Fig. 3). In other words, the contact regions 202R and 302R are provided in, for example, a region where the column signal processing unit 550 (third substrate 300) and the pixel array part 540 (second substrate 200) overlap each other in the stacking direction, or in an adjacent region. The contact regions 202R and 302R are arranged on, for example, the V direction ends of these regions (Fig. 2). On the third substrate 300, for example, the contact region 301R is provided at a position overlapping a part of the column signal processing unit 550, specifically, the V direction end of the column signal processing unit 550 (Figs. 2 and 3). The contact portions 202 and 302 are provided for connecting, for example, a pixel signal (a signal corresponding to the amount of charge generated as a result of photoelectric conversion in the photodiode) output from each of the pixel sharing units 539 included in the pixel array part 540 to the column signal processing unit 550 provided on the third substrate 300. The pixel signal is sent from the second substrate 200 to the third substrate 300.

Fig. 3 is an example of a cross-sectional view of the imaging device 1 as described above. The first substrate 100, the second substrate 200, and the third substrate 300 are electrically connected via the wiring layers 100T, 200T, and 300T. For example, the imaging device 1 includes an electrical connection portion that electrically connects the second substrate 200 and the third substrate 300. Specifically, the contact portions 201, 202, 301, and 302 are formed using electrodes made of a conductive material. The conductive material is composed of a metallic material such as copper (Cu), aluminum (Al), and gold (Au). The contact regions 201R, 202R, 301R, and 302R electrically connect the second substrate and the third substrate, for example, by directly connecting wirings formed as electrodes, thereby enabling signal input and/or output between the second substrate 200 and the third substrate 300.

The electrical connection portion that electrically connects the second substrate 200 and the third substrate 300 can be provided at a desired location. For example, as described in connection with the contact regions 201R, 202R, 301R, and 302R in Fig. 3, the electrical connection may be provided in a region overlapping the pixel array part 540 in the stacking direction. The electrical connection portion may also be provided in a region that does not overlap the pixel array part 540 in the stacking direction. Specifically, the electrical connection portion may be provided in a peripheral portion provided outside of the pixel array part 540 and in a region overlapping the pixel array part 540 in the stacking direction.

The first substrate 100 and the second substrate 200 are provided with, for example, connection hole portions H1 and H2. The connection hole portions H1 and H2 penetrate the first substrate 100 and the second substrate 200 (Fig. 3). The connection hole portions H1 and H2 are provided outside the pixel array part 540 (or a portion overlapping the pixel array part 540) (Fig. 2). For example, the connection hole portion H1 is placed outside the pixel array part 540 in the H direction, and the connection hole portion H2 is placed outside the pixel array part 540 in the V direction. For example, the connection hole portion H1 has reached the input unit 510A provided in the third substrate 300, and the connection hole portion H2 has reached the output unit 510B provided in the third substrate 300.

The connection hole portions H1 and H2 may be hollow or may at least partially include a conductive material. For example, there may be a configuration that includes electrodes formed as the input unit 510A and/or the output unit 510B and bonding wires connected to the electrodes. Alternatively, there is provided a configuration in which electrodes formed as the input unit 510A and/or the output unit 510B are connected to conductive materials provided in the connection hole portions H1 and H2. The conductive material provided in the connection hole portions H1 and H2 may be embedded in a part or the whole of the connection hole portions H1 and H2, or the conductive material may be formed on the side walls of the connection hole portions H1 and H2.

Fig. 3 shows the structure in which the third substrate 300 is provided with the input unit 510A and the output unit 510B. The structure is not limited thereto. For example, the input unit 510A and/or the output unit 510B can be provided in the second substrate 200 by sending the signals of the third substrate 300 to the second substrate 200 through the wiring layers 200T and 300T. Similarly, the input unit 510A and/or the output unit 510B can be provided in the first substrate 100 by sending the signals of the second substrate 200 to the first substrate 100 through the wiring layers 100T and 200T.

Fig. 4 is an equivalent circuit diagram showing an example of the configuration of the pixel sharing unit 539. The pixel sharing unit 539 includes the plurality of pixels 541 (in Fig. 4, the four pixels: pixels 541A, 541B, 541C, and 541D), the one pixel circuit 210 connected to the plurality of pixels 541, and the vertical signal line 543 connected to the pixel circuit 210. The pixel circuit 210 includes, for example, four transistors, specifically, an amplification transistor AMP, a selection transistor SEL, a reset transistor RST, and an FD conversion gain switching transistor FDG. As described above, the pixel sharing unit 539 operates the one pixel circuit 210 in a time-sharing manner, so that the pixel signals of the four pixels 541 (pixels 541A, 541B, 541C, and 541D) included in the pixel sharing unit 539 are sequentially output to the vertical signal line 543. In an aspect, the one pixel circuit 210 is connected to the plurality of pixels 541, and the pixel signals of the plurality of pixels 541 are output by the one pixel circuit 210 in a time-sharing manner. The aspect means that "the plurality of pixels 541 share the one pixel circuit 210".

The pixels 541A, 541B, 541C, and 541D have common constituent elements. Hereinafter, in order to distinguish the constituent elements of the pixels 541A, 541B, 541C, and 541D from one another, identification number 1 is assigned as a suffix to the reference character of the constituent element of the pixel 541A, identification number 2 is assigned as a suffix to the reference character of the constituent element of the pixel 541B, identification number 3 is assigned as a suffix to the reference character of the constituent element of the pixel 541C, and identification number 4 is assigned as a suffix to the reference character of the constituent element of the pixel 541D. If it is not necessary to distinguish the constituent elements of the pixels 541A, 541B, 541C, and 541D from one another, the identification numbers as suffixes to the reference characters of the constituent elements of the pixels 541A, 541B, 541C, and 541D are omitted.

The pixels 541A, 541B, 541C, and 541D each include, for example, the photodiode PD, the transfer transistor TR electrically connected to the photodiode PD, and a floating diffusion FD electrically connected to the transfer transistor TR. The photodiode PD (PD1, PD2, PD3, and PD4) has the cathode electrically connected to the source of the transfer transistor TR and the anode electrically connected to a reference potential line (e.g., ground). The photodiode PD photoelectrically converts incident light and generates a charge corresponding to the amount of received light. The transfer transistor TR (transfer transistors TR1, TR2, TR3, and TR4) is, for example, an N-type CMOS (Complementary Metal-Oxide-Semiconductor) transistor. The transfer transistor TR has the drain electrically connected to the floating diffusion FD and the gate electrically connected to the drive signal line. The drive signal line is a part of the plurality of row drive signal lines 542 (see Fig. 1) connected to the one pixel sharing unit 539. The transfer transistor TR transfers the charge generated in the photodiode PD to the floating diffusion FD. The floating diffusion FD (floating diffusions FD1, FD2, FD3, and FD4) is an N-type diffusion layer region formed in a P-type semiconductor layer. The floating diffusion FD is charge holding means that temporarily holds the charge transferred from the photodiode PD and is also charge-voltage conversion means that generates a voltage corresponding to the amount of charge.

The four floating diffusions FD (floating diffusions FD1, FD2, FD3, and FD4) included in the one pixel sharing unit 539 are electrically connected to one another, and are electrically connected to the gate of the amplification transistor AMP and the source of the FD conversion gain switching transistor FDG. The drain of the FD conversion gain switching transistor FDG is connected to the source of the reset transistor RST, and the gate of the FD conversion gain switching transistor FDG is connected to the drive signal line. The drive signal line is a part of the plurality of row drive signal lines 542 connected to the one pixel sharing unit 539. The drain of the reset transistor RST is connected to a power supply line VDD, and the gate of the reset transistor RST is connected to the drive signal line. The drive signal line is a part of the plurality of row drive signal lines 542 connected to the one pixel sharing unit 539. The gate of the amplification transistor AMP is connected to the floating diffusion FD, the drain of the amplification transistor AMP is connected to the power supply line VDD, and the source of the amplification transistor AMP is connected to the drain of the selection transistor SEL. The source of the selection transistor SEL is connected to the vertical signal line 543, and the gate of the selection transistor SEL is connected to the drive signal line. The drive signal line is a part of the plurality of row drive signal lines 542 connected to the one pixel sharing unit 539.

When the transfer transistor TR is turned on, the transfer transistor TR transfers the charge of the photodiode PD to the floating diffusion FD. The gate (transfer gate TG) of the transfer transistor TR includes, for example, a so-called vertical electrode and extends from the surface of the semiconductor layer (the semiconductor layer 100S in Fig. 6, which will be described later) to the depth of the PD as shown in Fig. 6, which will be described later. The reset transistor RST resets the potential of the floating diffusion FD to a predetermined potential. When the reset transistor RST is turned on, the potential of the floating diffusion FD is reset to the potential of the power supply line VDD. The selection transistor SEL controls the output timing of the pixel signal from the pixel circuit 210. The amplification transistor AMP generates, as a pixel signal, a signal having a voltage corresponding to the level of the charge held in the floating diffusion FD. The amplification transistor AMP is connected to the vertical signal line 543 via the selection transistor SEL. The amplification transistor AMP forms a source follower together with a load circuit unit (see Fig. 1) connected to the vertical signal line 543 in the column signal processing unit 550. When the selection transistor SEL is turned on, the amplification transistor AMP outputs the voltage of the floating diffusion FD to the column signal processing unit 550 through the vertical signal line 543. The reset transistor RST, the amplification transistor AMP, and the selection transistor SEL are, for example, N-type CMOS transistors.

The FD conversion gain switching transistor FDG is used to change the charge-voltage conversion gain in the floating diffusion FD. In general, pixel signals are low during shooting in a dark place. For charge-voltage conversion performed on the basis of Q = CV, when the capacitance of the floating diffusion FD (FD capacitance C) is large, V is low at the time of voltage conversion in the amplification transistor AMP. On the other hand, pixel signals are high in a bright place, and thus the floating diffusion FD cannot receive the charge of the photodiode PD unless the FD capacitance C is large. Furthermore, the FD capacitance C needs to be increased such that V is not too large (in other words, V is reduced) at the time of voltage conversion in the amplification transistor AMP. Under these circumstances, when the FD conversion gain switching transistor FDG is turned on, the gate capacitance of the FD conversion gain switching transistor FDG is added and thus the overall FD capacitance C increases. On the other hand, when the FD conversion gain switching transistor FDG is turned off, the overall FD capacitance C decreases. In this way, the FD conversion gain switching transistor FDG is turned on and off, so that the FD capacitance C can be made variable to change the conversion efficiency. The FD conversion gain switching transistor FDG is, for example, an N-type CMOS transistor.

Alternatively, the FD conversion gain switching transistor FDG may not be provided. In this case, for example, the pixel circuit 210 is configured with three transistors: the amplification transistor AMP, the selection transistor SEL, and the reset transistor RST. The pixel circuit 210 includes, for example, at least one of pixel transistors such as the amplification transistor AMP, the selection transistor SEL, the reset transistor RST, and the FD conversion gain switching transistor FDG.

The selection transistor SEL may be provided between the power supply line VDD and the amplification transistor AMP. In this case, the drain of the reset transistor RST is electrically connected to the power supply line VDD and the drain of the selection transistor SEL. The source of the selection transistor SEL is electrically connected to the drain of the amplification transistor AMP, and the gate of the selection transistor SEL is electrically connected to the row drive signal line 542 (see Fig. 1). The source of the amplification transistor AMP (the output end of the pixel circuit 210) is electrically connected to the vertical signal line 543, and the gate of the amplification transistor AMP is electrically connected to the source of the reset transistor RST. Although not illustrated, the number of pixels 541 that share the one pixel circuit 210 may not be four. For example, the two or eight pixels 541 may share the one pixel circuit 210.

Fig. 5 shows an example of a connection mode between the plurality of pixel sharing units 539 and the vertical signal lines 543. For example, the four pixel sharing units 539 arranged in the column direction are divided into four groups, each of which is connected to the vertical signal line 543. For simplicity of description, Fig. 5 shows an example in which the four groups each have the one pixel sharing unit 539. Each of the four groups may include the plurality of pixel sharing units 539. Thus, in the imaging device 1, the plurality of pixel sharing units 539 arranged in the column direction may be divided into groups including the one or more pixel sharing units 539. For example, the vertical signal line 543 and the column signal processing circuit 550 are connected to each of the groups, so that pixel signals can be reads simultaneously from the groups. Alternatively, in the imaging device 1, the one vertical signal line 543 may be connected to the plurality of pixel sharing units 539 arranged in the column direction. At this time, the pixel signals are sequentially read in a time-sharing manner from the plurality of pixel sharing units 539 connected to the one vertical signal line 543.

### [Specific configuration of imaging device 1]

Fig. 6 shows an example of a cross-sectional configuration perpendicular to the main surfaces of the first substrate 100, the second substrate 200, and the third substrate 300 of the imaging device 1. Fig. 6 schematically shows the positional relationship of the constituent elements for the sake of simplicity and may be different from the actual cross section. In the imaging device 1, the first substrate 100, the second substrate 200, and the third substrate 300 are stacked in this order. The imaging device 1 further includes a light receiving lens 401 on the back side (light incident side) of the first substrate 100. A color filter layer (not shown) may be provided between the light receiving lens 401 and the first substrate 100. The light receiving lens 401 is provided for, for example, each of the pixels 541A, 541B, 541C, and 541D. The imaging device 1 is, for example, a back-illuminated imaging device. The imaging device 1 includes the pixel array part 540 located at the central part and a peripheral part 540B located outside the pixel array part 540.

The first substrate 100 includes an insulating film 111, a fixed charge film 112, the semiconductor layer 100S, and the wiring layer 100T in this order from the light receiving lens 401. The semiconductor layer 100S is composed of, for example, a silicon substrate. The semiconductor layer 100S includes, for example, a P-well layer 115 in a part of and near the surface (a surface near the wiring layer 100T) of the semiconductor layer 100S, and includes an N-type semiconductor region 114 in the other region (a region deeper than the P-well layer 115). For example, the N-type semiconductor region 114 and the P-well layer 115 constitute the pn junction photodiode PD. The P-well layer 115 is a P-type semiconductor region.

Fig. 7A illustrates an example of the planar configuration of the first substrate 100. Fig. 7A mainly illustrates the planar configuration of a pixel separating portion 117, the photodiode PD, the floating diffusion FD, a VSS contact region 118, and the transfer transistor TR of the first substrate 100. The configuration of the first substrate 100 will be described below with reference to Fig. 7A along with Fig. 6.

The floating diffusion FD and the VSS contact region 118 are provided near the surface of the semiconductor layer 100S. The floating diffusion FD is an N-type semiconductor region provided in the P-well layer 115. The floating diffusions FD (floating diffusions FD1, FD2, FD3, and FD4) of the pixels 541A, 541B, 541C, and 541D are located close to one another at the central portion of the pixel sharing unit 539 (Fig. 7A). The detail will be described later, the four floating diffusions (floating diffusions FD1, FD2, FD3, and FD4) included in the sharing unit 539 are electrically connected to one another via electrical connecting means (pad portion 120 described later) in the first substrate 100 (more specifically, in the wiring layer 100T). Furthermore, the floating diffusion FD is connected from the first substrate 100 to the second substrate 200 (more specifically, from the wiring layer 100T to the wiring layer 200T) via electrical means (through electrode 120E described later). In the second substrate 200 (more specifically, in the wiring layer 200T), the floating diffusion FD is electrically connected to the gate of the amplification transistor AMP and the source of the FD conversion gain switching transistor FDG via the electrical means.

The VSS contact region 118 is a region electrically connected to the reference potential line VSS and is separated from the floating diffusion FD. For example, in the pixels 541A, 541B, 541C, and 541D, the floating diffusion FD is disposed on one end of each pixel in the V direction, and the VSS contact region 118 is disposed on the other end (Fig. 7A). The VSS contact region 118 is composed of, for example, a P-type semiconductor region. The VSS contact region 118 is connected to, for example, a ground potential or a fixed potential. This supplies the reference potential to the semiconductor layer 100S.

The first substrate 100 is provided with the transfer transistor TR along with the photodiode PD, the floating diffusion FD, and the VSS contact region 118. The photodiode PD, the floating diffusion FD, the VSS contact region 118, and the transfer transistor TR are provided in each of the pixels 541A, 541B, 541C, and 541D. The transfer transistor TR is provided on the front side (opposite to the light incident side or near the second substrate 200) of the semiconductor layer 100S. The transfer transistor TR has a transfer gate TG. The transfer gate TG includes, for example, a horizontal portion TGB opposed to the surface of the semiconductor layer 100S and a vertical portion TGA provided in the semiconductor layer 100S. The vertical portion TGA extends in the thickness direction of the semiconductor layer 100S. One end of the vertical portion TGA is in contact with the horizontal portion TGB, and the other end is provided in the N-type semiconductor region 114. The transfer transistor TR is composed of such a vertical transistor, so that transfer failures of pixel signals are less likely to occur and thus the reading efficiency of pixel signals can be improved.

The horizontal portion TGB of the transfer gate TG extends toward the central portion of the pixel sharing unit 539, for example, in the H direction from a position facing the vertical portion TGA (Fig. 7A). Thus, the position of a through electrode (a through electrode TGV described later) at the transfer gate TG in H direction can be brought close to the positions of through electrodes (through electrodes 120E and 121E described later) in H direction, the through electrodes being connected to the floating diffusion FD and the VSS contact region 118. For example, the plurality of pixel sharing units 539 provided on the first substrate 100 have the same configuration (Fig. 7A).

The semiconductor layer 100S is provided with the pixel separating portion 117 that separates the pixels 541A, 541B, 541C, and 541D. The pixel separating portion 117 is formed to extend in the direction of the normal to the semiconductor layer 100S (perpendicular to the surface of the semiconductor layer 100S). The pixel separating portion 117 is provided so as to partition the pixels 541A, 541B, 541C, and 541D and has, for example, a grid-like planar shape (Figs. 7A and 7B). For example, the pixel separating portion 117 electrically and optically separates the pixels 541A, 541B, 541C, and 541D. The pixel separating portion 117 includes, for example, a light shielding film 117A and an insulating film 117B. For the light shielding film 117A, for example, tungsten (W) is used. The insulating film 117B is provided between the light shielding film 117A and the P-well layer 115 or the N-type semiconductor region 114. The insulating film 117B is composed of, for example, silicon oxide (SiO). The pixel separating portion 117 has, for example, a full trench isolation (FTI) structure that penetrates the semiconductor layer 100S. Although not illustrated, the pixel separating portion 117 is not limited to an FTI structure that penetrates the semiconductor layer 100S. For example, a deep trench isolation (DTI) structure, which does not penetrate the semiconductor layer 100S, may be used instead. The pixel separating portion 117 extends in the direction of the normal to the semiconductor layer 100S and is formed in a part of the region of the semiconductor layer 100S.

In the semiconductor layer 100S, for example, a first pinning region 113 and a second pinning region 116 are provided. The first pinning region 113 is provided near the back side of the semiconductor layer 100S, and is disposed between the N-type semiconductor region 114 and the fixed charge film 112. The second pinning region 116 is provided on a side of the pixel separating portion 117, specifically, between the pixel separating portion 117 and the P-well layer 115 or the N-type semiconductor region 114. The first pinning region 113 and the second pinning region 116 are composed of, for example, P-type semiconductor regions.

The fixed charge film 112 having a negative fixed charge is provided between the semiconductor layer 100S and the insulating film 111. An electric field induced by the fixed charge film 112 forms the first pinning region 113, which is a hole accumulation layer, at the interface on the light-receiving surface (back side) of the semiconductor layer 100S. This suppresses the occurrence of dark current caused by the interface level on the light-receiving surface of the semiconductor layer 100S. The fixed charge film 112 is composed of, for example, an insulating film having a negative fixed charge. Examples of the material of the insulating film having a negative fixed charge include hafnium oxide, zirconium oxide, aluminum oxide, titanium oxide, and tantalum oxide.

The light shielding film 117A is provided between the fixed charge film 112 and the insulating film 111. The light shielding film 117A may be provided continuously with the light shielding film 117A constituting the pixel separating portion 117. The light shielding film 117A between the fixed charge film 112 and the insulating film 111 is provided selectively at, for example, a position opposed to the pixel separating portion 117 in the semiconductor layer 100S. The insulating film 111 is provided to cover the light shielding film 117A. The insulating film 111 is made of, for example, silicon oxide.

The wiring layer 100T provided between the semiconductor layer 100S and the second substrate 200 includes an interlayer insulating film 119, the pad portions 120 and 121, a passivation film 122, an interlayer insulating film 123, and a junction film 124 in this order from the semiconductor layer 100S. The horizontal portion TGB of the transfer gate TG is provided in, for example, the wiring layer 100T. The interlayer insulating film 119 is provided over the surface of the semiconductor layer 100S and is in contact with the semiconductor layer 100S. The interlayer insulating film 119 is composed of, for example, a silicon oxide film. The configuration of the wiring layer 100T is not limited to the above-described configuration. Any configuration may be used as long as the configuration includes wiring and an insulating film.

Fig. 7B shows the configurations of the pad portions 120 and 121 along with the planar configuration shown in Fig. 7A. The pad portions 120 and 121 are provided in selective regions on the interlayer insulating film 119. The pad portion 120 is configured to connect the floating diffusions FD (floating diffusions FD1, FD2, FD3, and FD4) of the pixels 541A, 541B, 541C, and 541D. For example, for each of the pixel sharing units 539, the pad portion 120 is located at the central portion of the pixel sharing unit 539 in plan view (Fig. 7B). The pad portion 120 is provided so as to cross the pixel separating portion 117 and is disposed to overlap at least a part of the floating diffusions FD1, FD2, FD3, and FD4 (Figs. 6 and 7B). Specifically, the pad portion 120 is formed in a region that overlaps, in a direction perpendicular to the surface of the semiconductor layer 100S, at least a part of the plurality of the floating diffusions FD (floating diffusions FD1, FD2, FD3, and FD4) that share the pixel circuit 210 and at least a part of the pixel separating portion 117 formed between the plurality of photodiodes PD (photodiodes PD1, PD2, PD3, and PD4) that share the pixel circuit 210. The interlayer insulating film 119 is provided with connection vias 120C for electrically connecting the pad portions 120 and the floating diffusions FD1, FD2, FD3, and FD4. The connection via 120C is provided in each of the pixels 541A, 541B, 541C, and 541D. For example, the pad portion 120 is partially embedded in the connection vias 120C, which electrically connects the pad portion 120 to the floating diffusions FD1, FD2, FD3, and FD4.

The pad portion 121 is configured to connect the plurality of VSS contact regions 118. For example, the VSS contact regions 118 provided in the pixels 541C and 541D of one of the pixel sharing units 539 adjacent to each other in V direction and the VSS contact regions 118 provided in the pixels 541A and 541B of the other pixel sharing unit 539 are electrically connected via a pad portion 121. For example, the pad portion 121 is provided to cross the pixel separating portion 117 and is superimposed on at least a part of the four VSS contact regions 118. Specifically, the pad portion 121 is formed in a region that overlaps, in a direction perpendicular to the surface of the semiconductor layer 100S, at least a part of the plurality of VSS contact regions 118 and at least a part of the pixel separating portion 117 formed between the plurality of VSS contact regions 118. The interlayer insulating film 119 is provided with connection vias 121C for electrically connecting the pad portion 121 and the VSS contact regions 118. The connection via 121C is provided in each of the pixels 541A, 541B, 541C, and 541D. For example, the pad portion 121 is partially embedded in the connection vias 121C, which electrically connects the pad portion 121 and the VSS contact regions 118. For example, the pad portion 120 and the pad portion 121 in each of the pixel sharing units 539 arranged in V direction are located substantially at the same position in H direction (Fig. 7B).

The provision of the pad portions 120 can reduce the number of wires for connecting the floating diffusions FD to the pixel circuit 210 (e.g., the gate electrode of the amplification transistor AMP) over the chip. Similarly, the provision of the pad portions 121 can reduce the number of wires for supplying a potential to the VSS contact regions 118 over the chip. This can reduce the area of the overall chip, suppress electrical interference between wires in miniaturized pixels, and/or achieve cost reduction by reducing the number of components.

The pad portions 120 and 121 can be provided at desired positions in the first substrate 100 and the second substrate 200. Specifically, the pad portions 120 and 121 can be provided in either the wiring layer 100T or an insulating region 212 of the semiconductor layer 200S. In the case where the pad portions 120 and 121 are provided in the wiring layer 100T, the pad portions 120 and 121 may be brought into direct contact with the semiconductor layer 100S. Specifically, the pad portions 120 and 121 may be configured to be directly connected to at least a part of the floating diffusions FD and/or the VSS contact regions 118. Furthermore, the connection vias 120C and 121C may be configured to be provided from the floating diffusions FD, which are to be connected to the pad portions 120 and 121, and/or the VSS contact regions 118, and the pad portions 120 and 121 may be configured to be provided at desired positions in the wiring layer 100T and the insulating region 211 2 of the semiconductor layer 200S.

In particular, when the pad portions 120 and 121 are provided in the wiring layer 100T, the number of wires to be connected to the floating diffusions FD and/or the VSS contact regions 118 in the insulating region 212 of the semiconductor layer 200S can be reduced. This can reduce the area of the insulating region 212 for forming through wiring for connection from the floating diffusion FD to the pixel circuit 210 in the second substrate 200 that forms the pixel circuit 210. Therefore, the area of the second substrate 200 that forms the pixel circuit 210 can be increased. The area of the pixel circuit 210 is secured, so that the pixel transistor can be formed in a large size, which can contribute to improved image quality by noise reduction or the like.

In particular, when the FTI structure is used for the pixel separating portion 117, the floating diffusion FD and/or the VSS contact region 118 are preferably provided in each of the pixels 541, so that the wiring that connects the first substrate 100 and the second substrate 200 can be significantly reduced by using the configurations of the pad portions 120 and 121.

As shown Fig. 7B, for example, the pad portions 120 to which the plurality of floating diffusions FD are connected and the pad portions 121 to which the plurality of VSS contacts 118 are connected are alternately arranged linearly in V direction. Moreover, the pad portions 120 and 121 are each formed at a position surrounded by the plurality of photodiodes PD, the plurality of transfer gate TG, and the plurality of floating diffusions FD. Thus, in the first substrate 100 in which the plurality of elements are formed, elements other than the floating diffusions FD and the VSS contact regions 118 can be freely arranged, thereby improving the efficiency of layout on the overall chip. In addition, symmetry is obtained in the layout of elements formed in each of the pixel sharing units 539, thereby suppressing variations in the characteristics of the pixels 541.

For example, the pad portions 120 and 121 are made of polysilicon (POLY SI), more specifically, an impurity-doped polysilicon. The pad portions 120 and 121 are preferably made of a highly heat-resistant conductive material such as polysilicon, tungsten (W), titanium (Ti), and titanium nitride (TiN). This can form the pixel circuit 210 after bonding the semiconductor layer 200S of the second substrate 200 to the first substrate 100. The reason will be described below. Hereinafter, a method of forming the pixel circuit 210 after bonding the first substrate 100 and the semiconductor layer 200S of the second substrate 200 will be referred to as a first manufacturing method.

In this case, after the pixel circuit 210 is formed on the second substrate 200, the second substrate 200 may also be bonded to the first substrate 100 (hereinafter referred to as a second manufacturing method). In the second manufacturing method, electrodes for electrical connection are formed in advance on the surface of the first substrate 100 (the surface of the wiring layer 100T) and the surface of the second substrate 200 (the surface of the wiring layer 200T). When the first substrate 100 and the second substrate 200 are bonded together, at the same time, the electrodes formed for electrical connection on the surface of the first substrate 100 and the surface of the second substrate 200 come into contact with each other. Thus, electrical connection is formed between the wiring included in the first substrate 100 and the wiring included in the second substrate 200.

Accordingly, the imaging device 1 is configured using the second manufacturing method and thus can be manufactured using an appropriate process for, for example, each of the configurations of the first substrate 100 and the second substrate 200, so that the imaging device can be manufactured with high quality and high performance.

In the second manufacturing method, when the first substrate 100 and the second substrate 200 are bonded to each other, an alignment error may occur due to a manufacturing apparatus for bonding. Although the first substrate 100 and the second substrate 200 have a size of, for example, several tens cm in diameter, when the first substrate 100 and the second substrate 200 are bonded to each other, substrate expansion and contraction may occur in the microscopic regions of the portions of the first substrate 100 and the second substrate 200. The expansion and contraction of the substrates are caused by a slight deviation in the timing when the substrates come into contact with each other. Such expansion and contraction of the first and second substrates 100 and 200 may cause errors in the positions of electrodes formed for electrical connection on the surfaces of the first and second substrates 100 and 200. In the second manufacturing method, even if such an error occurs, the electrodes of the first substrate 100 and the second substrate 200 are preferably brought into contact with each other. Specifically, at least one of the electrodes or preferably both of the electrodes of the first substrate 100 and the second substrate 200 are increased in size in consideration of the above error. Therefore, when the second manufacturing method is used, for example, the size of the electrode formed on the surface of the first substrate 100 or the second substrate 200 (the size in the substrate plane direction) is larger than the size of an internal electrode extending in the thickness direction from the inside of the first substrate 100 or the second substrate 200 to the surface.

On the other hand, the first manufacturing method can be used by configuring the pad portions 120 and 121 with a heat-resistant conductive material. In the first manufacturing method, the first substrate 100 including the photodiode PD and the transfer transistor TR is formed, and then the first substrate 100 and the second substrate 200 (semiconductor layer 2000S) are bonded to each other. At this time, the second substrate 200 is in a state in which a pattern including the active elements and the wiring layers that constitute the pixel circuit 210 has not been formed. Since the second substrate 200 is in a state before the patterns are formed, even if an error occurs in the bonding position when the first substrate 100 and the second substrate 200 are bonded to each other, the bonding error does not cause an error in alignment between the pattern of the first substrate 100 and the pattern of the second substrate 200. This is because the pattern of the second substrate 200 is formed after the first substrate 100 and the second substrate 200 are bonded to each other. Note that, when the pattern is formed on the second substrate, for example, the pattern formed on the first substrate is subjected to alignment in an exposure apparatus for pattern formation. For the above reasons, an error in the bonding position between the first substrate 100 and the second substrate 200 is negligible when the imaging device 1 is manufactured in the first manufacturing method. For the same reason, an error caused by the expansion and contraction of the substrate in the second manufacturing method is also negligible when the imaging device 1 is manufactured in the first manufacturing method.

In the first manufacturing method, after the first substrate 100 and the second substrate 200 (semiconductor layer 200S) are bonded to each other in this manner, an active element is formed on the second substrate 200. Thereafter, the through electrodes 120E and 121E and the through electrode TGV (Fig. 6) are formed. In the formation of the through electrodes 120E, 121E, and TGV, for example, the pattern of the through electrodes is formed from above the second substrate 200 by reduced projection exposure using an exposure device. Since the reduced exposure projection is used, even if an error occurs in alignment between the second substrate 200 and the exposure device, the magnitude of the error in the second substrate 200 is only a fraction (the inverse of a reduced exposure projection magnification) of the error of the second manufacturing method. Thus, the imaging device 1 is configured using the first manufacturing method and thus facilitates the alignment of elements formed on the first substrate 100 and the second substrate 200, so that the imaging device can be manufactured with high quality and high performance.

The imaging device 1 manufactured by using the first manufacturing method has characteristics different from those of the imaging device manufactured by the second manufacturing method. Specifically, in the imaging device 1 manufactured by the first manufacturing method, for example, the through electrodes 120E, 121E, and TGV have a substantially equal thickness (size in the substrate plane direction) from the second substrate 200 to the first substrate 100. Alternatively, when the through electrodes 120E, 121E, and TGV have a tapered shape, the through electrodes 120E, 121E, and TGV have a tapered shape with a constant slope. The imaging device 1 including the through electrodes 120E, 121E, and TGV facilitates the formation of a finer pattern of the pixels 541.

In this case, when the imaging device 1 is manufactured by the first manufacturing method, the active elements are formed on the second substrate 200 after the first substrate 100 and the second substrate 200 (semiconductor layer 200S) are bonded to each other, the first substrate 100 is also affected by heat treatment necessary for forming the active elements. Thus, as described above, a highly heat-resistant conductive material is preferably used for the pad portions 120 and 121 provided on the first substrate 100. For example, for the pad portions 120 and 121, it is preferable to use a material having a higher melting point (that is, higher heat resistance) than at least a part of a wiring material included in the wiring layer 200T of the second substrate 200. For example, the pad portions 120 and 121 are made of a highly heat-resistant conductive material such as doped polysilicon, tungsten, titanium, or titanium nitride. Thus, the imaging device 1 can be manufactured using the first manufacturing method.

The passivation film 122 is provided over the surface of the semiconductor layer 100S to cover, for example, the pad portions 120 and 121 (Fig. 6). The passivation film 122 is composed of, for example, a silicon nitride (SIN) film. The interlayer insulating film 123 covers the pad portions 120 and 121 with the passivation film 122 interposed therebetween. For example, the interlayer insulating film 123 is provided over the surface of the semiconductor layer 100S. The interlayer insulating film 123 is composed of, for example, a silicon oxide (SIO) film. The junction film 124 is provided on the bonded surface between the first substrate 100 (specifically, the wiring layer 100T) and the second substrate 200.

In other words, the junction film 124 is in contact with the second substrate 200. The junction film 124 is provided over the main surface of the first substrate 100. The junction film 124 is composed of, for example, a silicon nitride film.

For example, the light receiving lens 401 is opposed to the semiconductor layer 100S with the fixed charge film 112 and the insulating film 111 interposed therebetween (Fig. 6). The light receiving lens 401 is provided at a position where the light receiving lens 401 is opposed to, for example, the photodiode PD of each of the pixels 541A, 541B, 541C, and 541D.

The second substrate 200 includes the semiconductor layer 200S and the wiring layer 200T in this order from the first substrate 100. The semiconductor layer 200S is composed of a silicon substrate. A well region 211 is provided in the semiconductor layer 200S in the thickness direction. The well region 211 is, for example, a P-type semiconductor region. The second substrate 200 includes the pixel circuit 210 disposed for each of the pixel sharing units 539. The pixel circuit 210 is provided on, for example, the front side (the wiring layer 200T) of the semiconductor layer 200S. In the imaging device 1, the second substrate 200 is bonded to the first substrate 100 such that the back side (near the semiconductor layer 200S) of the second substrate 200 faces the front side (near the wiring layer 100T) of the first substrate 100. In other words, the second substrate 200 is bonded face-to-back to the first substrate 100.

Figs. 8 to 12 schematically illustrate an example of the planar configuration of the second substrate 200. Fig. 8 shows the configuration of the pixel circuit 210 provided near the surface of the semiconductor layer 200S. Fig. 9 schematically shows the configuration of each portion of the wiring layer 200T (specifically, the first wiring layer W1 described later), the semiconductor layer 200S connected to the wiring layer 200T, and the first substrate 100. Figs. 10 to 12 illustrate an example of the planar configuration of the wiring layer 200T. The configuration of the second substrate 200 will be described below with reference to Figs. 8 to 12 along with Fig. 6. In Figs. 8 and 9, the outline of the photodiode PD (the boundary between the pixel separating portion 117 and the photodiode PD) is indicated by a broken line, and the boundary between the semiconductor layer 200S and an element separating region 213 or an insulating region 214 is indicated by a broken line at a portion that overlaps the gate electrode of each of the transistors constituting the pixel circuit 210. In a portion that overlaps the gate electrode of the amplification transistor AMP, the boundary between the semiconductor layer 200S and the element separating region 213 and the boundary between the element separating region 213 and the insulating region 213 are provided on one side in the channel width direction.

The second substrate 200 includes the insulating region 212 that divides the semiconductor layer 200S and the element separating region 213 that is provided in a part of the semiconductor layer 200S in the thickness direction (Fig. 6). For example, the insulating region 212 provided between the two pixel circuits 210 adjacent to each other in H direction includes the through electrodes 120E and 121E and the through electrodes TGV (through electrodes TGV1, TGV2, TGV3, TGV4) of the two pixel sharing units 539 connected to the two pixel circuits 210 (Fig. 9).

The insulating region 212 has a thickness approximately the same as that of the semiconductor layer 200S (Fig. 6). The semiconductor layer 200S is divided by the insulating region 212. The through electrodes 120E and 121E and the through electrode TGV are disposed in the insulating region 212. The insulating region 212 is composed of, for example, silicon oxide.

The through electrodes 120E and 121E are provided so as to penetrate the insulating region 212 in the thickness direction. The upper ends of the through electrodes 120E and 121E are connected to the wiring (first wiring W1, second wiring W2, third wiring W3, and fourth wiring W4 that will be described later) of the wiring layer 200T. The through electrodes 120E and 121E are provided so as to penetrate the insulating region 212, the junction film 124, the interlayer insulating film 123, and the passivation film 122, and the lower ends of the through electrodes 120E and 121E are connected to the pad portions 120 and 121 (Fig. 6). The through electrode 120E is configured to electrically connect the pad portion 120 and the pixel circuit 210. That is, the floating diffusion FD of the first substrate 100 is electrically connected to the pixel circuit 210 of the second substrate 200 via the through electrode 120E. The through electrode 121E is configured to electrically connect the pad portion 121 and the reference potential line VSS of the wiring layer 200T. That is, the VSS contact region 118 of the first substrate 100 is electrically connected to the reference potential line VSS of the second substrate 200 via the through electrode 121E.

The through electrode TGV is provided so as to penetrate the insulating region 212 in the thickness direction. The upper end of the through electrode TGV is connected to the wiring of the wiring 200T. The through electrode TGV is provided so as to penetrate the insulating region 212, the junction film 124, the interlayer insulating film 123, the passivation film 122, and the interlayer insulating film 119, and the lower end of the through electrode TGV is connected to the transfer gate TG (Fig. 6). The through electrode TGV is configured to electrically connect the transfer gate TG (transfer gates TG1, TG2, TG3, TG4) of each of the pixels 541A, 541B, 541C, and 541D and the wiring (some of the row drive signal lines 542, specifically, wirings TRG1, TRG2, TRG3, and TRG4 in Fig. 11) of the wiring layer 200T. In other words, the transfer gate TG of the first substrate 100 is electrically connected to wiring TRG of the second substrate 200 via the through electrode TGV, and a driving signal is transmitted to each of the transfer transistors TR (transfer transistors TR1, TR2, TR3, and TR4).

The insulating region 212 is a region where the through electrodes 120E and 121E and the through electrode TGV for electrically connecting the first substrate 100 and the second substrate 200 are insulated from the semiconductor layer 200S. For example, in the insulating region 212 provided between the two pixel circuits 210 (sharing unit 539) adjacent to each other in H direction, the through electrodes 120E and 121E and the through electrodes TGV (through electrodes TGV1, TGV2, TGV3, TGV4) are arranged, which are connected to the two pixel circuits 210. For example, the insulating region 212 is provided to extend in V direction (Figs. 8 and 9). In this configuration, by devising the arrangement of the horizontal portion TGB of the transfer gate TG, the position of the through electrode TGV in H direction is placed closer to the positions of the through electrodes 120E and 121E in H direction than the position of the vertical portion TGA (Figs. 7A and 9). For example, the through electrode TGV is located at substantially the same position as the through electrodes 120E and 121E in H direction. Thus, the through electrodes 120E and 121E and the through electrode TGV can be provided collectively in the insulating region 212 extending in V direction. As another example of arrangement, the horizontal portion TGB may be provided only in a region that overlaps the vertical portion TGA. In this case, the through electrode TGV is formed substantially just above the vertical portion TGA. For example, the through electrode TGV is disposed substantially at the center of each of the pixels 541 in H direction and V direction. At this time, the position of the through electrode TGV in H direction and the positions of the through electrodes 120E and 121E in H direction are largely deviated from each other. Around the through electrode TGV and the through electrodes 120E and 121E, for example, the insulating region 212 is provided to obtain electrical insulation from the adjacent semiconductor layer 200S. When the position of the through electrode TGV in H direction and the positions of the through electrodes 120E and 121E in H direction are largely separated from each other, the insulating region 212 needs to be independently provided around each of the through electrodes 120E, 121E, and TGV. Thus, the semiconductor layer 200S is finely divided. In comparison with this arrangement, the size of the semiconductor layer 200S in H direction can be increased by the layout in which the through electrodes 120E and 121E and the through electrode TGV are arranged collectively in the insulating region 212 extending in V direction. Thus, a semiconductor element formation region in the semiconductor layer 200S can have a large area. This can increase, for example, the size of the amplification transistor AMP to suppress noise.

As described with reference to Fig. 4, the pixel sharing unit 539 has a structure in which the floating diffusions FD provided for the respective pixels 541 are electrically connected to one another and the plurality of pixels 541 share the one pixel circuit 210. Furthermore, electrical connection between the floating diffusions FD is established by the pad portion 120 provided on the first substrate 100 (Fig. 6, Fig. 7B). The electrical connection portion (pad portion 120) provided on the first substrate 100 and the pixel circuit 210 provided on the second substrate 200 are electrically connected to each other via the one through electrode 120E. As another structural example, it may also be conceivable that an electrical connection portion between the floating diffusions FD is provided on the second substrate 200. In this case, the pixel sharing unit 539 includes four through electrodes that are connected to the floating diffusions FD1, FD2, FD3, and FD4, respectively. Accordingly, in the second substrate 200, the number of through electrodes penetrating the semiconductor layer 200S increases, and the insulating region 212 that insulates the periphery of the through electrodes extends. In comparison with this structure, the structure in which the pad portion 120 is provided on the first substrate 100 (Figs. 6 and 7B) can reduce the number of through electrodes and reduce the size of the insulating region 212. Thus, a semiconductor element formation region in the semiconductor layer 200S can have a large area. This can increase, for example, the size of the amplification transistor AMP to suppress noise.

The element separating region 213 is provided on the front side of the semiconductor layer 200S. The element separating region 213 has a shallow trench isolation (STI) structure. In the element separating region 213, the semiconductor layer 200S is engraved in the thickness direction (a direction perpendicular to the main surface of the second substrate 200), and an insulating film is embedded in the engraved portion. The insulating film is made of, for example, silicon oxide. The element separating region 213 separates the plurality of transistors constituting the pixel circuit 210 according to the layout of the pixel circuit 210. The semiconductor layer 200S (specifically, the well region 211) extends below the element separating region 213 (a deep portion of the semiconductor layer 200S).

Referring now to Figs. 7A, 7B and 8, the difference between the outer shape of the pixel sharing unit 539 on the first substrate 100 (the outer shape in the substrate plane direction) and the outer shape of the pixel sharing unit 539 on the second substrate 200 will be described below.

In the imaging device 1, the pixel sharing unit 539 is provided on both of the first substrate 100 and the second substrate 200. For example, the outer shape of the pixel sharing unit 539 provided on the first substrate 100 and the outer shape of the pixel sharing unit 539 provided on the second substrate 200 are different from each other.

In Figs. 7A and 7B, the outlines of the pixels 541A, 541B, 541C, and 541D are indicated by dashed lines, and the outline of the pixel sharing unit 539 is indicated by a bold line. For example, the pixel sharing unit 539 of the first substrate 100 includes the two pixels 541 (pixels 541A, 541B) adjacent to each other in H direction and the two pixels 541 (pixels 541C, 541D) adjacent to them in V direction. In other words, the pixel sharing unit 539 of the first substrate 100 includes the four adjacent pixels 541 in two rows by two columns and the pixel sharing unit 539 of the first substrate 100 has an outer shape substantially like a square. In the pixel array part 540, the pixel sharing units 539 are arranged adjacent to each other at a pitch of two pixels in H direction (a pitch corresponding to the two pixels 541) and a pitch of two pixels in V direction (a pitch corresponding to the two pixels 541).

In Figs. 8 and 9, the outlines of the pixels 541A, 541B, 541C, and 541D are indicated by dashed lines, the outer shape of the pixel sharing unit 539 is indicated by a bold line. For example, the outer shape of the pixel sharing unit 539 of the second substrate 200 is smaller than that of the pixel sharing unit 539 of the first substrate 100 in H direction and is larger than that of the pixel sharing unit 539 of the first substrate 100 in V direction. For example, the pixel sharing unit 539 of the second substrate 200 is formed in a size (region) corresponding to one pixel in H direction and in a size corresponding to four pixels in V direction. That is, the pixel sharing unit 539 of the second substrate 200 is formed to have a size corresponding to adjacent pixels arranged in one row by four columns, and the pixel sharing unit 539 of the second substrate 200 has a substantially rectangular outer shape.

For example, in each of the pixel circuits 210, the selection transistor SEL, the amplification transistor AMP, the reset transistor RST, and the FD conversion gain switching transistor FDG are arranged in this order in V direction (Fig. 8). The pixel circuits 210 have substantially rectangular outer shapes, so that four transistors (the selection transistor SEL, the amplification transistor AMP, the reset transistor RST, and the FD conversion gain switching transistor FDG) can be arranged in one direction (V direction in Fig. 8). Thus, the drain of the amplification transistor AMP and the drain of the reset transistor RST can be shared by one diffusion region (a diffusion region connected to the power supply line VDD). For example, the formation region of the pixel circuit 210 can be substantially shaped like a square shape (see Fig. 21 described later). In this case, the two transistors are arranged along one direction, and making it difficult to share the drain of the amplification transistor AMP and the drain of the reset transistor RST by one diffusion region. Therefore, the pixel circuit 210 is provided in a substantially rectangular formation region, so that the four transistors can be arranged close to one another and the formation region of the pixel circuit 210 can be reduced. That is, the pixels can be miniaturized. Furthermore, when the formation region of the pixel circuit 210 does not need to be reduced, the formation region of the amplification transistor AMP can be increased to suppress noise.

For example, near the surface of the semiconductor layer 200S, a VSS contact region 218 connected to the reference potential line VSS is provided in addition to the selection transistor SEL, the amplification transistor AMP, the reset transistor RST, and the FD conversion gain switching transistor FDG. The VSS contact region 218 is composed of, for example, a P-type semiconductor region. The VSS contact region 218 is electrically connected to the VSS contact region 118 of the first substrate 100 (semiconductor layer 100S) via the wiring of the wiring layer 200T and the through electrode 121E. The VSS contact region 218 is provided adjacent to the source of the FD conversion gain switching transistor FDG with, for example, the element separating region 213 interposed therebetween (Fig. 8).

Referring to Figs. 7B and 8, the positional relationship between the pixel sharing unit 539 provided on the first substrate 100 and the pixel sharing unit 539 provided on the second substrate 200 will be described below. For example, one of the two pixel sharing units 539 arranged in V direction of the first substrate 100 (for example, the upper side of Fig. 7B) is connected to one of the two pixel sharing units 539 arranged in H direction of the second substrate 200 (for example, the left side of Fig. 8). For example, the other (e.g., the lower side of Fig. 7B) of the two pixel sharing units 539 arranged in V direction of the first substrate 100 is connected to the other (e.g., the right side of Fig. 8) of the two pixel sharing units 539 arranged in H direction of the second substrate 200.

For example, in the two pixel sharing units 539 arranged in H direction of the second substrate 200, the internal layout (arrangement of transistors and the like) of one of the pixel sharing units 539 is substantially identical to a layout obtained by reversing the internal layout of the other pixel sharing unit 539 in V direction and H direction. The effects obtained by this layout will be described below.

In the two pixel sharing units 539 arranged in V direction of the first substrate 100, each of the pad portions 120 is disposed at the center of the outer shape of the pixel sharing unit 539, that is, at the center of the pixel sharing unit 539 in V direction and H direction (Fig. 7B). On the other hand, since the pixel sharing unit 539 of the second substrate 200 has a substantially rectangular outer shape that extends in V direction, for example, the amplification transistor AMP connected to the pad portion 120 is disposed at a position shifted upward from the center of the pixel sharing unit 539 in V direction. For example, when the internal layouts of the two pixel sharing units 539 arranged in H direction of the second substrate 200 are identical to each other, the distance between the amplification transistor AMP of one of the pixel sharing units 539 and the pad portion 120 (e.g., the pad portion 120 of the pixel sharing unit 539 on the upper side of Fig. 7) is relatively short. However, the distance between the amplification transistor AMP of the other pixel sharing unit 539 and the pad portion 120 (e.g., the pad portion 120 of the pixel sharing unit 539 on the lower side of Fig. 7) is long. Therefore, the area of wiring required for connecting the amplification transistor AMP and the pad portion 120 is increased, and the wiring layout of the pixel sharing unit 539 may be complicated. This may affect the miniaturization of the imaging device 1.

In contrast, the internal layouts of the two pixel sharing units 539 arranged in H direction of the second substrate 200 are reversed at least in V direction, thereby reducing the distances between the amplification transistors AMP and the pad portions 120 of both of the two pixel sharing units 539. Accordingly, the imaging device 1 can be more easily miniaturized in comparison with a configuration in which the internal layouts of the two pixel sharing units 539 arranged in H direction of the second substrate 200 are identical to each other. The planar layout of each of the plurality of the pixel sharing units 539 of the second substrate 200 is symmetrical in the range shown in Fig. 8, but the layout is asymmetrical when including the layout of the first wiring layer W1 shown in Fig. 9, which will be described later.

Furthermore, the internal layouts of the two pixel sharing units 539 arranged in H direction of the second substrate 200 are preferably reversed in H direction. The reason will be described below. As shown in Fig. 9, the two pixel sharing units 539 arranged in H direction of the second substrate 200 are connected respectively to the pad portions 120 and 121 of the first substrate 100. For example, the pad portions 120 and 121 are disposed at the H direction central portion (between the two pixel sharing units 539 arranged in H direction) of the two pixel sharing units 539 arranged in H direction of the second substrate 200. Accordingly, the internal layouts of the two pixel sharing units 539 arranged in H direction of the second substrate 200 are reversed in H direction, thereby reducing the distances between the plurality of pixel sharing units 539 of the second substrate 200 and the pad portions 120 and 121. That is, this facilitates the miniaturization of the imaging device 1.

Furthermore, the position of the outline of the pixel sharing unit 539 on the second substrate 200 may not be aligned with the position of the outline of any one of the pixel sharing units 539 on the first substrate 100. For example, in one of the two pixel sharing units 539 arranged in H direction of the second substrate 200 (e.g., the left side of Fig. 9), one of the outlines in V direction (e.g., the upper side of Fig. 9) is disposed outside one of the outlines in V direction of the corresponding pixel sharing unit 539 (e.g., the upper side of Fig. 7B) of the first substrate 100. Moreover, in the other of the two pixel sharing units 539 arranged in H direction of the second substrate 200 (e.g., the right side of Fig. 9), the other outline in V direction (e.g., the lower side of Fig. 9) is disposed outside the other outline in V direction of the corresponding pixel sharing unit 539 (e.g., the lower side of Fig. 7B) of the first substrate 100. Thus, by arranging the pixel sharing units 539 on the second substrate 200 and the pixel sharing units 539 on the first substrate 100, the distance between the amplification transistor AMP and the pad portion 120 can be reduced. This facilitates the miniaturization of the imaging device 1.

Furthermore, the positions of the outlines of the plurality of pixel sharing units 539 on the second substrate 200 may not be aligned with one another. For example, the two pixel sharing units 539 are arranged in H direction of the second substrate 200 such that the positions of the outlines in V direction are displaced from each other. This can reduce the distance between the amplification transistor AMP and the pad portion 120. This facilitates the miniaturization of the imaging device 1.

Referring to Figs. 7B and 9, the repeated arrangement of the pixel sharing units 539 in the pixel array part 540 will be described below. The pixel sharing unit 539 of the first substrate 100 has a size corresponding to the two pixels 541 in H direction and a size corresponding to the two pixels 541 in V direction (Fig. 7B). For example, in the pixel array part 540 of the first substrate 100, the pixel sharing units 539, each of which has a size corresponding to the four pixels 541, are repeatedly arranged adjacent to each other at a pitch of two pixels in H direction (a pitch corresponding to the two pixels 541) and a pitch of two pixels in V direction (a pitch corresponding to the two pixels 541). Alternatively, the pixel array part 540 of the first substrate 100 may include the pair of pixel sharing units 539 arranged adjacent to each other in V direction. In the pixel array part 540 of the first substrate 100, for example, pairs of pixel sharing units 539 are repeatedly arranged adjacent to each other at a pitch of two pixels in H direction (a pitch corresponding to the two pixels 541) and a pitch of four pixels in V direction (a pitch corresponding to the four pixels 541). The pixel sharing unit 539 of the second substrate 200 has a size corresponding to the one pixel 541 in H direction and a size corresponding to the four pixels 541 in V direction (Fig. 9). For example, the pixel array part 540 of the second substrate 200 is provided with a pair of pixel sharing units 539, including the two pixel sharing units 539, each having a size corresponding to the four pixels 541. The pixel sharing units 539 are arranged adjacent to each other in H direction and are displaced from each other in V direction. In the pixel array part 540 of the second substrate 200, for example, pairs of pixel sharing units 539 are repeatedly arranged adjacent to each other at a pitch of two pixels in H direction (a pitch corresponding to the two pixels 541) and a pitch of four pixels in V direction (a pitch corresponding to the four pixels 541) without any gaps. Such a repeated arrangement of the pixel sharing units 539 allows the pixel sharing units 539 to be arranged without any gaps. This facilitates the miniaturization of the imaging device 1.

For example, the amplification transistor AMP preferably has a FIN-type three-dimensional structure (Fig. 6). Thus, the effective gate width is increased, and noise can be suppressed. The selection transistor SEL, the reset transistor RST, and the FD conversion gain switching transistor FDG each have, for example, a planar structure. The amplification transistor AMP may have a planar structure. Alternatively, the selection transistor SEL, the reset transistor RST, or the FD conversion gain switching transistor FDG may have a three-dimensional structure.

The wiring layer 200T includes, for example, a passivation film 221, an interlayer insulating film 222, and a plurality of wirings (a first wiring layer W1, a second wiring layer W2, a third wiring layer W3, and a fourth wiring layer W4). The passivation film 221 is in contact with, for example, the surface of the semiconductor layer 200S and covers the entire surface of the semiconductor layer 200S. The passivation film 221 covers the gate electrodes of the selection transistor SEL, the amplification transistor AMP, the reset transistor RST, and the FD conversion gain switching transistor FDG. The interlayer insulating film 222 is provided between the passivation film 221 and the third substrate 300. The interlayer insulating film 222 separates a plurality of wirings (the first wiring layer W1, the second wiring layer W2, the third wiring layer W3, and the fourth wiring layer W4). The interlayer insulating film 222 is made of, for example, silicon oxide.

In the wiring layer 200T, for example, the first wiring layer W1, the second wiring layer W2, the third wiring layer W3, the fourth wiring layer W4, and the contact portions 201 and 202 are provided in this order from the semiconductor layer 200S and are insulated from one another by the interlayer insulating film 222. The interlayer insulating film 222 is provided with a plurality of connection portions connecting the first wiring layer W1, the second wiring layer W2, the third wiring layer W3, or the fourth wiring layer W4 and the lower layers thereof. The connection portions are portions formed by embedding a conductive material into connection holes provided on the interlayer insulating film 222. For example, the interlayer insulating film 222 is provided with a connection portion 218V that connects the first wiring layer W1 and the VSS contact region 218 of the semiconductor layer 200S. For example, the hole diameter of the connection portion that connects the elements of the second substrate 200 is different from the hole diameters of the through electrodes 120E and 121E and the through electrode TGV. Specifically, the hole diameter of the connection hole that connects the elements of the second substrate 200 is preferably smaller than the hole diameters of the through electrodes 120E and 121E and the through electrode TGV. The reason will be described below. The depth of the connection portion (such as the connection portion 218V) provided in the wiring layer 200T is smaller than the depths of the through electrodes 120E and 121E and the through electrode TGV. Therefore, the connection portion allows the connection hole to be filled with the conductive material more easily than the through electrodes 120E and 121E and the through electrode TGV. The hole diameter of the connection portion is smaller than the hole diameters of the through electrodes 120E and 121E and the through electrode TGV, facilitating the miniaturization of the imaging device 1.

For example, the through electrode 120E, the gate of the amplification transistor AMP, and the source of the FD conversion gain switching transistor FDG (specifically, a connection hole reaching the source of the FD conversion gain switching transistor FDG) are connected via the first wiring layer W1. The first wiring layer W1 connects, for example, the through electrode 121E and the connection portion 218V, thereby electrically connecting the VSS contact region 218 of the semiconductor layer 200S and the VSS contact region 118 of the semiconductor layer 100S.

Referring to Figs. 10 to 12, the planar configuration of the wiring layer 200T will be described below. Fig. 10 shows an example of the planar configuration of the first wiring layer W1 and the second wiring layer W2. Fig. 11 shows an example of the planar configuration of the second wiring layer W2 and the third wiring layer W3. Fig. 12 shows an example of the planar configuration of the third wiring layer W3 and the fourth wiring layer W4.

For example, the third wiring layer W3 includes wirings TRG1, TRG2, TRG3, TRG4, SELL, RSTL, and FDGL extending in H direction (row direction) (Fig. 11). These wirings correspond to the plurality of row drive signal lines 542 described with reference to Fig. 4. The wirings TRG1, TRG2, TRG3, and TRG4 are provided to send driving signals to the transfer gates TG1, TG2, TG3, and TG4. The wirings TRG1, TRG2, TRG3, and TRG4 are connected to the transfer gates TG1, TG2, TG3, and TG4 via the second wiring layer W2, the first wiring layer W1, and the through electrode 120E, respectively. The wiring SELL is provided to send the driving signal to the gate of the selection transistor SEL, the wiring RSTL is provided to send the driving signal to the gate of the reset transistor RST, and the wiring FDGL is provided to send the driving signal to the gate of the FD conversion gain switching transistor FDG. The wirings SELL, RSTL, and FDGL are connected to the gates of the selection transistor SEL, the reset transistor RST, and the FD conversion gain switching transistor FDG via the second wiring layer W2, the first wiring layer W1, and the connection portion, respectively.

For example, the fourth wiring layer W4 includes the power supply line VDD, the reference potential line VSS, and the vertical signal line 543 that extend in V direction (column direction) (Fig. 12). The power supply line VDD is connected to the drain of the amplification transistor AMP and the drain of the reset transistor RST via the third wiring layer W3, the second wiring layer W2, the first wiring layer W1, and the connection portion. The reference potential line VSS is connected to the VSS contact region 218 via the third wiring layer W3, the second wiring layer W2, the first wiring layer W1, and the connection portion 218V. Moreover, the reference potential line VSS is connected to the VSS contact region 118 of the first substrate 100 via the third wiring layer W3, the second wiring layer W2, the first wiring layer W1, the through electrode 121E, and the pad portion 121. The vertical signal line 543 is connected to the source (VOUT) of the selection transistor SEL via the third wiring layer W3, the second wiring layer W2, the first wiring layer W1, and the connection portion.

The contact portions 201 and 202 may be provided at positions overlapping the pixel array part 540 in plan view (e.g., Fig. 3) or may be provided in the peripheral part 540B outside the pixel array part 540 (e.g., Fig. 6). The contact portions 201 and 202 are provided on the surface (a surface near the wiring layer 200T) of the second substrate 200. For example, the contact portions 201 and 202 are made of metals such as Cu (copper) and Al (aluminum). The contact portions 201 and 202 are exposed on the surface (a surface near the third substrate 300) of the wiring layer 200T. The contact portions 201 and 202 are used for electrical connection between the second substrate 200 and the third substrate 300 and for bonding between the second substrate 200 and the third substrate 300.

Fig. 6 shows an example in which a peripheral circuit is provided in the peripheral part 540B of the second substrate 200. The peripheral circuit may include a part of the row drive unit 520 or a part of the column signal processing unit 550. Furthermore, as shown in Fig. 3, the peripheral circuit may not be disposed in the peripheral part 540B of the second substrate 200, and the connection hole portions H1 and H2 may be disposed in the vicinity of the pixel array part 540.

The third substrate 300 includes, for example, the wiring layer 300T and the semiconductor layer 300S in this order from the second substrate 200. For example, the surface of the semiconductor layer 300S is provided near the second substrate 200 side. The semiconductor layer 300S is composed of a silicon substrate. A circuit is provided on a part of the front side of the semiconductor layer 300S. Specifically, the part of the front side of the semiconductor layer 300S includes, for example, at least some of the input unit 510A, the row drive unit 520, the timing control unit 530, the column signal processing unit 550, the image signal processing unit 560, and the output unit 510B. The wiring layer 300T provided between the semiconductor layer 300S and the second substrate 200 includes, for example, an interlayer insulating film, a plurality of wiring layers separated by the interlayer insulating film, and contact portions 301 and 302. The contact portions 301 and 302 are exposed on the surface of the wiring layer 300T (the surface near the second substrate 200), the contact portion 301 is in contact with the contact portion 201 of the second substrate 200, and the contact portion 302 is in contact with the contact portion 202 of the second substrate 200. The contact portions 301 and 302 are electrically connected to circuits (e.g., at least one of the input unit 510A, the row drive unit 520, the timing control unit 530, the column signal processing unit 550, and the image signal processing unit 560 and the output unit 510B) formed on the semiconductor layer 300S. The contact portions 301 and 302 are made of, for example, metals such as Cu (copper) and aluminum (Al). For example, an external terminal TA is connected to the input unit 510A via the connection hole portion H1, and an external terminal TB is connected to the output unit 510B via the connection hole portion H2.

The characteristics of the imaging device 1 will be described below.

Generally, an imaging device is mainly composed of a photodiode and a pixel circuit. In this case, when the area of the photodiode is increased, a charge generated as a result of photoelectric conversion increases. This improves the signal-to-noise ratio (S/N ratio) of the pixel signal, allowing the imaging device to output improved image data (image information). On the other hand, when the size of the transistor included in the pixel circuit is increased (particularly, the size of the amplification transistor), noise generated in the pixel circuit is reduced. This improves the S/N ratio of the imaging signal, allowing the imaging device to output improved image data (image information).

However, in the imaging device in which the photodiode and the pixel circuit are provided on the same semiconductor substrate, it is conceivable that when the area of the photodiode is increased in a limited area of the semiconductor substrate, the transistor provided in the pixel circuit is downsized. Furthermore, it is conceivable that when the size of the transistor provided in the pixel circuit is increased, the area of the photodiode is reduced.

In order to solve these problems, for example, the imaging device 1 of the present embodiment uses a structure in which the plurality of pixels 541 share the one pixel circuit 210 and the shared pixel circuit 210 is superimposed on the photodiode PD. Thus, in the limited area of the semiconductor substrate, the area of the photodiode PD can be maximized and the size of the transistor provided in the pixel circuit 210 can be maximized. Thus, the S/N ratio of the pixel signal is improved, and the imaging device 1 can output improved image data (image information).

When a structure is implemented in which the plurality of pixels 541 share the one pixel circuit 210 and the pixel circuit 210 is superimposed on the photodiode PD, a plurality of wirings are extended to be connected to the one pixel circuit 210 from the floating diffusions FD of the plurality of pixels 541. To obtain a large area of the semiconductor substrate 200 that forms the pixel circuit 210, for example, a connection wiring can be formed to connect a plurality of extending wirings into a bundle. Also for a plurality of wirings extending from the VSS contact region 118, a connection wiring can be formed to connect the extending wirings into a bundle.

For example, if a connection wiring that connects a plurality of wirings extending from the floating diffusions FD of the plurality of pixels 541 is formed on the semiconductor substrate 200 in which the pixel circuit 210 is formed, the area for forming the transistor included in the pixel circuit 210 may be reduced. Likewise, if a connection wiring that connects, into a bundle, a plurality of wirings extending from the VSS contact regions 118 of the respective pixels 541 is formed on the semiconductor substrate 200 in which the pixel circuit 210 is formed, the area for forming the transistor included in the pixel circuit 210 may be reduced.

In order to solve these problems, for example, the imaging device 1 of the present embodiment has a structure in which the plurality of pixels 541 share the one pixel circuit 210 and the shared pixel circuit 210 is superimposed on the photodiode PD, and a structure can be provided such that the first substrate 100 includes a connection wiring that connects the floating diffusions FD of the respective pixels 541 into a bundle and a connection wiring that connects, into a bundle, the VSS contact regions 118 provided for the respective pixels 541.

In this case, when the above-mentioned second manufacturing method is used as a manufacturing method for providing, on the first substrate 100, a connection wiring that connects the floating diffusions FD of the respective pixels 541 into a bundle and a connection wiring that connects the VSS contact regions 118 of the respective pixels 541 into a bundle, for example, the imaging device can be manufactured using an appropriate process according to the configurations of the first substrate 100 and the second substrate 200, so that the imaging device can be manufactured with high quality and high performance. In addition, connection wirings for the first substrate 100 and the second substrate 200 can be formed by a simple process. Specifically, when the second manufacturing method is used, the electrode to be connected to the floating diffusion FD and the electrode to be connected to the VSS contact region 118 are provided on the surface of the first substrate 100 and the surface of the second substrate 200, the surfaces serving as the bonding interfaces between the first substrate 100 and the second substrate 200. Furthermore, it is preferable to upsize the electrodes formed on the surfaces of the two substrates such that the electrodes formed on the surfaces of the two substrates come into contact with each other even if a positional deviation occurs between the electrodes provided on the surfaces of the two substrates when the first substrate 100 and the second substrate 200 are bonded to each other. In this case, it is conceivable that the electrodes are difficult to locate in a limited area of each pixel included in the imaging device 1.

In order to solve the problem that a large electrode is required on the bonding interface between the first substrate 100 and the second substrate 200, for example, in the imaging device 1 of the present embodiment, the first manufacturing method can be used as a manufacturing method in which the plurality of pixels 541 share the one pixel circuit 210 and the shared pixel circuit 210 is superimposed on the photodiode PD. Thus, the elements formed on the first substrate 100 and the second substrate 200 can be easily aligned with each other, so that the imaging device can be manufactured with high quality and high performance. In addition, a unique structure produced by using the manufacturing method can be provided. That is, a structure is provided such that the semiconductor layer 100S and the wiring layer 100T of the first substrate 100 and the semiconductor layer 200S and the wiring layer 200T of the second substrate 200 are stacked in this order, that is, a structure is provided such that the first substrate 100 and the second substrate 200 are stacked in a face-to-back manner. In addition, the through electrodes 120E and 121E are provided so as to penetrate the semiconductor layer 200S and the wiring layer 100T of the first substrate 100 from the front side of the semiconductor layer 200S of the second substrate 200 and reach the surface of the semiconductor layer 100S of the first substrate 100.

In a structure in which the first substrate 100 includes a connection wiring that connects the floating diffusions FD of the respective pixels 541 into a bundle and a connection wiring that connects the VSS contact regions 118 of the respective pixels 541 into a bundle, the structure and the second substrate 200 are stacked using the first manufacturing method and the pixel circuit 210 is formed on the second substrate 200. Thus, heat treatment required for forming the active elements included in the pixel circuit 210 may affect the connection wirings formed on the first substrate 100.

In order to solve the problem that the connection wiring may be affected by the heat treatment when the active elements are formed, the imaging device 1 of the present embodiment is desirably configured such that a conductive material having high thermal resistance is used for the connection wiring that connects the floating diffusions FD of the respective pixels 541 into a bundle and the connection wiring that connects the VSS contact regions 118 of the respective pixels 541 into a bundle. Specifically, the material having high thermal resistance may be a material having a higher melting point than at least some of wiring materials included in the wiring layer 200T of the second substrate 200.

As described above, for example, the imaging device 1 of the present embodiment includes: (1) a structure in which the first substrate 100 and the second substrate 200 are stacked in a face-to-back manner (specifically, a structure in which the semiconductor layer 100S and the wiring layer 100T of the first substrate 100 and the semiconductor layer 200S and the wiring layer 200T of the second substrate 200 are stacked in this order); (2) a structure in which the through electrodes 120E and 121E are provided so as to penetrate the semiconductor layer 200S and the wiring layer 100T of the first substrate 100 from the front side of the semiconductor layer 200S of the second substrate 200 and reach the surface of the semiconductor layer 100S of the first substrate 100; and (3) a structure in which the connection wiring that connects the floating diffusions FD provided for the respective pixels 541 into a bundle and the connection wiring that connects the VSS contact regions 118 of the respective pixels 541 into a bundle are made of a conductive material having high thermal resistance. Thus, without providing a large electrode on the interface between the first substrate 100 and the second substrate 200, the first substrate 100 be provided with the connection wiring that connects the floating diffusions FD provided for the respective pixels 541 into a bundle and the connection wiring that connects the VSS contact regions 118 of the respective pixels 541 into a bundle.

### [Operations of imaging device 1]

Referring to Figs. 13 and 14, the operations of the imaging device 1 will be described below. Figs. 13 and 14 further indicate arrows representing the paths of signals in Fig. 3. Fig. 13 shows the paths of an input signal externally input to the imaging device 1, a power supply potential, and a reference potential as arrows. Fig. 14 shows the signal path of the pixel signal output from the imaging device 1 to the outside as arrows. For example, an input signal (e.g., a pixel clock and a synchronizing signal) input to the imaging device 1 via the input unit 510A is transmitted to the row drive unit 520 of the third substrate 300, and a row drive signal is generated by the row drive unit 520. The row drive signal is sent to the second substrate 200 via the contact portions 301 and 201. Furthermore, the row drive signal reaches each of the pixel sharing units 539 of the pixel array part 540 via the row drive signal line 542 in the wiring layer 200T. Among the row drive signals having reached the pixel sharing unit 539 of the second substrate 200, the drive signals other than that at the transfer gate TG are input to the pixel circuit 210 and drive the transistors included in the pixel circuit 210. The drive signal of the transfer gate TG is input to the transfer gates TG1, TG2, TG3, and TG4 of the first substrate 100 via the through electrode TGV and drives the pixels 541A, 541B, 541C, and 541D (Fig. 13). The power supply potential and the reference potential that are supplied from the outside of the imaging device 1 to the input unit 510A (input terminal 511) of the third substrate 300 are sent to the second substrate 200 via the contact portions 301 and 201 and are supplied to the pixel circuit 210 of each of the pixel sharing units 539 via the wiring in the wiring layer 200T. The reference potential is also supplied to the pixels 541A, 541B, 541C, and 541D of the first substrate 100 via the through electrode 121E. In addition, the pixel signals photoelectrically converted by the pixels 541A, 541B, 541C, and 541D of the first substrate 100 are sent to the pixel circuit 210 of the second substrate 200 for each of the pixel sharing units 539 via the through electrode 120E. A pixel signal based on the pixel signal is sent from the pixel circuit 210 to the third substrate 300 via the vertical signal line 543 and the contact portions 202 and 302. The pixel signal is processed by the column signal processing unit 550 and the image signal processing unit 560 of the third substrate 300, and then is output to the outside via the output unit 510B.

### [Effects]

In the present embodiment, the pixels 541A, 541B, 541C, and 541D (pixel sharing unit 539) and the pixel circuit 210 are provided on different substrates (first substrate 100 and second substrate 200). Thus, the areas of the pixels 541A, 541B, 541C, and 541D and the pixel circuit 210 can be enlarged as compared with the case where the pixels 541A, 541B, 541C, and 541D and the pixel circuit 210 are formed on the same substrate. As a result, the amount of pixel signals obtained by photoelectric conversion can be increased, and the transistor noise of the pixel circuit 210 can be reduced. This can improve the signal/noise ratio of the pixel signal, allowing the imaging device 1 to output better pixel data (image information). Furthermore, the imaging device 1 can be miniaturized (in other words, a pixel size reduction and the miniaturization of the imaging device 1). The imaging device 1 can increase the number of pixels per unit area by reducing the pixel size, and can output an image of high image quality.

Furthermore, in the imaging device 1, the first substrate 100 and the second substrate 200 are electrically connected to each other via the through electrodes 120E and 121E provided in the insulating region 212. For example, it is conceivable to adopt a method of connecting the first substrate 100 and the second substrate 200 by bonding the pad electrodes or a method of connecting the first substrate 100 and the second substrate 200 via a through wiring (e.g., Through Si Via(TSV)) penetrating the semiconductor layer. In comparison with these methods, by providing the through electrodes 120E and 121E in the insulating region 212, an area required for connecting the first substrate 100 and the second substrate 200 can be reduced. Thus, the pixel size can be reduced and the imaging device 1 can be further reduced in size. Moreover, refinement of the area per pixel can increase the resolution. Further miniaturization of the area per pixel allows for higher resolution. When the chip size does not need to be reduced, the formation regions of the pixels 541A, 541B, 541C, and 541D and the pixel circuit 210 can be enlarged. Hence, the amount of pixel signals obtained by photoelectric conversion can be increased, and the noise of the transistor included in the pixel circuit 210 can be reduced. This can improve the signal/noise ratio of the pixel signal and allows the imaging device 1 to output better pixel data (image information).

In the imaging device 1, the pixel circuit 210, the column signal processing unit 550, and the image signal processing unit 560 are provided on different substrates (second substrate 200 and third substrate 300). Thus, the area of the pixel circuit 210 and the areas of the column signal processing unit 550 and the image signal processing unit 560 can be enlarged as compared with the case where the pixel circuit 210, the column signal processing unit 550, and the image signal processing unit 560 are formed on the same substrate. Thus, noise generated in the column signal processing unit 550 can be reduced and a higher level image processing circuit can be mounted by the image signal processing unit 560. This can improve the signal/noise ratio of the pixel signal and allows the imaging device 1 to output better pixel data (image information).

Moreover, in the imaging device 1, the pixel array part 540 is provided on the first substrate 100 and the second substrate 200, and the column signal processing unit 550 and the image signal processing unit 560 are provided on the third substrate 300. Furthermore, the contact portions 201, 202, 301, and 302 that connect the second substrate 200 and the third substrate 300 are formed above the pixel array part 540. Therefore, the contact portions 201, 202, 301, and 302 can be freely laid out without being affected by interference in the layout from various wirings provided in the pixel array. This allows the contact portions 201, 202, 301, and 302 to be used for electrical connection between the second substrate 200 and the third substrate 300. By using the contact portions 201, 202, 301, and 302, for example, the column signal processing unit 550 and the image signal processing unit 560 have high degrees of freedom in layout. Thus, noise generated in the column signal processing unit 550 can be reduced and a higher level image processing circuit can be mounted by the image signal processing unit 560. This can improve the signal/noise ratio of the pixel signal and allows the imaging device 1 to output better pixel data (image information).

Additionally, in the imaging device 1, the pixel separating portion 117 penetrates the semiconductor layer 100S. Thus, even when a distance between the adjacent pixels (pixels 541A, 541B, 541C, and 541D) decreases due to an area reduction of each of the pixels, color mixture between the pixels 541A, 541B, 541C, and 541D can be suppressed. This can improve the signal/noise ratio of the pixel signal and allows the imaging device 1 to output better pixel data (image information).

Moreover, in the imaging device 1, the pixel circuit 210 is provided for each of the pixel sharing units 539. Thus, the formation regions of the transistors (amplification transistor AMP, reset transistor RST, selection transistor SEL, FD conversion gain switching transistor FDG) constituting the pixel circuit 210 can be larger than in the case where the pixel circuit 210 is provided for each of the pixels 541A, 541B, 541C, and 541D. For example, noise can be suppressed by increasing the formation region of the amplification transistor AMP. This can improve the signal/noise ratio of the pixel signal and allows the imaging device 1 to output better pixel data (image information).

Furthermore, in the imaging device 1, the pad portion 120 that electrically connects the floating diffusions FD (floating diffusions FD1, FD2, FD3, and FD4) of the four pixels (pixels 541A, 541B, 541C, and 541D) is provided on the first substrate 100. Thus, the number of through electrodes (through electrodes 120E) that connect the first substrate 100 and the second substrate 200 can be reduced as compared with the case where the pad portion 120 is provided on the second substrate 200. Accordingly, the size of the insulating region 212 can be reduced, and the formation region (semiconductor layer 200S) of the transistor constituting the pixel circuit 210 can be obtained in a sufficient size. This can reduce the noise of the transistor included in the pixel circuit 210, thereby improving the signal/noise ratio of the pixel signal and allowing the imaging device 1 to output better pixel data (image information).

Modification examples of the imaging device 1 according to the embodiment will be described below. In the following modification examples, the same configurations as those in the embodiment will be denoted with the same reference numerals.

### <2. Modification example 1>

Figs. 15 to 19 illustrate a modification example of the planar configuration of the imaging device 1 according to the embodiment. Fig. 15 schematically shows a planar configuration in the vicinity of the surface of the semiconductor layer 200S of the second substrate 200, and corresponds to Fig. 8 described in the foregoing embodiment. Fig. 16 schematically shows the structure of each portion of the first wiring layer W1, the semiconductor layer 200S connected to the first wiring layer W1, and the first substrate 100, and corresponds to Fig. 9 described in the foregoing embodiment. Fig. 17 shows an example of the planar configuration of the first wiring layer W1 and the second wiring layer W2, and corresponds to Fig. 10 described in the foregoing embodiment. Fig. 18 shows an example of the planar configuration of the second wiring layer W2 and the third wiring layer W3, and corresponds to Fig. 11 described in the foregoing embodiment. Fig. 19 shows an example of the planar configuration of the third wiring layer W3 and the fourth wiring layer W4, and corresponds to Fig. 12 described in the foregoing embodiment.

In the modification example, as shown in Fig. 16, the internal layout of one (for example, the right side of the drawing) of the two pixel sharing units 539 arranged in H direction on the second substrate 200 is configured by reversing the internal layout of the other pixel sharing unit 539 (for example, the left side of the drawing) only in H direction. Furthermore, the deviation in V direction between the outline of one of the pixel sharing units 539 and the outline of the other pixel sharing unit 539 is larger than the deviation described in the foregoing embodiment (Fig. 9). Thus, by increasing the deviation in V direction, the distance between the amplification transistor AMP of the other pixel sharing unit 539 and the pad portion 120 (the pad portion 120 of the other (the lower side of the drawing) of the two pixel sharing units 539 arranged in the V direction shown in Fig. 7) connected thereto can be reduced. With this layout, in modification example 1 of the imaging device 1 shown in Figs. 15 to 19, the area of the two pixel sharing units 539 arranged in H direction can be made equal to the area of the pixel sharing units 539 of the second substrate 200 described in the foregoing embodiment without reversing the planar layout in V direction. The planar layout of the pixel sharing units 539 of the first substrate 100 is the same as that described in the foregoing embodiment (Figs. 7A and 7B). Therefore, the imaging device 1 according to the modification example can obtain the same effect as the imaging device 1 described in the foregoing embodiment. The arrangement of the pixel sharing units 539 of the second substrate 200 is not limited to the arrangement described in the foregoing embodiment and the modification example.

### <3. Modification example 2>

Figs. 20 to 25 illustrate a modification example of the planar configuration of the imaging device 1 according to the embodiment. Fig. 20 schematically illustrates the planar configuration of the first substrate 100 and corresponds to Fig. 7A described in the foregoing embodiment. Fig. 21 schematically shows a planar configuration in the vicinity of the surface of the semiconductor layer 200S of the second substrate 200, and corresponds to Fig. 8 described in the foregoing embodiment. Fig. 22 schematically shows the configuration of each portion of the first wiring layer W1, the semiconductor layer 200S connected to the first wiring layer W1, and the first substrate 100, and corresponds to Fig. 9 described in the foregoing embodiment. Fig. 23 shows an example of the planar configuration of the first wiring layer W1 and the second wiring layer W2, and corresponds to Fig. 10 described in the foregoing embodiment. Fig. 24 shows an example of the planar configuration of the second wiring layer W2 and the third wiring layer W3, and corresponds to Fig. 11 described in the foregoing embodiment. Fig. 25 shows an example of the planar configuration of the third wiring layer W3 and the fourth wiring layer W4, and corresponds to Fig. 12 described in the foregoing embodiment.

In the modification example, the outer shape of each of the pixel circuits 210 is substantially a square planar shape (e.g., see Fig. 21). In this respect, the planar configuration of the imaging device 1 of the modification example is different from that of the imaging device 1 described in the foregoing embodiment.

For example, the pixel sharing unit 539 of the first substrate 100 is formed over the pixel regions of two rows by two columns and has a substantially square planar shape (Fig. 20) as in the foregoing embodiment. In each of the pixel sharing units 539, for example, the horizontal portion TGB of the transfer gates TG1 and TG3 of the pixels 541A and 541C of one pixel column extends in H direction from the position superimposed on the vertical portion TGA toward the central portion of the pixel sharing unit 539 (more specifically, in the direction toward the outer edges of the pixels 541A and 541C and the direction toward the central portion of the pixel sharing unit 539), the horizontal portion TGB of the transfer gates TG2 and TG4 of the pixel 541B and the pixel 541D of the other pixel column extends in H direction from the position superimposed on the vertical portion TGA toward the outer side of the pixel sharing unit 539 (more specifically, in the direction toward the outer edges of the pixels 541B and 541D and the direction toward the outside of the pixel sharing unit 539). The pad portion 120 connected to the floating diffusion FD is provided at the central portion of the pixel sharing unit 539 (the central portion of the pixel sharing unit 539 in H direction and V direction), and the pad portion 121 connected to the VSS contact region 118 is provided at the end of the pixel sharing unit 539 at least in H direction (in H direction and V direction in Fig. 20).

As another arrangement example, it may also be contemplated that the horizontal portion TGB of the transfer gates TG1, TG2, TG3, and TG4 is provided only in the region facing the vertical portion TGA. At this time, the semiconductor layer 200S is likely to be divided into fine portions as in the foregoing embodiment. Therefore, it is difficult to form a large transistor in the pixel circuit 210. In contrast, when the horizontal portion TGB of the transfer gates TG1, TG2, TG3, and TG4 is extended in H direction from the position superimposed on the vertical portion TGA as in the modification example, the width of the semiconductor layer 200S can be increased as in the foregoing embodiment. Specifically, the positions of the through electrodes TGV1 and TGV3 connected to the transfer gates TG1 and TG3 in H direction may be arranged close to the position of the through electrode 120E in H direction, and the positions of the through electrodes TGV2 and TGV4 connected to the transfer gates TG2 and TG4 in H direction may be arranged close to the position of the through electrode 121E in H direction (Fig. 22). Thus, the width (size in H direction) of the semiconductor layer 200S extending in V direction can be increased as in the foregoing embodiment. Therefore, the size of the transistor of the pixel circuit 210, in particular, the size of the amplification transistor AMP can be increased. This can improve the signal/noise ratio of the pixel signal and allows the imaging device 1 to output better pixel data (image information).

For example, the pixel sharing unit 539 of the second substrate 200 has substantially the same size as the pixel sharing unit 539 of the first substrate 100 in H direction and V direction, and is provided over a region corresponding to, for example, a pixel region of approximately two rows by two columns. For example, in each of the pixel circuits 210, the selection transistor SEL and the amplification transistor AMP are arranged in V direction on the one semiconductor layer 200S extending in V direction, and the FD conversion gain switching transistor FDG and the reset transistor RST are arranged in V direction on the one semiconductor layer 200S extending in V direction. The one semiconductor layer 200S provided with the selection transistor SEL and the amplification transistor AMP and the one semiconductor layer 200S provided with the FD conversion gain switching transistor FDG and the reset transistor RST are arranged in H direction with the insulating region 212 interposed therebetween. The insulating region 212 extends in V direction (Fig. 21).

Referring to Figs. 21 and 22, the outer shape of the pixel sharing unit 539 of the second substrate 200 will be described below. For example, the pixel sharing unit 539 of the first substrate 100 shown in Fig. 20 is connected to the amplification transistor AMP and the selection transistor SEL that are provided on one side (the left side of Fig. 22) of the pad portion 120 in H direction, and the FD conversion gain switching transistor FDG and the reset transistor RST that are provided on the other side (the right side of Fig. 22) of the pad portion 120 in H direction. The outer shape of the sharing unit 541 of the second substrate 200 including the amplification transistor AMP, the selection transistor SEL, the FD conversion gain switching transistor FDG, and the reset transistor RST is determined by the following four outer edges.

The first outer edge is the outer edge of one end (one end on the upper side of Fig. 22) of the semiconductor layer 200S in V direction, the semiconductor layer 200S including the selection transistor SEL and the amplification transistor AMP. The first outer edge is provided between the amplification transistor AMP included in the pixel sharing unit 539 and the selection transistor SEL included in the pixel sharing unit 539 adjacent to the pixel sharing units 539 in one side (upper side in Fig. 22) in V direction. More specifically, the first outer edge is provided at the central portion of the element separating region 213 in V direction between the amplification transistor AMP and the selection transistor SEL. The second outer edge is the outer edge of the other end (the lower end of Fig. 22) of the semiconductor layer 200S in V direction, the semiconductor layer 200S including the selection transistor SEL and the amplification transistor AMP. The second outer edge is provided between the selection transistor SEL included in the pixel sharing unit 539 and the amplification transistor AMP included in the pixel sharing unit 539 adjacent to the pixel sharing unit 539 in other side (lower side of Fig. 22) in V direction. More specifically, the second outer edge is provided at the central portion of the element separating region 213 in V direction between the selection transistor SEL and the amplification transistor AMP. The third outer edge is the outer edge of the other end (the lower end of Fig. 22) of the semiconductor layer 200S in V direction, the semiconductor layer 200S including the reset transistor RST and the FD conversion gain switching transistor FDG. The third outer edge is provided between the FD conversion gain switching transistor FDG included in the pixel sharing unit 539 and the reset transistor RST included in the pixel sharing unit 539 adjacent to the pixel sharing unit 539 in other side (the lower side of Fig. 22) in V direction. More specifically, the third outer edge is provided at the central portion of the element separating region 213 in V direction between the FD conversion gain switching transistor FDG and the reset transistor RST. The fourth outer edge is the outer edge of one end (one end of the upper side of Fig. 22) of the semiconductor layer 200S in V direction, the semiconductor layer 200S including the reset transistor RST and the FD conversion gain switching transistor FDG. The fourth outer edge is provided between the reset transistor RST included in the pixel sharing unit 539 and the FD conversion gain switching transistor FDG (not shown) included in the pixel sharing unit 539 adjacent to the pixel sharing units 539 in one side (upper side of Fig. 22) in V direction. More specifically, the fourth outer edge is provided at the central portion of the element separating region 213 (not shown) in V direction between the reset transistor RST and the FD conversion gain switching transistor FDG.

In the outer shape of the pixel sharing unit 539 of the second substrate 200 including the first, second, third, and fourth outer edges, the third and fourth outer edges are shifted to one side in V direction with respect to the first and second outer edges (in other words, offset to one side in V direction). By using such a layout, the arrangement closest to the pad portion 120 can be performed on the basis of the gate of the amplification transistor AMP and the source of the FD conversion gain switching transistor FDG. Accordingly, the areas of the wirings connecting these components can be reduced, facilitating the miniaturization of the imaging device 1. The VSS contact region 218 is provided between the semiconductor layer 200S including the selection transistor SEL and the amplification transistor AMP and the semiconductor layer 200S including the reset transistor RST and the FD conversion gain switching transistor FDG. For example, the plurality of pixel circuits 210 have the same arrangement.

The imaging device 1 having the second substrate 200 configured thus can also provide the same effects as those described in the foregoing embodiment. The arrangement of the pixel sharing units 539 of the second substrate 200 is not limited to the arrangement described in the foregoing embodiment and the modification example.

### <4. Modification example 3>

Figs. 26 to 31 illustrate a modification example of the planar configuration of the imaging device 1 according to the embodiment. Fig. 26 schematically illustrates the planar configuration of the first substrate 100 and corresponds to Fig. 7B described in the foregoing embodiment. Fig. 27 schematically shows a planar configuration in the vicinity of the surface of the semiconductor layer 200S of the second substrate 200, and corresponds to Fig. 8 described in the foregoing embodiment. Fig. 28 schematically shows the structure of each portion of the first wiring layer W1, the semiconductor layer 200S connected to the first wiring layer W1, and the first substrate 100, and corresponds to Fig. 9 described in the foregoing embodiment. Fig. 29 shows an example of the planar configuration of the first and second wiring layers W1 and W2, and corresponds to Fig. 10 described in the foregoing embodiment. Fig. 30 shows an example of the planar configuration of the second wiring layer W2 and the third wiring layer W3, and corresponds to Fig. 11 described in the foregoing embodiment. Fig. 31 shows an example of the planar configuration of the third wiring layer W3 and the fourth wiring layer W4, and corresponds to Fig. 12 described in the foregoing embodiment.

In the present modification example, the semiconductor layer 200S of the second substrate 200 extends in H direction (Fig. 28). That is, the modification example substantially corresponds to a configuration in which the planar configuration of the imaging device 1 shown in Fig. 21 or other drawings is rotated by 90 degrees.

For example, the pixel sharing unit 539 of the first substrate 100 is formed over the pixel regions of two rows by two columns and has a substantially square planar shape (Fig. 26) as in the foregoing embodiment. In each of the pixel sharing units 539, for example, the transfer gates TG1 and TG2 of the pixel 541A and the pixel 541B of one pixel row extend toward the central portion of the pixel sharing unit 539 in V direction, and the transfer gates TG3 and TG4 of the pixel 541C and the pixel 541D of the other pixel row extend to the outside of the pixel sharing unit 539 in V direction. The pad portion 120 connected to the floating diffusion FD is provided at the central portion of the pixel sharing unit 539, and the pad portion 121 connected to the VSS contact region 118 is provided on the end of the pixel sharing unit 539 at least in V direction (in V direction and H direction in Fig. 26). At this point, the positions of the through electrodes TGV1 and TGV2 of the transfer gates TG1 and TG2 in V direction are brought close to the position of the through electrode 120E in V direction, and the positions of the through electrodes TGV3 and TGV4 of the transfer gates TG3 and TG4 in V direction are brought close to the position of the through electrode 121E in V direction (Fig. 28). Thus, for the same reason as in the foregoing embodiment, the width of the semiconductor layer 200S extending in H direction (size in V direction) can be increased. Accordingly, the size of the amplification transistor AMP can be increased, and noise can be suppressed.

In each of the pixel circuits 210, the selection transistor SEL and the amplification transistor AMP are arranged in H direction, and the reset transistor RST is disposed at a position adjacent to the selection transistor SEL in V direction with the insulating region 212 interposed therebetween (Fig. 27). The FD conversion gain switching transistor FDG is arranged adjacent to the reset transistor RST in H direction. The VSS contact region 218 in an island shape is provided in the insulating region 212. For example, the third wiring layer W3 extends in H direction (Fig. 30), and the fourth wiring layer W4 extends in V direction (Fig. 31).

The imaging device 1 having the second substrate 200 configured thus can also provide the same effects as those described in the foregoing embodiment. The arrangement of the pixel sharing units 539 of the second substrate 200 is not limited to the arrangement described in the foregoing embodiment and the modification example. For example, the semiconductor layer 200S described in the above embodiment and modification 1 may extend in H direction.

### <5. Modification example 4>

Fig. 32 illustrates a modification example of the sectional configuration of the imaging device 1 according to the embodiment. Fig. 32 corresponds to Fig. 3 described in the above embodiment. In the modification example, the imaging device 1 includes contact portions 203, 204, 303, and 304 provided at positions facing the central portion of the pixel array part 540, in addition to the contact portions 201, 202, 301, and 302. In this respect, the imaging device 1 of the modification example is different from the imaging device 1 described in the foregoing embodiment.

The contact portions 203 and 204 are provided on the second substrate 200 and is exposed on the bonded surface with the third substrate 300. The contact portions 303 and 304 are provided on the third substrate 300 and are exposed on the bonded surface with the second substrate 200. The contact portion 203 is in contact with the contact portion 303, and the contact portion 204 is in contact with the contact portion 304. That is, in the imaging device 1, the second substrate 200 and the third substrate 300 are connected to each other via the contact portions 203, 204, 303, and 304 in addition to the contact portions 201, 202, 301, and 302.

Referring to Figs. 33 and 34, the operations of the imaging device 1 will be described below. Fig. 33 shows the paths of an input signal externally input to the imaging device 1, a power supply potential, and a reference potential as arrows. Fig. 34 shows the signal path of the pixel signal output from the imaging device 1 to the outside as arrows. For example, an input signal input to the imaging device 1 via the input unit 510A is transmitted to the row drive unit 520 of the third substrate 300, and a row drive signal is generated by the row drive unit 520. The row drive signal is sent to the second substrate 200 via the contact portions 303 and 203. Furthermore, the row drive signal reaches each of the pixel sharing units 539 of the pixel array part 540 via the row drive signal line 542 in the wiring layer 200T. Among the row drive signals having reached the pixel sharing unit 539 of the second substrate 200, the drive signals other than that at the transfer gate TG are input to the pixel circuit 210 and drive the transistors included in the pixel circuit 210. The drive signal of the transfer gate TG is input to the transfer gates TG1, TG2, TG3, and TG4 of the first substrate 100 via the through electrode TGV and drives the pixels 541A, 541B, 541C, and 541D. The power supply potential and the reference potential that are supplied from the outside of the imaging device 1 to the input unit 510A (input terminal 511) of the third substrate 300 are sent to the second substrate 200 via the contact portions 303 and 203 and are supplied to the pixel circuit 210 of each of the pixel sharing units 539 via the wiring in the wiring layer 200T. The reference potential is also supplied to the pixels 541A, 541B, 541C, and 541D of the first substrate 100 via the through electrode 121E. In addition, the pixel signals photoelectrically converted by the pixels 541A, 541B, 541C, and 541D of the first substrate 100 are sent to the pixel circuit 210 of the second substrate 200 for each of the pixel sharing units 539. A pixel signal based on the pixel signal is sent from the pixel circuit 210 to the third substrate 300 via the vertical signal line 543 and the contact portions 204 and 304. The pixel signal is processed by the column signal processing unit 550 and the image signal processing unit 560 of the third substrate 300, and then is output to the outside via the output unit 510B.

The imaging device 1 having the contact portions 203, 204, 303, and 304 configured thus can also provide the same effects as those described in the foregoing embodiment. The positions and numbers or the like of the contact portions can be changed in accordance with the design of the circuit or the like on the third substrate 300, which is the connection destination of the wiring via the contact portions 303 and 304.

### <6. Modification example 5>

Fig. 35 illustrates a modification example of the sectional configuration of the imaging device 1 according to the embodiment. Fig. 35 corresponds to Fig. 6 described in the above embodiment. In the modification example, the transfer transistor TR having a planar structure is provided on the first substrate 100. In this respect, the imaging device 1 of the modification example is different from the imaging device 1 described in the foregoing embodiment.

In the transfer transistor TR, the transfer gate TG is composed of the horizontal portion TGB alone. In other words, the transfer gate TG does not have the vertical portion TGA and is opposed to the semiconductor layer 100S.

The imaging device 1 with the transfer transistor TR having such a planar structure can also provide the same effects as in the foregoing embodiment. Furthermore, it may be conceivable to provide the planar transfer gate TG on the first substrate 100 to form the photodiode PD closer to the surface of the semiconductor layer 100S than in the case where the vertical transfer gate TG is provided on the first substrate 100, thereby increasing the amount of saturation signal (QS). In addition, the method of forming the planar transfer gate TG on the first substrate 100 may be considered to have a smaller number of manufacturing steps than the method of forming the vertical transfer gate TG on the first substrate 100, and less likely to cause adverse effects on the photodiode PD due to the manufacturing steps.

### <7. Modified example 6>

Fig. 36 shows a modification of the pixel circuit of the imaging device 1 according to the foregoing embodiment. Fig. 36 corresponds to Fig. 4 described in the foregoing embodiment. In the modification example, the pixel circuit 210 is provided for each pixel (pixel 541A). That is, the pixel circuit 210 is not shared by a plurality of pixels. In this respect, the imaging device 1 of the modification example is different from the imaging device 1 described in the foregoing embodiment.

The imaging device 1 of the modification example is identical to the imaging device 1 described in the foregoing embodiment in that the pixels 541A and the pixel circuit 210 are provided on different substrates (the first substrate 100 and the second substrate 200). Therefore, the imaging device 1 according to the modification example can obtain the same effect as in the foregoing embodiment.

### <8. Modified example 7>

Fig. 37 shows a modification example of the planar configuration of the pixel separating portion 117 described in the foregoing embodiment. A gap may be provided in the pixel separating portion 117 surrounding each of the pixels 541A, 541B, 541C, and 541D. That is, the entire circumference of the pixels 541A, 541B, 541C, and 541D may not be surrounded by the pixel separating portion 117. For example, the gap of the pixel separating portion 117 is provided near the pad portions 120 and 121 (see Fig. 7B).

Although the foregoing embodiment has described the example in which the pixel separating portion 117 has an FTI structure penetrating the semiconductor layer 100S (see Fig. 6), the pixel separating portion 117 may have a structure other than the FTI structure. For example, the pixel separating portion 117 may not be provided to fully penetrate the semiconductor layer 100S, and may have a so-called DTI (Deep Trench Isolation) structure.

### <9. Modified example 8>

As shown in the foregoing embodiment and the modification examples, in the present disclosure, the potential of the floating diffusion layer (floating diffusion FD) in the pixel 541 and the pixel circuit 210 is shared by metal (copper as a non-limiting example) connection between at least the first substrate 100 and the second substrate 200.

To the floating diffusion FD, a signal generated by the photodiode PD serving as a light receiving element is transferred by the transfer transistor TR. The modification example will describe a configuration in which a ground voltage that serves as a reference for this signal is defined for each of the substrates.

Fig. 38 illustrates a modification example of the pixel circuit of the imaging device 1 according to the embodiment. Fig. 38 corresponds to Fig. 4 described in the above embodiment. Fig. 38 shows an example in which one of the pixels 541 in Fig. 4 is provided with an amplification transistor, that is, an example in which the floating diffusion FD is provided for each pixel. The photodiode PD outputs a signal based on the intensity of received light.

The photodiode PD formed on the first substrate 100 has, for example, an anode potential set to a first ground potential GND1. Similarly, the transfer transistor TR formed on the first substrate 100 has a body potential set to the first ground potential GND1.

An element formed on the second substrate 200 has a ground potential set to a second ground potential GND2. For example, the body potential of the amplification transistor AMP formed on the second substrate 200 is the second ground potential GND2. The second ground potential GND2 is a potential different from the first ground potential GND1.

In this example, a signal based on the intensity of the light received by the photodiode PD disposed on the first substrate 100 is amplified by the amplification transistor AMP disposed on the second substrate 200 and is transmitted to the vertical signal line 543. The ground potential serving as a reference potential is set to a different potential.

As shown in Fig. 38, the first substrate 100 may include a capacitor C1 that forms a potential relative to the first ground potential GND1 on the floating diffusion FD.

Similarly, the second substrate 200 may include a capacitor C2 that forms a potential relative to the second ground potential GND2 on the floating diffusion FD.

In this way, the capacitance can be disposed to form a proper potential for the floating diffusion FD on each of the substrates.

If a proper potential can be obtained for the floating diffusion FD, the capacitors C1 and C2 may be omitted as shown in Figs. 4 and 36 and other drawings.

Fig. 39 shows that the same ground potential is set in Fig. 36. Also in such an arrangement of transistors, the ground potentials of the first substrate 100 and the second substrate 200 can be set to different potentials.

When the single floating diffusion FD is provided for the single pixel 541 as shown in Figs. 36 and 39, the imaging device 1 may be configured such that an analogue-to-digital conversion circuit (ADC) is disposed for each pixel. More specifically, an ADC can be provided for each photodiode PD.

Fig. 40 shows still another example of an equivalent circuit according to the modification example. In Fig. 40, as in the case of Fig. 4, the pixel share units 539 serve as units of repetition and are arranged repeatedly in an array of row and column directions. Also in such an arrangement of the pixels 541, the first ground potential GND1, which is the ground potential on the first substrate 100, and the second ground potential GND2, which is the ground potential on the second substrate 200, can be set to different values.

That is, in each of the pixels 541 disposed in the pixel sharing unit 539, the photodiode PD as a light receiving element and the transfer transistor TR may be controlled to the first ground potential GND1.

As a matter of course, the ground potentials of the first substrate 100 and the second substrate 200 can be set to different potentials in other arrangements of Fig. 5 and other drawings as well as the arrangement to Fig. 4.

The planar layout including transistors, gates, and contacts on the first substrate 100 and the second substrate 200 may be, as a non-limiting example, similar to those shown in Figs. 7A, 7B, and 8, or may be another arrangement shown in Fig. 9 and the subsequent drawings. In either case, the electrodes connected to the ground potential are connected to the first ground potential GND1 and the second ground potential GND2, respectively, on the first substrate 100 and the second substrate 200.

The sectional layout including the transistors, gates, and contacts on the first substrate 100 and the second substrate 200 may also be the same as or similar to the foregoing configurations in the range where the first ground potential GND1 and the second ground potential GND2 can be arranged as different potentials.

The relationship between the first ground potential GND1 and the second ground potential GND2 will be described below.

Fig. 41 is a potential diagram showing the potential of the wiring or the like and the potential of the gate of the transistor in the first substrate 100 and the second substrate 200. The upper part of the drawing shows the structure of the wiring or the like and the gates of the transistors.

The floating diffusion FD of the first substrate 100 and the second substrate 200 has the same potential as the gate of the amplification transistor AMP via the contact. The contacts that connect the floating diffusion FD may be, for example, metal. The metal may be copper as a non-limiting example.

In contrast, the lower portion of Fig. 41 shows the ranges of potentials at the gates and the wiring or the like. The potential diagram in the lower portion is a graph that indicates a larger negative value toward the upper side of the drawing and a larger positive value toward the lower side of the drawing.

As shown in the potential diagram, the second ground potential GND2 is, for example, a potential on the positive side of the first ground potential GND1. The first ground potential GND1 may be a negative bias potential. The second ground potential GND2 may be 0 [V].

The reset transistor RST resets the potential of the floating diffusion FD of the second substrate 200 connected to the floating diffusion FD of the first substrate 100, to the potential connected to the power supply line VDD by a voltage applied to the gate. The potential of the gate can be set in a potential range higher than the second ground potential GND2, as shown in the drawing.

The voltage applied to the gate of the transfer transistor TR is set relative to, for example, the first ground potential GND1, which is a negative bias. The transfer transistor TR is turned off in a state in which a voltage larger than the first ground potential GND1 on the negative side is applied to the gate, and a voltage exceeding a threshold voltage is applied at the timing of execution of transfer.

This operation allows the transfer transistor TR to transfer a signal on the cathode side of the photodiode PD, which is higher than the floating diffusion FD of the first substrate 100, to the reset floating diffusion FD.

The signal is transferred to the floating diffusion FD of the second substrate 200 via the contact and is applied to the gate of the amplification transistor AMP.

The amplification transistor AMP that forms the source-follower circuit outputs a voltage based on the height of the potential applied to the gate to the drain of the selection transistor SEL. In this case, the voltage applied to the gate of the selection transistor SEL can be a voltage set relative to the second ground potential GND2.

As a matter of course, as shown in Figs. 38 and 39, the body of the amplification transistor AMP can also be set to the second ground potential GND2.

By turning on the selection transistor SEL at an appropriate timing, a signal based on the intensity of light received by the pixel at an appropriate timing is transmitted to the vertical signal line 543 via the selection transistor SEL.

The ground potentials of the first substrate 100 including the photodiode PD and the second substrate 200 including the amplification transistor AMP are set to different potentials, so that the range of the voltage that determines the High/Low of the signal on the first substrate 100 and the range of the voltage that determines the High/Low of the signal on the second substrate 200 can be set to different potentials.

For example, as shown in Fig. 41, the range of the voltage applied to the gate of the transistor in the second substrate 200, in which the photodiode PD for receiving light is not provided, can be significantly narrower than the range of the voltage applied to the gate of the transistor in the first substrate 100 provided with the photodiode PD.

Hence, as a non-limiting example, a circuit design can be made in which a transistor operating at 5 [V] can be used on the first substrate 100 while a transistor operating at 3 [V] can be used on the second substrate 200.

For example, a difference in potential applied to the transistor formed on the second substrate 200 can be reduced while increasing the vertical width (potential difference) of the saturation signal of the photodiode PD by lowering the first ground potential GND1.

By setting the ground potential as described above, for example, the withstand voltage performance of the transistor provided on the second substrate 200 can be set lower than the withstand voltage performance of the transistor provided on the first substrate 100.

Thus, the thickness of the gate oxide film of the transistor provided on the second substrate 200 can be smaller than the thickness of the gate oxide film of the transistor provided on the first substrate 100. Similarly, the width of the wiring on the second substrate 200 and the distance between the wirings can be smaller (shorter) than the width of the wiring on the first substrate 100 and the distance between the wirings.

Furthermore, by changing the ground potential for each substrate, the saturation signal (electron) amount (QS) of the photodiode PD can be increased on the first substrate 100, and the second substrate 200 can obtain effects such as low power consumption and noise reduction.

As described above, since the thickness of the gate oxide film, the width of the wiring, and the distance between the wirings can be reduced on the second substrate 200, the layout efficiency of the second substrate 200 can also be improved regardless of the saturation signal amount of the photodiode PD.

### <10. Modified example 9>

The sectional configuration of the modification in which the ground potential is changed for each of the substrates will be described below with reference to several examples. Since the constituent elements in the cross section are similar to those in, for example, Fig. 6, a detailed description thereof is omitted.

Fig. 42 is a schematic diagram showing an example of the configuration and cross section of a semiconductor substrate that makes a formation from the light receiving element to the pixel circuit and the logic circuit of the imaging device 1.

The left drawing shows a configuration example of the semiconductor substrate. As a non-limiting configuration, the imaging device 1 may include the first substrate 100, the second substrate 200, and the third substrate 300.

The first substrate 100 includes, for example, at least a photodiode PD that is a light receiving element.

The second substrate 200 includes, for example, a pixel circuit that controls a signal output from the photodiode PD, and the pixel circuit includes various pixel transistors. The floating diffusion FD of the first substrate 100 and the floating diffusion FD of the second substrate 200 may be connected to each other via a contact region and controlled to have the same potential. The ground potentials of the first substrate 100 and the second substrate 200 can be set to different potential as described above.

The third substrate 300 includes, for example, a logic circuit that implements various signal processing and image processing on signals output from the pixel circuit. The third substrate 300 may be controlled at the same ground potential as the second substrate 200. The third substrate 300 may be configured to form a pixel unit with the first substrate 100 and the second substrate 200.

The right drawing shows, as an non-limiting example, the arrangement of the circuit in the case of a three-layer structure.

Fig. 43 is a schematic diagram showing an example of the configuration and cross section of a semiconductor substrate that makes a formation from the light receiving element to the pixel circuit and the logic circuit of the imaging device 1.

As shown in Fig. 43, the imaging device 1 may include the first substrate 100, the second substrate 200, and the third substrate 300 as a non-limiting configuration.

The first substrate 100 includes, for example, at least a photodiode PD that is a light receiving element.

The second substrate 200 includes, for example, a pixel circuit that controls a signal output from the photodiode PD, and the pixel circuit includes various pixel transistors. The floating diffusion FD of the first substrate 100 and the floating diffusion FD of the second substrate 200 may be connected to each other via a contact region and controlled to have the same potential. The ground potentials of the first substrate 100 and the second substrate 200 can be set to different potential as described above.

The third substrate 300 includes, for example, a part of the pixel circuit and a logic circuit that implements various signal processing and image processing on signals output from the pixel circuit. The third substrate 300 may be controlled at the same ground potential as the second substrate 200. The third substrate 300 may be configured to form a pixel unit with the first substrate 100 and the second substrate 200. In this way, the third substrate 300 may include a part of the pixel circuit.

Also in the case of Fig. 43, the cross-sectional view can be identical in configuration to Fig. 42.

Fig. 44 is a schematic diagram showing an example of the configuration and cross section of a semiconductor substrate that makes a formation from the light receiving element to the pixel circuit and the logic circuit of the imaging device 1.

The left drawing shows a configuration example of the semiconductor substrate. As a non-limiting configuration, the imaging device 1 may include the first substrate 100 and the second substrate 200.

The first substrate 100 includes, for example, at least a photodiode PD that is a light receiving element.

The second substrate 200 includes, for example, a pixel circuit that controls a signal output from the photodiode PD and a logic circuit that implements various signal processing and image processing on the signal output from the pixel circuit. Each of the pixel circuit and the logic circuit may include a plurality of transistors.

The floating diffusion FD of the first substrate 100 and the floating diffusion FD of the second substrate 200 may be connected to each other via a contact region and controlled to have the same potential. The ground potentials of the first substrate 100 and the second substrate 200 can be set to different potential as described above.

In this way, the second substrate 200 may include the logic circuit.

As in the modification example, the ground potentials of the photodiode PD and the amplification transistor AMP and the like can be arbitrarily set to the same potential or different potentials. Thus, by setting any ground potential for each of the transistors used in the circuit, the saturation signal amount of the photodiode PD can be increased and the degree of freedom in layout can be further improved.

### <11. Modified example 10>

Some examples will be described for the configuration of an equivalent circuit when a different ground potential is set depending on the substrate. In the following examples, the floating diffusion FD is provided for each pixel. A similar configuration can be adopted when the floating diffusion FD is shared by the plurality of pixels shown in Fig. 40.

Also, the following configuration examples may be implemented separately or may be implemented in combination as long as the configurations do not contradict each other.

Fig. 45 illustrates an example of the configuration of an equivalent circuit according to the embodiment.

In the second substrate 200, the potential of the well of the amplification transistor AMP may be set equal to the potential of the source of the amplification transistor AMP via the body region instead of the second ground potential GND2.

According to this connection, the potential of the source of the amplification transistor AMP and the potential of the well are equal to each other, and the modulation factor of the amplification gate that forms the source-follower circuit is set to 1, thereby increasing the conversion efficiency of the potential of the floating diffusion FD.

Fig. 46 illustrates an example of the configuration of the equivalent circuit according to the embodiment.

As shown in Fig. 46, the reset transistor RST may be provided in the first substrate 100 instead of the second substrate 200. By forming the reset transistor RST in the same substrate as the transfer transistor TR, the floating diffusion FD corresponding to the arranged reset transistor RST can be eliminated from the second substrate 200.

Hence, the capacitance of the floating diffusion FD can be reduced by the reduction of the floating diffusion FD omitted from the second substrate 200, so that the conversion efficiency of the signal stored in the floating diffusion FD can be increased.

Fig. 47 illustrates an example of the configuration of the equivalent circuit according to the embodiment.

As shown in Fig. 47, the reset transistor RST and the amplification transistor AMP may be provided in the first substrate 100. As compared with the case of Fig. 46, the distance between the floating diffusion FD and the amplification transistor AMP can be shorter, so that the conversion efficiency of the signal stored in the floating diffusion FD can be further increased.

As explained with reference to the two drawings, the constituent elements of the pixel unit other than the photodiode PD, the transfer diode TR, and the floating diffusion FD that are disposed on the first substrate 100 may be disposed on either of the first substrate 100 and the second substrate 200. As a matter of course, the pixel unit can be provided with circuit elements such as transistors other than those shown in these drawings.

Fig. 48 illustrates an example of the configuration of the equivalent circuit according to the embodiment.

As shown in Fig. 48, the equivalent circuit may be configured with a plurality of floating diffusion regions and a transistor for switching conversion efficiency. For example, the pixel circuit may be configured with the floating diffusions FD1, FD2, and FD3, the FD conversion gain switching transistor FDG between the floating diffusions FD1 and FD2, and a FD conversion gain switching transistor FCG between the floating diffusion FD2 and FD3.

The floating diffusion FD1 may be connected to the first ground potential GND1 via the capacitor C1 on the first substrate 100 and to the second ground potential GND2 via the capacitor C2 on the second substrate 200.

The floating diffusion FD2 may be connected to a second ground potential GND2 via a capacitor C3.

The floating diffusion FD3 may be connected to the second ground potential GND2 via a capacitor C4 and to a voltage FD_VDD, which is a power supply, via a capacitor C5.

The FD conversion gain switching transistors FDG and FDC are arranged on the second substrate 200, and the ground potentials are set to the second ground potential GND2. In this case, the floating diffusions FD2 and FD3 are formed on the second substrate 200.

In this configuration, when the FD conversion gain switching transistor FDG of the first stage is turned off, the conversion efficiency can be increased.

By turning on the FD conversion gain switching transistor FDG and turning off the FD conversion gain switching transistor FCG of the second stage, the floating diffusion FD1 and the floating diffusion FD2 are connected to each other, so that the conversion efficiency can be controlled to be lower than in the case where the FD conversion gain switching transistor FDG is turned off.

Furthermore, by turning on both of the FD conversion gain switching transistors FDG and FCG, the floating diffusions FD1 and FD2 and the floating diffusion FD3 are connected to one another, so that the conversion efficiency can be set lower than in the case where only the FD conversion gain switching transistor FDG is turned on.

In this way, the ground voltage of the transistor for switching the FD conversion gain can also be set in the same manner as the ground voltages of other transistors on the substrate.

As described above, by properly setting the ground voltages in these transistors, the layout and process rules of the transistors can be changed with higher flexibility.

Furthermore, the transistors for switching the transfer conversion gain do not need to have a two-stage configuration, and as shown in Figs. 4 and 6 and other drawings, only the FD conversion gain switching transistor FCG of a one-stage configuration may be provided.

Fig. 49 shows another example of the equivalent circuit including the FD conversion gain switching transistor.

As shown in Fig. 49, the FD conversion gain switching transistors FDG and FCG may be provided in the first substrate 100. In this case, the FD conversion gain switching transistors FDG and FCG can set the ground potentials to the first ground potential GND1. The floating diffusions FD2 and FD3 are formed on the first substrate 100.

Fig. 50 shows another example of a bypass including the FD conversion gain switching transistor.

As shown in Fig. 50, the FD conversion gain switching transistors FDG and FCG can be arranged also in the imaging device 1 in which the first substrate 100, the second substrate 200, and the third substrate 300 are stacked.

The ground potential of the first substrate 100 is set to the first ground potential GND1, the ground potential of the second substrate 200 is set to the second ground potential GND2, and the ground potential of the third substrate 300 is set to a third ground potential GND3.

As a non-limiting example, the floating diffusion FD1 is formed on the first substrate 100 and the second substrate 200, the floating diffusion FD2 is formed on the second substrate 200 and the third substrate 300, and the floating diffusion FD3 is formed on the third substrate 300.

The FD conversion gain switching transistor FDG is disposed on the second substrate 200, and the ground potential is set to the second ground potential GND2. The FD conversion gain switching transistor FCG is disposed on the third substrate 300, and the ground potential is set to the third ground potential GND3.

Furthermore, as a non-limiting example, the transfer transistor TRG is disposed on the first substrate 100 with the first ground potential GND1 serving as the ground potential, the amplification transistor AMP is disposed on the second substrate 200 with the second ground potential GND2 serving as the ground potential, and the selection transistor SEL is disposed on the third substrate 300 with the third ground potential GND3 serving as the ground potential.

In this way, the transistors and/or floating diffusions can also be allocated to the respective three substrates.

The allocation of the transistors is described as a non-limiting example, and the transistors can also be formed on any substrate as long as any contradictions do not arise in the circuit design.

Fig. 52 illustrates a non-limiting availability example of the equivalent circuit according to the embodiment. Fig. 55 is a plan view showing an extracted part of the layout of the first substrate 100 of the equivalent circuit in Fig. 52.

As shown in these drawings, the pixel unit further includes, on the first substrate 100, an offset transistor OFG, a memory transfer transistor TRY, and a memory region TRX. The pixel unit is not limited to a CMOS image sensor including four typical transistors and can also be used for a substrate corresponding to a global shutter.

The offset transistor OFG is a transistor connecting an offset potential OFG_ VDD for offsetting the potential of the cathode of the photodiode PD and the cathode of the photodiode PD. By turning on the offset transistor OFG, the potential of the cathode of the photodiode PD is controlled to the offset potential OFG_ VDD.

The memory transfer transistor TRY is a transistor that transfers the potential of the cathode of the photodiode PD to the memory region TRX at the appropriate timing. The potential of the memory region TRX is transferred to the floating diffusion FD at more appropriate timing by the transfer transistor TR.

With this configuration, the intensity of the signal at the timing of exposure can be transferred to the memory region TRX regardless of the scanning timing, and the signal maintained in the memory region TRX can be transferred to the floating diffusion FD at the appropriate timing. This operation enables global shutter imaging, which aligns the timing of signal acquisition.

Fig. 55 shows the regions of the transistors and the contact regions for applying voltage on the first substrate 100 of Fig. 52. GND1 and OFG_VDD in the drawing indicate contacts to which the voltages are applied, and Cxxx indicates contacts for supplying voltages to be applied to the gates of the transistors. A memory MEM is formed with, for example, the memory transfer transistor TRY and the memory region TRX.

The potential of the cathode of the photodiode PD is controlled to the offset potential OFG_ VDD via the offset transistor OFG at a predetermined timing. The imaging device 1 performs exposure at any timing thereafter, so that a signal corresponding to the intensity of the signal acquired in each pixel unit is accumulated in the cathode of the photodiode PD.

After the exposure is completed, the memory transfer transistor TRY is turned on at any timing to transfer the signal held in the cathode of the photodiode PD to the memory region TRX.

After the memory transfer transistor TRY is turned off, the transfer transistor TR is turned on at any timing to transfer the signal to the floating diffusion FD. The signal is properly transferred by charge transfer.

Thus, the configuration for setting the ground potential for each of the substrates in the present disclosure can be used to acquire image signals in a charge-domain global shutter system.

Although the charge domain type is described in the above example, the ground potentials of the transistor and the circuit element in the voltage-domain global shutter imaging can also be set for each of the stacked substrates.

### <12. Availability example>

Fig. 53 illustrates an example of a schematic configuration of an imaging system 7 including the imaging device 1 according to the embodiment and the modification examples.

The imaging system 7 is an electronic device, for example, an imaging device such as a digital still camera or a video camera, or a portable terminal device such as a smartphone or a tablet terminal. The imaging system 7 includes, for example, the imaging device 1 according to the embodiment and the modification examples described above, a DSP circuit 243, a frame memory 244, a display unit 245, a storage unit 246, an operation unit 247, and a power supply unit 248. In the imaging system 7, the imaging device 1 according to the embodiment and the modification examples, the DSP circuit 243, the frame memory 244, the display unit 245, the storage unit 246, the operation unit 247, and the power supply unit 248 are connected to one another via a bus line 249.

The imaging device 1 according to the embodiment and the modification examples outputs image data corresponding to incident light. The DSP circuit 243 is a signal processing circuit that processes signals (image data) output from the imaging device 1 according to the above embodiment and the modification examples. The frame memory 244 temporarily holds the image data processed by the DSP circuit 243 in units of frames. The display unit 245 includes a panel type display device such as a liquid crystal panel or an organic electro luminescence (EL) panel, and displays moving images or still images captured by the imaging device 1 according to the embodiment and the modification examples. The storage unit 246 records image data of a moving image or a still image captured by the imaging device 1 according to the embodiment and the modification examples on a recording medium such as a semiconductor memory or a hard disk. The operation unit 247 issues an operation command for various functions of the imaging system 7 in response to operations of a user. The power supply unit 248 supplies, as appropriate, various power sources that serve as operating power sources for the imaging device 1 according to the embodiment and the modification examples, the DSP circuit 243, the frame memory 244, the display unit 245, the storage unit 246, and the operation unit 247.

The imaging procedure in the imaging system 7 will be described below.

Fig. 54 shows an example of the flowchart of the imaging operation in the imaging system 7. The user provides an instruction to start imaging by operating the operation unit 247 (step S101). The operation unit 247 then transmits an imaging command to the imaging device 1 (step S102). When receiving the imaging command, the imaging device 1 (specifically, a system control circuit 36) executes imaging using a predetermined imaging method (step S103).

The imaging device 1 outputs image data obtained by imaging to the DSP circuit 243. As used herein, the image data is data of pixel signals generated for all pixels on the basis of charges temporarily held in the floating diffusions FD. The DSP circuit 243 performs predetermined signal processing (e.g., noise reduction processing) based on the image data input from the imaging device 1 (step S104). The DSP circuit 243 causes the frame memory 244 to hold the image data that has undergone predetermined signal processing, and the frame memory 244 causes the storage unit 246 to store the image data (step S105). In this way, imaging is performed in the imaging system 7.

In the availability example, the imaging device 1 according to the embodiment and the modification examples is applied to the imaging system 7. This allows for miniaturization or higher definition of the imaging device 1, so that the compact or high-definition imaging system 7 can be provided.

### <13. Application Examples>

### [Application Example 1]

The technique of the present disclosure (the present technique) can be applied to various products. For example, the technique according to the present disclosure may be implemented as a device equipped in any type of moving body such as an automobile, an electric vehicle, a hybrid electric vehicle, a motorcycle, a bicycle, a personal mobility device, an airplane, a drone, a ship, and a robot.

Fig. 55 is a block diagram illustrating a schematic configuration example of a vehicle control system, that is, an example of a mobile control system to which the technique according to the present disclosure is applicable.

The vehicle control system 12000 includes a plurality of electronic control units connected to one another via a communication network 12001. In the example illustrated in Fig. 55, the vehicle control system 12000 includes a drive system control unit 12010, a body system control unit 12020, a vehicle external information detection unit 12030, a vehicle internal information detection unit 12040, and an integrated control unit 12050. Additionally, as a functional configuration of the integrated control unit 12050, a microcomputer 12051, an audio/image output unit 12052, and an in-vehicle network interface (I/F) 12053 are illustrated.

The drive system control unit 12010 controls the operation of a device related to a vehicle drive system according to various programs. For example, the drive system control unit 12010 functions as a driving force generator for generating a driving force of a vehicle, for example, an internal combustion engine or a driving motor, a driving force transmission mechanism for transmitting a driving force to wheels, a steering mechanism for adjusting a turning angle of a vehicle, and a control device such as a braking device that generates a braking force of a vehicle.

The body system control unit 12020 controls the operations of various devices mounted in the vehicle body, according to various programs. For example, the body system control unit 12020 functions as a control device for a keyless entry system, a smart key system, a power window device, or various lamps such as a headlamp, a back lamp, a brake lamp, a turn signal, and a fog lamp. In this case, the body system control unit 12020 may receive input of radio waves transmitted from a portable device that substitutes for a key or signals of various switches. The body system control unit 12020 receives the inputs of the radio waves or signals and controls a door lock device, a power window device, and lamps of the vehicle.

The vehicle external information detection unit 12030 detects information on the outside of the vehicle in which the vehicle control system 12000 is mounted. For example, the vehicle external information detection unit 12030 is connected with an imaging unit 12031. The vehicle external information detection unit 12030 causes the imaging unit 12031 to capture an image of the outside of the vehicle and receives the captured image. The vehicle external information detection unit 12030 may perform object detection processing or distance detection processing for peoples, cars, obstacles, signs, and letters on the road based on the received image.

The imaging unit 12031 is an optical sensor that receives light and outputs an electrical signal according to the amount of received light. The imaging unit 12031 can also output the electrical signal as an image or ranging information. Furthermore, the light received by the imaging unit 12031 may be visible light or invisible light such as infrared light.

The vehicle internal information detection unit 12040 detects information on the inside of the vehicle. For example, a driver state detection unit 12041 that detects a driver's state is connected to the vehicle internal information detection unit 12040. The driver state detection unit 12041 may include, for example, a camera that captures an image of a driver, and the vehicle internal information detection unit 12040 may calculate the degree of fatigue or concentration of the driver on the basis of detection information input from the driver state detection unit 12041 or may determine whether the driver is dozing or not.

The microcomputer 12051 can calculate a control target value of the driving force generator, the steering mechanism, or the braking device on the basis of information acquired about the outside or the inside of the vehicle by the vehicle external information detection unit 12030 or the vehicle internal information detection unit 12040 and output a control command to the drive system control unit 12010. For example, the microcomputer 12051 can perform cooperative control for the purpose of obtaining functions of an ADAS (Advanced Driver Assistance System) including collision avoidance or impact mitigation of a vehicle, following traveling based on inter-vehicle distance, vehicle speed maintenance driving, vehicle collision warning, or vehicle lane deviation warning or the like.

Furthermore, the microcomputer 12051 can perform cooperative control for the purpose of automated driving or the like in which autonomous travel is performed without depending on operations by the driver, by controlling the driving force generator, the steering mechanism, or the braking device or the like on the basis of information about the surroundings of the vehicle, the information being acquired by the vehicle external information detection unit 12030 or the vehicle internal information detection unit 12040.

In addition, the microcomputer 12051 can output a control command to the body system control unit 12020 on the basis of the information acquired about the outside of the vehicle by the vehicle external information detection unit 12030. For example, the microcomputer 12051 can perform cooperative control for the purpose of preventing glare by controlling the headlamps to switch a high beam to a low beam according to the position of a vehicle ahead or an oncoming vehicle that is detected by the vehicle external information detection unit 12030.

The audio/image output unit 12052 transmits an output signal of at least one of sound and an image to an output device capable of visually or audibly notifying a passenger or the outside of the vehicle about information. In the example of Fig. 57, an audio speaker 12061, a display unit 12062, and an instrument panel 12063 are illustrated as output devices. The display unit 12062 may include, for example, at least one of an on-board display and a head-up display.

Fig. 56 illustrates an example of the installation position of the imaging unit 12031.

In Fig. 56, a vehicle 12100 includes imaging units 12101, 12102, 12103, 12104, and 12105 as the imaging unit 12031.

For example, the imaging units 12101, 12102, 12103, 12104, and 12105 are provided at positions such as a front nose, side-view mirrors, a rear bumper, a back door, and an upper portion of a windshield in the vehicle interior of the vehicle 12100. The imaging unit 12101 provided at the front nose and the imaging unit 12105 provided in an upper portion of the windshield in the interior of the vehicle mainly capture images ahead of the vehicle 12100. The imaging units 12102 and 12103 provided at the side-view mirrors mainly capture images on the sides of the vehicle 12100. The imaging unit 12104 provided at the rear bumper or the back door mainly captures images behind the vehicle 12100. Front view images captured by the imaging unit 12101 and 12105 are mainly used for detecting a vehicle ahead, pedestrians, obstacles, traffic lights, traffic signs, or lanes or the like.

Fig. 56 also shows an example of the imaging ranges of the imaging units 12101 to 12104. An imaging range 12111 indicates the imaging range of the imaging unit 12101 provided at the front nose, imaging ranges 12112 and 12113 respectively indicate the imaging ranges of the imaging units 12102 and 12103 provided at the side-view mirrors, and an imaging range 12114 indicates the imaging range of the imaging unit 12104 provided at the rear bumper or the back door. For example, by superimposing image data captured by the imaging units 12101 to 12104, a bird's-eye view image viewed from the upper side of the vehicle 12100 can be obtained.

At least one of the imaging units 12101 to 12104 may have a function for acquiring distance information. For example, at least one of the imaging units 12101 to 12104 may be a stereo camera including a plurality of imaging elements or may be an imaging element that has pixels for phase difference detection.

For example, the microcomputer 12051 can extract, particularly, the closest three-dimensional object on the travel path of the vehicle 12100, which is a three-dimensional object traveling at a predetermined speed (for example, 0 km/h or higher) in the substantially same direction as the vehicle 12100, as a vehicle ahead by acquiring a distance to each three-dimensional object in the imaging ranges 12111 to 12114 and a temporal change of this distance (a relative speed with respect to the vehicle 12100) on the basis of the distance information obtained from the imaging units 12101 to 12104. Furthermore, the microcomputer 12051 can set an inter-vehicle distance to be secured from a vehicle ahead in advance and can perform automated brake control (also including following stop control) or automated acceleration control (also including following start control). Thus, cooperative control can be performed for the purpose of, for example, automated driving in which autonomous travel is performed without depending on operations by the driver.

For example, the microcomputer 12051 can classify and extract three-dimensional data on three-dimensional objects into two-wheeled vehicles, normal vehicles, large vehicles, pedestrians, and other three-dimensional objects such as electric poles on the basis of distance information obtained from the imaging units 12101 to 12104 and can use the three-dimensional data for automated avoidance of obstacles. For example, the microcomputer 12051 differentiates obstacles around the vehicle 12100 as obstacles that can be viewed by the driver of the vehicle 12100 and obstacles that are difficult to view. The microcomputer 12051 then determines the risk of collision, that is, the degree of risk of collision with each obstacle and outputs a warning to the driver through the audio speaker 12061 or the display unit 12062 or performs forced deceleration or avoidance steering through the drive system control unit 12010 when the risk of collision is equal to or greater than a set value and thus collision may occur. Thus, driving assistance can be performed for collision avoidance.

At least one of the imaging units 12101 to 12104 may be an infrared camera that detects infrared rays. For example, the microcomputer 12051 can recognize a pedestrian by determining the presence or absence of a pedestrian in images captured by the imaging units 12101 to 12104. The pedestrian is recognized by, for example, the step of extracting feature points in the captured images of the imaging units 12101 to 12104 serving as infrared cameras, and the step of performing pattern matching processing on a series of feature points indicating the edge of an object to determine whether or not the object is a pedestrian. When the microcomputer 12051 determines that a pedestrian is present in the captured images of the imaging units 12101 to 12104 and recognizes the pedestrian, the audio/image output unit 12052 controls the display unit 12062 such that a square contour line for emphasis is superimposed and displayed on the recognized pedestrian. In addition, the audio/image output unit 12052 may control the display unit 12062 such that an icon indicating a pedestrian or the like is displayed at a desired position.

An example of the mobile control system to which the technique according to the present disclosure can be applied has been described above. The technique according to the present disclosure may be applied to the imaging unit 12031 among the above-described configurations. More specifically, the imaging device 1 according to the embodiment and the modifications thereof can be applied to the imaging unit 12031. By applying the technique according to the present disclosure to the imaging unit 12031, a high-definition photographed image can be obtained with reduced noise, so that the mobile control system can perform accurate control using the photographed image.

### [Application example 2]

Fig. 57 shows an example of a schematic configuration of an endoscope surgery system to which the technique according to the present disclosure (the present technique) can be applied.

Fig. 57 shows a state in which an operator (doctor) 11131 is performing a surgical operation on a patient 11132 on a patient bed 11133 by using an endoscopic surgery system 11000. As illustrated in Fig. 57, the endoscopic surgery system 11000 includes an endoscope 11100, other surgical instruments 11110 such as a pneumoperitoneum tube 11111 and an energy treatment tool 11112, a support arm device 11120 that supports the endoscope 11100, and a cart 11200 equipped with various devices for endoscopic surgery.

The endoscope 11100 includes a lens barrel 11101 having a region to be inserted with a predetermined length into a body cavity of the patient 11132 from the distal end of the endoscope, and a camera head 11102 connected to the proximal end of the lens barrel 11101. In the illustrated example, the endoscope 11100 is configured as a so-called rigid endoscope having the rigid lens barrel 11101. The endoscope 11100 may be configured as a so-called flexible endoscope having a flexible lens barrel.

The distal end of the lens barrel 11101 is provided with an opening where an objective lens is fit. A light source device 11203 is connected to the endoscope 11100, light generated by the light source device 11203 is guided to the distal end of the lens barrel 11101 by a light guide extended to the inside of the lens barrel 11101, and the light is projected to an observation target in the body cavity of the patient 11132 through the objective lens. The endoscope 11100 may be a direct-view endoscope, an oblique-view endoscope, or a side-view endoscope.

An optical system and an imaging element are provided inside the camera head 11102, and reflected light (observation light) from the observation target is concentrated on the imaging element by the optical system. The imaging element photoelectrically converts the observation light, and an electrical signal corresponding to the observation light, that is, an image signal corresponding to an observation image is formed. The image signal is transmitted to a camera control unit (CCU: Camera Control Unit) 11201 as RAW data.

The CCU 11201 is configured of a central processing unit (CPU), a graphics processing unit (GPU), and the like and comprehensively controls the operation of the endoscope 11100 and a display device 11202. In addition, the CCU 11201 receives an image signal from the camera head 11102 and performs various types of image processing for displaying an image based on the image signal, for example, development processing (demosaic processing) on the image signal.

The display device 11202 displays the image based on the image signal subjected to the image processing by the CCU 11201, under the control of the CCU 11201.

The light source device 11203 is composed of, for example, a light source such as a light emitting diode (LED), and supplies the endoscope 11100 with emitted light when capturing an image of a surgical site or the like.

An input device 11204 is an input interface for the endoscopic surgery system 11000. The user can input various types of information or instructions to the endoscopic surgery system 11000 via the input device 11204. For example, the user inputs an instruction to change imaging conditions (including the type of irradiation light, a magnification, and a focal length) of the endoscope 11100.

A treatment tool control device 11205 controls driving of the energy treatment tool 11112 for cauterization or incision of a tissue or sealing of blood vessel. A pneumoperitoneum device 11206 feeds gas into the body cavity of the patient 11132 via the pneumoperitoneum tube 11111 in order to inflate the body cavity for the purpose of securing a field of view through the endoscope 11100 and a working space of the operator. A recorder 11207 is a device capable of recording various types of information pertaining to the surgery. A printer 11208 is a device capable of printing various types of information pertaining to the surgery in various formats such as text, images, and graphs.

The light source device 11203 that supplies the endoscope 11100 with irradiation light for capturing the image of the surgical site can be composed of, for example, an LED, a laser light source, or a white light source configured as a combination thereof. When a white light source is configured as a combination of RGB laser light sources, the output intensity and the output timing of each color (each wavelength) can be controlled with high accuracy, allowing the light source device 11203 to adjust the white balance of the captured image. In this case, images corresponding to RGB can also be captured in a time-sharing manner by irradiating an observation target with laser beams from RGB laser light sources and controlling driving of the imaging element of a camera head 11102 in synchronization with the irradiation timing. According to the method, color images can be obtained without providing the image sensor with a color filter.

Furthermore, driving of the light source device 11203 may be controlled such that the intensity of output light is changed at predetermined time intervals. The driving of the imaging element of the camera head 11102 is controlled in synchronization with the timing of changing the intensity of the light, and images are acquired in a time-sharing manner and are combined, so that an image having a high dynamic range can be generated without so-called blackout and whiteout.

The light source device 11203 may be configured to supply light in a predetermined wavelength band corresponding to special light observation. In the special light observation, for example, by emitting light in a band narrower than that of radiation light (that is, white light) during normal observation using wavelength dependence of light absorption in a body tissue, so-called narrow band light observation (Narrow Band Imaging) is performed in which a predetermined tissue such as a blood vessel in a mucous membrane surface layer is imaged with a high contrast. Alternatively, in the special light observation, fluorescence observation may be performed to obtain an image by fluorescence generated by emitting excitation light. In the fluorescence observation, excitation light can be emitted to a body tissue to observe fluorescence from the body tissue (autofluorescence observation), or a reagent such as indocyanine green (ICG) can be locally injected to a body tissue and excitation light corresponding to a fluorescence wavelength of the reagent can be emitted to the body tissue to obtain a fluorescence image. The light source device 11203 can be configured to supply narrow band light and/or excitation light corresponding to such special light observation.

Fig. 58 is a block diagram illustrating an example of the functional configurations of the camera head 11102 and the CCU 11201 shown in Fig. 57.

The camera head 11102 includes a lens unit 11401, an imaging unit 11402, a drive unit 11403, a communication unit 11404, and a camera head control unit 11405. The CCU 11201 has a communication unit 11411, an image processing unit 11412, and a control unit 11413. The camera head 11102 and the CCU 11201 are communicatively connected to each other via a transmission cable 11400.

The lens unit 11401 is an optical system provided in a connection part for connection to the lens barrel 11101. Observation light taken in from the tip of the lens barrel 11101 is guided to the camera head 11102 and is incident on the lens unit 11401. The lens unit 11401 is configured in combination with a plurality of lenses including a zoom lens and a focus lens.

The imaging unit 11402 includes an imaging device (image sensor). The imaging element constituting the imaging unit 11402 may be one element (a so-called single plate type) or a plurality of elements (a so-called multi-plate type). When the imaging unit 11402 is configured as a multi-plate type, for example, image signals corresponding to respective RGB are generated by the imaging elements, and a color image may be obtained by combining the image signals. Alternatively, the imaging unit 11402 may be configured to include a pair of imaging elements for acquiring each of image signals for the right eye and the left eye that correspond to 3D (Dimensional) display. The provision of 3D display allows the operator 11131 to more accurately recognize the depth of a living tissue in a surgical site. When the imaging unit 11402 is configured as a multi-plate type, a plurality of lens units 11401 may be provided so as to correspond to the respective imaging elements.

The imaging unit 11402 does not always need to be provided in the camera head 11102. For example, the imaging unit 11402 may be provided immediately after the objective lens inside of the lens barrel 11101.

The drive unit 11403 includes an actuator, and the zoom lens and the focus lens of the lens unit 11401 are moved by a predetermined distance along an optical axis under the control of the camera head control unit 11405. The magnification and focus of the image captured by the imaging unit 11402 can therefore be adjusted as appropriate.

The communication unit 11404 includes a communication device that transmits and receives various types of information to and from the CCU 11201. The communication unit 11404 transmits the image signal obtained from the imaging unit 11402 as RAW data to the CCU 11201 via the transmission cable 11400.

The communication unit 11404 receives a control signal for controlling driving of the camera head 11102 from the CCU 11201 and supplies the camera head control unit 11405 with the control signal. The control signal includes, for example, information regarding image capturing conditions, such as information indicating a designation of a framerate of a captured image, information indicating a designation of an exposure value when an image is captured, and/or information indicating a designation of the magnification and the focus of the captured image.

The imaging conditions, such as the frame rate, the exposure value, the magnification, and the focal point, may be appropriately specified by the user, or may be automatically set by the control unit 11413 of the CCU 11201 on the basis of the acquired image signal. In the latter case, the endoscope 11100 should have a so-called auto exposure (AE) function, a so-called auto focus (AF) function, and a so-called auto white balance (AWB) function.

The camera head control unit 11405 controls the driving of the camera head 11102 based on a control signal from the CCU 11201 received via the communication unit 11404.

The communication unit 11411 includes a communication device that transmits and receives various types of information to and from the camera head 11102. The communication unit 11411 receives an image signal transmitted via the transmission cable 11400 from the camera head 11102.

The communication unit 11411 transmits the control signal for controlling the driving of the camera head 11102 to the camera head 11102. The image signal or the control signal can be transmitted through electric communications or optical communications or the like.

The image processing unit 11412 performs various types of image processing on the image signal that is the RAW data transmitted from the camera head 11102.

The control unit 11413 performs various types of control on imaging of a surgical site by the endoscope 11100 and display of a captured image obtained through imaging of a surgical site or the like. For example, the control unit 11413 generates control signals for controlling the driving of the camera head 11102.

In addition, the control unit 11413 causes the display device 11202 to display a captured image showing a surgical site or the like on the basis of an image signal subjected to the image processing by the image processing unit 11412. At this time, the control unit 11413 may recognize various objects in the captured image using various image recognition techniques. For example, the control unit 11413 can recognize surgical instruments such as forceps, a specific biological site, bleeding, mist or the like at the time of use of the energy treatment tool 11112 by detecting a shape and a color or the like of an edge of an object included in the captured image. When the display device 11202 is caused to display a captured image, the control unit 11413 may superimpose various types of surgery support information on an image of the surgical site by using a recognition result of the captured image. The surgery support information is superimposed on the display and is presented to the operator 11131, so that a burden on the operator 11131 can be reduced and the operator 11131 can reliably perform a surgical operation.

The transmission cable 11400 that connects the camera head 11102 and the CCU 11201 is an electrical signal cable that supports communication of electrical signals, an optical fiber that supports optical communication, or a composite cable thereof.

Although wired communication is performed using the transmission cable 11400 in the illustrated example, radio communications may be performed between the camera head 11102 and the CCU 11201.

An example of an endoscopic surgery system to which the technique according to the present disclosure can be applied has been described thus far. The technique according to the present disclosure can be suitably applied to the imaging unit 11402 provided in the camera head 11102 of the endoscope 11100 among the configurations described above. By applying the technique according to the present disclosure to the imaging unit 11402, the size of the imaging unit 11402 can be reduced with high definition, and thus the compact and high-definition endoscope 11100 can be provided.

Although the present disclosure has been described with reference to the embodiment and the modification examples thereof, the availability example, and the application example, the present disclosure is not limited to the above embodiments and the like can be modified in various ways. The effects described in the present specification are merely examples. The effects of the present disclosure are not limited to the effects described in the present specification. The present disclosure may have effects other than those described in the present specification.

Furthermore, for example, the present disclosure may have the following configurations.
(1) A solid-state imaging device including a first substrate and a second substrate,
   wherein
   the first substrate includes:
   at least a light receiving element that outputs a signal based on the intensity of received light,
   a ground potential is a first ground potential,
   the second substrate includes
   at least a transistor that outputs a signal based on the signal output from the light receiving element, and
   a ground potential is a second ground potential different from the first ground potential.
(2) The solid-state imaging device according to (1), wherein the second ground potential is a potential on the positive side of the first ground potential.
(3) The solid-state imaging device according to (2), wherein the first ground potential is a negative bias potential.
(4) The solid-state imaging device according to (2) or (3), wherein the second ground potential is 0 [V].
(5) The solid state imaging device according to any of (1) to (4), wherein, the second substrate includes
   an amplification transistor that amplifies a signal output by the light receiving element.
(6) The solid-state imaging device according to any of (1) to (5), wherein the thickness of the gate oxide film of the transistor provided on the second substrate is smaller than the thickness of the gate oxide film provided on the first substrate.
(7) The solid-state imaging device according to any of (1) to (6), wherein the first substrate and the second substrate are electrically connected to each other via a metal.
(8) The solid-state imaging device according to (7), wherein the metal is copper.
(9) The solid-state imaging device according to (7) or (8), wherein a distance between the wirings of the second substrate is shorter than a distance between the wirings of the first substrate.
(10) The solid-state imaging device according to any of (1) to (9), wherein the first substrate and the second substrate are formed in a stacked state.
(11) The solid-state imaging device according to any of (1) to (10), further including: a third substrate,
   wherein
   the third substrate
   forms a pixel unit with the first substrate and the second substrate.
(12) The solid-state imaging device according to any of (1) to (11), wherein the signal acquired by the light receiving element is converted into an image signal by a charge-domain global shutter system.
(13) The solid-state imaging device according to any of (1) to (11), wherein the signal acquired by the light receiving element is converted into an image signal by a voltage-domain global shutter system.
(14) The solid-state imaging device according to any of (1) to (13), wherein the signal acquired by the light receiving element is converted into a digital signal by an analogue-to-digital conversion circuit provided for the light receiving element.
(15) The solid-state imaging device according to (5), wherein the amplification transistor has a well potential and a source potential that are equal to each other and different from the second ground potential.
(16) An electronic device including the solid-state imaging device according to any of (1) to (15).

The aspects of the present disclosure are not limited to the embodiments described above and include various modifications that are conceivable, and the effects of the present disclosure are not limited to the content described above. Constituent elements of each of the embodiments may be appropriately combined for an application. In other words, various additions, changes, and partial deletions can be performed in a range not departing from the conceptual idea and spirit of the present disclosure derived from content specified in the claims and equivalents thereof.

### [Reference Signs List]

1 Imaging device
7 Imaging system
100 First substrate
100S, 200S, 300S Semiconductor layer
100T, 200T, 300T Wiring layer
111 Insulating Film
112 Fixed charge film
113 First pinning region
114 N-type semiconductor region
115 P-well Layer
116 Second pinning region
117 Pixel separating portion
117A Light shielding film
117B Insulating film
118, 218 VSS contact region
119, 123, 222 Interlayer insulating film
120, 121 Pad portion
120E, 121E Through electrode
122, 221 Passivation film
124 Junction film
200 Second substrate
201, 202, 203, 204, 301, 302, 303, 304 Contact portion
212 Insulating region
213 Element separating region
218V, TGV Connection hole
300 Third substrate
401 Light receiving lens
541A, 541B, 541C, 541D Pixel
TR Transfer transistor
TG Transfer gate
RST Reset transistor
AMP Amplification transistor
SEL Selection transistor
FDG, FCG FD conversion gain switching transistor
FD, FD1, FD2, FD3 Floating diffusion
C1, C2, C3, C4, C5 Capacitor
TRX Memory region
TRY Memory transfer transistor

## Claims

1. A solid-state imaging device comprising a first substrate and a second substrate,
wherein
the first substrate includes:
at least a light receiving element that outputs a signal based on intensity of received light,
a ground potential is a first ground potential,
the second substrate includes
at least a transistor that outputs a signal based on the signal output from the light receiving element, and
a ground potential is a second ground potential different from the first ground potential.

2. The solid-state imaging device according to claim 1, wherein the second ground potential is a potential on a positive side of the first ground potential.

3. The solid-state imaging device according to claim 2, wherein the first ground potential is a negative bias potential.

4. The solid-state imaging device according to claim 2, wherein the second ground potential is 0 [V].

5. The solid-state imaging device according to claim 1, further comprising
an amplification transistor that amplifies a signal output by the light receiving element.

6. The solid-state imaging device according to claim 1, wherein a thickness of a gate oxide film of a transistor provided on the second substrate is smaller than a thickness of a gate oxide film provided on the first substrate.

7. The solid-state imaging device according to claim 1, wherein the first substrate and the second substrate are electrically connected to each other via a metal.

8. The solid-state imaging device according to claim 7, wherein the metal is copper.

9. The solid-state imaging device according to claim 7, wherein a distance between wirings of the second substrate is shorter than a distance between wirings of the first substrate.

10. The solid-state imaging device according to claim 1, wherein the first substrate and the second substrate are formed in a stacked state.

11. The solid-state imaging device according to claim 1, further comprising: a third substrate,
wherein
the third substrate
forms a pixel unit with the first substrate and the second substrate.

12. The solid-state imaging device according to claim 1, wherein the signal acquired by the light receiving element is converted into an image signal by a charge-domain global shutter system.

13. The solid-state imaging device according to claim 1, wherein the signal acquired by the light receiving element is converted into an image signal by a voltage-domain global shutter system.

14. The solid-state imaging device according to claim 1, wherein the signal acquired by the light receiving element is converted into a digital signal by an analogue-to-digital conversion circuit provided for the light receiving element.

15. The solid-state imaging device according to claim 5, wherein the amplification transistor has a well potential and a source potential that are equal to each other and different from the second ground potential.

16. An electronic device comprising the solid-state imaging device according to claim 1.
